# EUROPEAN PATENT APPLICATION

(11) **EP 4 550 947 A1**
(43) Date of publication of application: **07.05.2025**
(21) Application number: 24837522.2
(22) Date of filing: 26.01.2024
(51) Int. Cl.: H05K 1/18, H05K 1/11, H05K 1/02

(54) **CIRCUIT BOARD, CIRCUIT BOARD ASSEMBLY AND ELECTRONIC DEVICE**

(30) Priority: 12.09.2023 CN 202311170956
(71) Applicant: Honor Device Co., Ltd., Shenzhen, Guangdong 518040 (CN)
(72) Inventor: AN, Jian, Shenzhen, Guangdong 518040 (CN); JIA, Menghua, Shenzhen, Guangdong 518040 (CN); HUO, Pan, Shenzhen, Guangdong 518040 (CN); LI, Dongcheng, Shenzhen, Guangdong 518040 (CN); XIE, Xin, Shenzhen, Guangdong 518040 (CN)
(74) Representative: Thun, Clemens
(86) International application number: PCT/CN2024/074320
(87) International publication number: WO 2025/055253

(57) **Abstract**

Embodiments of this application provide a circuit board, a circuit board assembly, and an electronic device, and are applied to the field of electronic technologies. The circuit board is configured to carry a target storage chip, and the target storage chip includes any one of at least two types of storage chips. The circuit board includes a first pad group, the first pad group is configured to be connected to the target storage chip, the first pad group includes a plurality of first pads, each first pad is connected to at least two traces, each trace connected to at least some first pads includes a first jumper area, and the trace is broken off in the first jumper area. When the circuit board is configured to carry the target storage chip, the first jumper area included in a target trace connected to the at least some first pads is used to mount a jumper element, and the target trace is a trace corresponding to the target storage chip in the at least two traces connected to the first pad. In this way, different types of storage chips are compatible on a same circuit board.

## Description

This application claims priority to Chinese Patent Application No. 202311170956.1, filed with the China National Intellectual Property Administration on September 12, 2023 and entitled "CIRCUIT BOARD, CIRCUIT BOARD ASSEMBLY, AND ELECTRONIC DEVICE", which is incorporated herein by reference in its entirety.

### TECHNICAL FIELD

This application relates to the field of electronic technologies, and in particular, to a circuit board, a circuit board assembly, and an electronic device.

### BACKGROUND

With continuous development of electronic technologies, electronic devices such as a mobile phone and a tablet computer have gradually become relatively common tools in people's daily life and work. To meet diversified requirements of a user on an electronic device, a plurality of types of chips such as a processor chip and a storage chip may be disposed in the electronic device.

That a storage chip is disposed in the electronic device is used as an example, and the storage chip may be mounted on a circuit board disposed in the electronic device. Currently, there are a plurality of different types of storage chips. When different types of storage chips are mounted on the circuit board, the different types of storage chips require different circuit boards. Consequently, utilization of a same type of circuit board is reduced, and design costs of the circuit board are increased.

### SUMMARY

Embodiments of this application provide a circuit board, a circuit board assembly, and an electronic device. Different types of storage chips are compatible on a same circuit board, to improve utilization of a same type of circuit board, and reduce design costs of the circuit board.

According to a first aspect, an embodiment of this application provides a circuit board. The circuit board is configured to carry a target storage chip, the target storage chip includes any one of at least two types of storage chips, quantities of pins of all of the at least two types of storage chips are equal, and pin arrangements of all of the at least two types of storage chips are the same. The circuit board includes a first pad group, the first pad group is configured to be connected to the target storage chip, the first pad group includes a plurality of first pads, each first pad is connected to at least two traces, each trace connected to at least some first pads includes a first jumper area, and the trace is broken off in the first jumper area. When the circuit board is configured to carry the target storage chip, the first jumper area included in a target trace connected to the at least some first pads is used to mount a jumper element, and the target trace is a trace corresponding to the target storage chip in the at least two traces connected to the first pad.

In this way, each first pad on the circuit board is disposed to be connected to at least two traces, so that pin connection relationships of different types of storage chips are compatible. In addition, each trace connected to the at least some first pads includes the first jumper area, so that when different types of storage chips are mounted on the circuit board, a jumper element may be mounted in the first jumper area included in one corresponding trace in the at least two traces connected to the first pad, to implement gating. In this way, different types of storage chips are compatible on a same circuit board, to improve utilization of a same type of circuit board, and reduce design costs of the circuit board.

In a possible implementation, the target storage chip includes a first storage chip or a second storage chip. Each first pad is connected to two traces, and the two traces connected to each of the at least some first pads each include the first jumper area. When the circuit board is configured to carry the first storage chip, the first jumper area included in a first trace connected to the at least some first pads is used to mount a jumper element, and the first trace is a trace corresponding to the first storage chip in the two traces connected to the first pad; and when the circuit board is configured to carry the second storage chip, the first jumper area included in a second trace connected to the at least some first pads is used to mount a jumper element, and the second trace is a trace corresponding to the second storage chip in the two traces connected to the first pad. In this way, the first storage chip and the second storage chip are compatible on a same circuit board.

In a possible implementation, the plurality of first pads include a first-type pad, the first-type pad is configured to be connected to a power pin of the first storage chip and/or a power pin of the second storage chip, the first-type pad is not configured to be connected to an unused pin of the first storage chip or an unused pin of the second storage chip, and the circuit board is further configured to carry a first power module. When the first-type pad is configured to be connected to the power pin of the first storage chip, the first power module is configured to be connected to the first-type pad through the first trace; and/or when the first-type pad is configured to be connected to the power pin of the second storage chip, the first power module is configured to be connected to the first-type pad through the second trace. In this way, a specific connection relationship of the first-type pad in the circuit board is provided.

In a possible implementation, the first trace and the second trace that are connected to the first-type pad each include the first jumper area. When the circuit board is configured to carry the first storage chip, the first jumper area included in the first trace connected to the first-type pad is used to mount a jumper element, and the first jumper area included in the second trace connected to the first-type pad is not used to mount a jumper element; and when the circuit board is configured to carry the second storage chip, the first jumper area included in the second trace connected to the first-type pad is used to mount a jumper element, and the first jumper area included in the first trace connected to the first-type pad is not used to mount a jumper element. In this way, a jump is made in the first jumper area included in the first trace and the second trace that are connected to the first-type pad, so that some pins of the first storage chip and the second storage chip are compatible on a first-type pad on a same circuit board.

In a possible implementation, the first trace and/or the second trace that are/is connected to the first power module do/does not include the first jumper area, and the first trace or the second trace that is not connected to the first power module includes the first jumper area. When the circuit board is configured to carry the first storage chip and the first-type pad is configured to be connected to the power pin of the first storage chip, the first power module is configured to power on the first trace connected to the first-type pad; and/or when the circuit board is configured to carry the second storage chip and the first-type pad is configured to be connected to the power pin of the second storage chip, the first power module is configured to power on the second trace connected to the first-type pad. In this way, the first power module performs powering-on, so that some pins of the first storage chip and the second storage chip are compatible on a first-type pad on a same circuit board, to reduce jumper elements that need to be mounted in the first jumper area, thereby reducing costs of a circuit board assembly and simplifying manufacturing steps of the circuit board assembly.

In a possible implementation, neither of the first trace and the second trace that are connected to the first power module include the first jumper area. When the circuit board is configured to carry the first storage chip and the first-type pad is configured to be connected to the power pin of the first storage chip, the first power module is configured to power on the first trace connected to the first-type pad, and the first power module is configured to not power on the second trace connected to the first-type pad; and when the circuit board is configured to carry the second storage chip and the first-type pad is configured to be connected to the power pin of the second storage chip, the first power module is configured to power on the second trace connected to the first-type pad, and the first power module is configured to not power on the first trace connected to the first-type pad.

In a possible implementation, the first trace connected to the first power module does not include the first jumper area, and the second trace not connected to the first power module includes the first jumper area. When the circuit board is configured to carry the first storage chip and the first-type pad is configured to be connected to the power pin of the first storage chip, the first power module is configured to power on the first trace connected to the first-type pad, and the first jumper area included in the second trace connected to the first-type pad is not used to mount a jumper element; and when the circuit board is configured to carry the second storage chip and the first-type pad is configured to be connected to a signal pin or a ground pin of the second storage chip, the first jumper area included in the second trace connected to the first-type pad is used to mount a jumper element, and the first power module is configured to not power on the first trace connected to the first-type pad.

In a possible implementation, the second trace connected to the first power module does not include the first jumper area, and the first trace not connected to the first power module includes the first jumper area. When the circuit board is configured to carry the first storage chip and the first-type pad is configured to be connected to a signal pin or a ground pin of the first storage chip, the first jumper area included in the first trace connected to the first-type pad is used to mount a jumper element, and the first power module is configured to not power on the second trace connected to the first-type pad; and when the circuit board is configured to carry the second storage chip and the first-type pad is configured to be connected to the power pin of the second storage chip, the first power module is configured to power on the second trace connected to the first-type pad, and the first jumper area included in the first trace connected to the first-type pad is not used to mount a jumper element.

In a possible implementation, the plurality of first pads include a second-type pad, and the second-type pad is configured to be connected to a signal pin of the first storage chip and a signal pin of the second storage chip, or is configured to be connected to a signal pin of the first storage chip and a ground pin of the second storage chip, or is configured to be connected to a ground pin of the first storage chip and a signal pin of the second storage chip. The first trace and the second trace that are connected to the second-type pad each include the first jumper area; when the circuit board is configured to carry the first storage chip, the first jumper area included in the first trace connected to at least some second-type pads is used to mount a jumper element; and when the circuit board is configured to carry the second storage chip, the first jumper area included in the second trace connected to the second-type pad is used to mount a jumper element. In this way, a jump is made in the first jumper area included in the first trace and the second trace that are connected to the second-type pad, so that some pins of the first storage chip and the second storage chip are compatible on a second-type pad on a same circuit board.

In a possible implementation, the first pad group further includes a plurality of second pads, each second pad is connected to one trace, one trace connected to the second pad is a third trace, the third trace connected to some second pads includes a second jumper area, the third trace is broken off in the second jumper area, and the third trace connected to the other second pads does not include the second jumper area. When the circuit board is configured to carry the first storage chip or the second storage chip, the second jumper area included in the third trace connected to the at least some second pads is used to mount a jumper element. In this way, a specific connection relationship of the second pad in the circuit board is provided.

In a possible implementation, the plurality of second pads include a third-type pad, and the third-type pad is configured to be connected to a power pin of the first storage chip and an unused pin of the second storage chip, or is configured to be connected to an unused pin of the first storage chip and a power pin of the second storage chip. The circuit board is further configured to carry a second power module, and the second power module is configured to be connected to the third-type pad through the third trace.

In a possible implementation, the third trace connected to the third-type pad includes the second jumper area. When the circuit board is configured to carry the first storage chip and the third-type pad is configured to be connected to the power pin of the first storage chip, the second jumper area included in the third trace connected to the third-type pad is used to mount a jumper element; and when the circuit board is configured to carry the second storage chip and the third-type pad is configured to be connected to the unused pin of the second storage chip, the second jumper area included in the third trace connected to the third-type pad is not used to mount a jumper element. When the circuit board is configured to carry the first storage chip and the third-type pad is configured to be connected to the unused pin of the first storage chip, the second jumper area included in the third trace connected to the third-type pad is not used to mount a jumper element; and when the circuit board is configured to carry the second storage chip and the third-type pad is configured to be connected to the power pin of the second storage chip, the second jumper area included in the third trace connected to the third-type pad is used to mount a jumper element. In this way, a jumper element is mounted in the second jumper area included in the third trace connected to the third-type pad, so that some pins of the first storage chip and the second storage chip are compatible on a third-type pad on a same circuit board.

In a possible implementation, the third trace connected to the third-type pad does not include the second jumper area. When the circuit board is configured to carry the first storage chip and the third-type pad is configured to be connected to the power pin of the first storage chip, the second power module is configured to power on the third trace connected to the third-type pad; and when the circuit board is configured to carry the second storage chip and the third-type pad is configured to be connected to the unused pin of the second storage chip, the second power module is configured to not power on the third trace connected to the third-type pad. When the circuit board is configured to carry the first storage chip and the third-type pad is configured to be connected to the unused pin of the first storage chip, the second power module is configured to not power on the third trace connected to the third-type pad; and when the circuit board is configured to carry the second storage chip and the third-type pad is configured to be connected to the power pin of the second storage chip, the second power module is configured to power on the third trace connected to the third-type pad. In this way, the second power module performs powering-on or does not perform powering-on, so that some pins of the first storage chip and the second storage chip are compatible on a third-type pad on a same circuit board, to reduce jumper elements that need to be mounted in the second jumper area, thereby reducing costs of a circuit board assembly and simplifying manufacturing steps of the circuit board assembly.

In a possible implementation, the plurality of second pads include a fourth-type pad, the fourth-type pad is configured to be connected to an unused pin of the first storage chip and/or an unused pin of the second storage chip, and the fourth-type pad is not configured to be connected to a power pin of the first storage chip or a power pin of the second storage chip.

In a possible implementation, the third trace connected to the fourth-type pad includes the second jumper area. When the circuit board is configured to carry the first storage chip and the fourth-type pad is configured to be connected to the unused pin of the first storage chip, the second jumper area included in the third trace connected to the fourth-type pad is not used to mount a jumper element; and when the circuit board is configured to carry the second storage chip and the fourth-type pad is configured to be connected to a ground pin or a signal pin of the second storage chip, the second jumper area included in the third trace connected to the fourth-type pad is used to mount a jumper element. When the circuit board is configured to carry the first storage chip and the fourth-type pad is configured to be connected to a ground pin or a signal pin of the first storage chip, the second jumper area included in the third trace connected to the fourth-type pad is used to mount a jumper element or is not used to mount a jumper element; and when the circuit board is configured to carry the second storage chip and the fourth-type pad is configured to be connected to the unused pin of the second storage chip, the second jumper area included in the third trace connected to the fourth-type pad is not used to mount a jumper element. In this way, a jumper element is mounted in the second jumper area included in the third trace connected to the fourth-type pad, so that some pins of the first storage chip and the second storage chip are compatible on a fourth-type pad on a same circuit board.

In a possible implementation, the third trace connected to the fourth-type pad does not include the second jumper area. In this way, when the first storage chip or the second storage chip is mounted on the circuit board, jumper elements that need to be mounted in the second jumper area may be reduced, thereby reducing costs of a circuit board assembly and simplifying manufacturing steps of the circuit board assembly.

In a possible implementation, the plurality of second pads includes a fifth-type pad, and the fifth-type pad is configured to be connected to a ground pin of the first storage chip and a ground pin of the second storage chip. The third trace connected to the fifth-type pad includes the second jumper area; when the circuit board is configured to carry the first storage chip, the second jumper area included in the third trace connected to the fifth-type pad is used to mount a jumper element; and when the circuit board is configured to carry the second storage chip, the second jumper area included in the third trace connected to the fifth-type pad is used to mount a jumper element or is not used to mount a jumper element; or the third trace connected to the fifth-type pad does not include the second jumper area. In this way, a specific connection relationship of the fifth-type pad on the circuit board is provided, so that some pins of the first storage chip and the second storage chip are compatible on a fifth-type pad on a same circuit board.

In a possible implementation, the circuit board further includes a second pad group, the second pad group is configured to be connected to a processor chip, and the circuit board is further configured to carry a third power module. The plurality of second pads include a sixth-type pad; the sixth-type pad is configured to be connected to a power pin of the first storage chip and a power pin of the second storage chip; when the circuit board is configured to carry the first storage chip, the power pin of the first storage chip is connected to a first power pin of the processor chip sequentially through the sixth-type pad, the third trace, and the third power module; when the circuit board is configured to carry the second storage chip, the power pin of the second storage chip is connected to a second power pin of the processor chip sequentially through the sixth-type pad, the third trace, and the third power module; and the first power pin and the second power pin are a same power pin. The third trace connected to the sixth-type pad includes the second jumper area; and when the circuit board is configured to carry the first storage chip or the second storage chip, the second jumper area included in the third trace connected to the sixth-type pad is used to mount a jumper element; or the third trace connected to the sixth-type pad does not include the second jumper area; and when the circuit board is configured to carry the first storage chip or the second storage chip, the third power module is configured to power on the third trace connected to the sixth-type pad. In this way, when a same power pin of the processor chip is separately connected to power pins that are of the first storage chip and the second storage chip and that are at a same location, two traces may be combined into one trace, to simplify a structure of the circuit board.

In a possible implementation, the jumper element includes any one of a resistor, a capacitor, a diode, and a transistor.

In a possible implementation, sizes of all of the at least two types of storage chips are the same. In this way, it is convenient to reserve a mounting location on the storage chip in the circuit board.

In a possible implementation, the at least two types of storage chips include at least two of a first universal flash storage (universal flash storage, UFS) storage chip, a second UFS storage chip, and an embedded multimedia card (embedded multimedia card, EMMC) storage chip, and an interface version of the first UFS storage chip is different from an interface version of the second UFS storage chip.

According to a second aspect, an embodiment of this application provides a circuit board assembly, including a target storage chip and the foregoing circuit board. The target storage chip is connected to the circuit board.

According to a third aspect, an embodiment of this application provides an electronic device, including a housing and the foregoing circuit board assembly. The circuit board assembly is disposed inside the housing.

Effects of various possible implementations of the second aspect and the third aspect are similar to effects of the first aspect and the possible designs of the first aspect, and details are not described herein again.

### BRIEF DESCRIPTION OF DRAWINGS

FIG. 1 is a schematic diagram of a three-dimensional structure of an electronic device according to an embodiment of this application;
FIG. 2 is a schematic diagram of a breakdown structure of an electronic device according to an embodiment of this application;
FIG. 3 is a schematic diagram of a structure of a circuit board assembly according to an embodiment of this application;
FIG. 4 is a schematic diagram of a layout of pins after a first storage chip or a second storage chip is packaged according to an embodiment of this application;
FIG. 5 is a schematic diagram of an example structure of a circuit board according to an embodiment of this application;
FIG. 6 is a schematic diagram of a connection relationship between a first-type pin common pad and each of a first trace and a second trace according to an embodiment of this application;
FIG. 7 is a schematic diagram of another connection relationship between a first-type pin common pad and each of a first trace and a second trace according to an embodiment of this application;
FIG. 8 is a schematic diagram of a connection relationship between a second-type pin common pad and each of a first trace and a second trace according to an embodiment of this application;
FIG. 9 is a schematic diagram of another connection relationship between a second-type pin common pad and each of a first trace and a second trace according to an embodiment of this application;
FIG. 10 is a schematic diagram of a connection relationship between a third-type pin common pad and each of a first trace and a second trace according to an embodiment of this application;
FIG. 11 is a schematic diagram of another connection relationship between a third-type pin common pad and each of a first trace and a second trace according to an embodiment of this application;
FIG. 12 is a schematic diagram of a connection relationship between a fourth-type pin common pad and each of a first trace and a second trace according to an embodiment of this application;
FIG. 13 is a schematic diagram of another connection relationship between a fourth-type pin common pad and each of a first trace and a second trace according to an embodiment of this application;
FIG. 14 is a schematic diagram of a connection relationship between a fifth-type pin common pad and each of a first trace and a second trace according to an embodiment of this application;
FIG. 15 is a schematic diagram of another connection relationship between a fifth-type pin common pad and each of a first trace and a second trace according to an embodiment of this application;
FIG. 16 is a schematic diagram of a connection relationship between a sixth-type pin common pad and each of a first trace and a second trace according to an embodiment of this application;
FIG. 17 is a schematic diagram of a connection relationship between a seventh-type pin common pad and each of a first trace and a second trace according to an embodiment of this application;
FIG. 18 is a schematic diagram of a connection relationship between an eighth-type pin common pad and each of a first trace and a second trace according to an embodiment of this application;
FIG. 19 is a schematic diagram of a connection relationship between a ninth-type pin common pad and a third trace according to an embodiment of this application;
FIG. 20 is a schematic diagram of another connection relationship between a ninth-type pin common pad and a third trace according to an embodiment of this application;
FIG. 21 is a schematic diagram of a connection relationship between a tenth-type pin common pad and a third trace according to an embodiment of this application;
FIG. 22 is a schematic diagram of another connection relationship between a tenth-type pin common pad and a third trace according to an embodiment of this application;
FIG. 23 is a schematic diagram of a connection relationship between an eleventh-type pin common pad and a third trace according to an embodiment of this application;
FIG. 24 is a schematic diagram of a connection relationship between a twelfth-type pin common pad and a third trace according to an embodiment of this application;
FIG. 25 is a schematic diagram of a connection relationship between a thirteenth-type pin common pad and a third trace according to an embodiment of this application;
FIG. 26 is a schematic diagram of a connection relationship between a fourteenth-type pin common pad and a third trace according to an embodiment of this application;
FIG. 27 is a schematic diagram of a connection relationship between a fifteenth-type pin common pad and a third trace according to an embodiment of this application;
FIG. 28 is a schematic diagram of a connection relationship between a sixteenth-type pin common pad and a third trace according to an embodiment of this application;
FIG. 29 is a schematic diagram of an example structure in which a first storage chip is mounted on a circuit board according to an embodiment of this application;
FIG. 30 is a schematic diagram of an example structure in which a second storage chip is mounted on a circuit board according to an embodiment of this application;
FIG. 31 is a schematic diagram of a connection relationship between a sixth-type pad and a third trace according to an embodiment of this application; and
FIG. 32 is a schematic diagram of another connection relationship between a sixth-type pad and a third trace according to an embodiment of this application.

### DESCRIPTION OF EMBODIMENTS

To clearly describe the technical solutions in embodiments of this application, words such as "first" and "second" are used in embodiments of this application to distinguish between same items or similar items that have basically a same function or purpose. For example, a first chip and a second chip are merely used to distinguish between different chips, and are not intended to limit a sequence thereof. A person skilled in the art may understand that words such as "first" and "second" do not limit a quantity and an execution sequence, and the words such as "first" and "second" do not indicate a definite difference.

It should be noted that in the embodiments of this application, words such as "example" or "for example" are used to represent giving an example, an illustration, or a description. Any embodiment or design solution described as "example" or "for example" in this application should not be construed as preferred or advantageous over other embodiments or design solutions. Exactly, use of a word such as "example" or "for example" is intended to present related concepts in a specific manner.

In the embodiments of this application, "at least one" means one or more, and " a plurality of" means two or more. The term "and/or" is an association relationship for describing associated objects, and may indicate that three relationships may exist. For example, A and/or B may indicate the following cases: Only A exists, both A and B exist, and only B exits, where A and B may be singular or plural. The character "/" usually indicates an "or" relationship between the associated objects. "At least one of the following items (pieces)" or a similar expression thereof indicates any combination of these items, including a single item (piece) or any combination of a plurality of items (pieces). For example, at least one of a, b, or c may represent a, b, c, a and b, a and c, b and c, or a, b, and c, where a, b, and c may be singular or plural.

A storage chip may be mounted on a circuit board disposed in some electronic devices. Currently, there are a plurality of different types of storage chips, and the different types of storage chips have different protocols. In this case, when the different types of storage chips are mounted on a circuit board, the different types of storage chips require different circuit boards, so that a type of circuit board needs to be separately manufactured for each type of storage chip. Consequently, utilization of a same type of circuit board is reduced, and design costs of the circuit board are increased.

Based on this, the embodiments of this application provide a circuit board, a circuit board assembly, and an electronic device. The circuit board is configured to carry a target storage chip, the target storage chip includes any one of at least two types of storage chips, quantities of pins of all of the at least two types of storage chips are equal, and pin arrangements of all of the at least two types of storage chips are the same. The circuit board includes a first pad group, the first pad group is configured to be connected to the target storage chip, the first pad group includes a plurality of first pads, each first pad is connected to at least two traces, each trace connected to at least some first pads includes a first jumper area, and the trace is broken off in the first jumper area. When the circuit board is configured to carry the target storage chip, the first jumper area included in a target trace connected to the at least some first pads is used to mount a jumper element, and the target trace is a trace corresponding to the target storage chip in the at least two traces connected to the first pad.

Therefore, each first pad on the circuit board is disposed to be connected to at least two traces, so that pin connection relationships of different types of storage chips are compatible. In addition, each trace connected to the at least some first pads includes the first jumper area, so that when different types of storage chips are mounted on the circuit board, a jumper element may be mounted in the first jumper area included in one corresponding trace in the at least two traces connected to the first pad, to implement gating. In this way, different types of storage chips are compatible on a same circuit board, to improve utilization of a same type of circuit board, and reduce design costs of the circuit board.

It may be understood that the electronic device in this embodiment of this application may be an electronic product that includes a storage chip, for example, a mobile phone, a tablet computer (Pad), a notebook computer, a smart TV, a wearable device (for example, a smartwatch or a smart band), an electronic book reader, a personal computer (personal computer, PC), a personal digital assistant (personal digital assistant, PDA), a vehicle-mounted device, a financial device, a virtual reality (virtual reality, VR) terminal device, or an augmented reality (augmented reality, AR) terminal device. A specific technology and a specific device form that are used for the electronic device are not limited in the embodiments of this application.

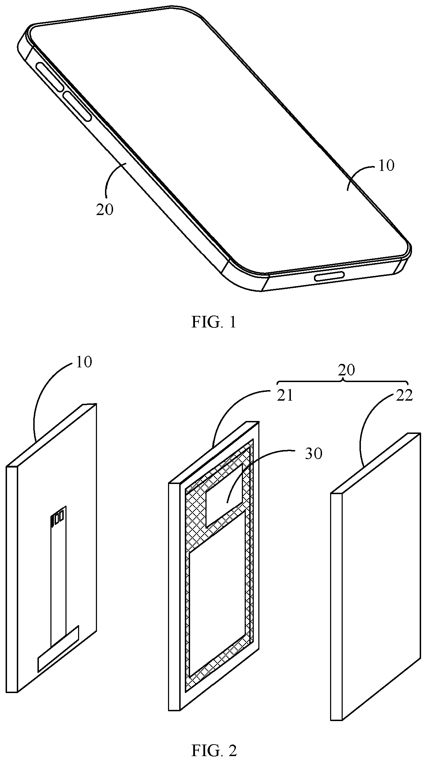

FIG. 1 is a schematic diagram of a three-dimensional structure of an electronic device according to an embodiment of this application. FIG. 2 is a schematic diagram of a breakdown structure of the electronic device shown in FIG. 1. As shown in FIG. 1 and FIG. 2, that the electronic device is a mobile phone is used as an example. The electronic device may include a display module 10, a housing 20, and a circuit board assembly 30. The housing 20 includes a middle frame 21 and a rear cover 22, and the middle frame 21 is located between the display module 10 and the rear cover 22.

The display module 10 is configured to implement a display function. The display module 10 may include a display panel. The display panel may be a liquid crystal display (liquid crystal display, LCD) display panel, an organic light-emitting diode (organic light-emitting diode, OLED) display panel, an active-matrix organic light emitting diode or an active-matrix organic light emitting diode (active-matrix organic light emitting diod, AMOLED) display panel, a flexible light-emitting diode (flex light-emitting diode, FLED) display panel, a Miniled display panel, a MicroLed display panel, a Micro-oLed display panel, a quantum dot light emitting diode (quantum dot light emitting diodes, QLED) display panel, and the like.

In some embodiments, the middle frame 21 and the rear cover 22 may be of an integral structure, to enhance structural compactness of the electronic device, and reduce a possibility that an electronic element inside the electronic device is broken because the rear cover 22 is detached when the electronic device falls. In some other embodiments, the middle frame 21 and the rear cover 22 may alternatively be connected in a detachable manner, to help repair and replace the electronic element such as a battery and a circuit board inside the electronic device, and increase flexibility of using the electronic device.

The display module 10, the middle frame 21, and the rear cover 22 may enclose accommodation space of the electronic device, and parts such as the circuit board assembly 30, the battery, and a camera module may be disposed in the accommodation space, so that the circuit board assembly 30 is disposed inside the housing 20. For example, as shown in FIG. 2, the circuit board assembly 30 may be located on a surface on a side that is of the middle frame 21 and that faces the rear cover 22.

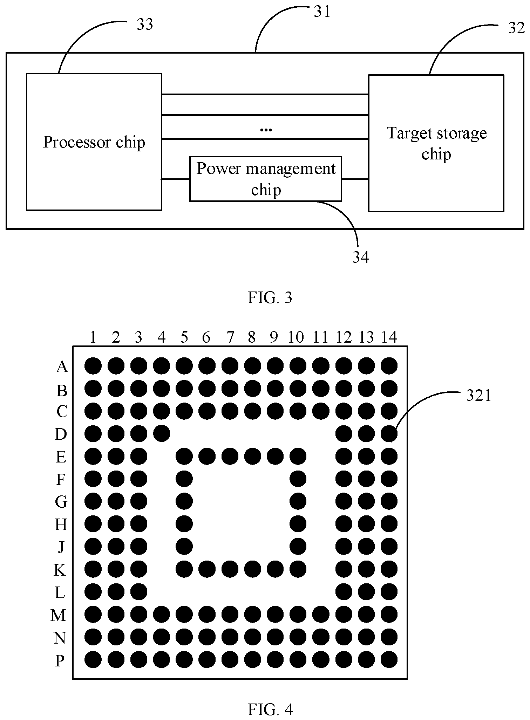

For example, FIG. 3 is a schematic diagram of a structure of a circuit board assembly according to an embodiment of this application. As shown in FIG. 3, a circuit board assembly 30 includes a circuit board 31, a target storage chip 32, a processor chip 33, and a power management chip 34. The target storage chip 32, the processor chip 33, and the power management chip 34 may be connected to the circuit board 31. Specifically, the target storage chip 32, the processor chip 33, and the power management chip 34 may be connected to the circuit board 31 through welding.

The circuit board 31 may be a main board of an electronic device, and plays a role of carrying electronic elements such as the target storage chip 32, the processor chip 33, and the power management chip 34 and implementing an electrical connection among the target storage chip 32, the processor chip 33, and the power management chip 34. In addition, the circuit board 31 may include but is not limited to a printed circuit board (printed circuit board, PCB), a flexible printed circuit (flexible printed circuit, FPC), and a flexible-rigid circuit board.

In the electronic device, core components of a storage system include the target storage chip 32, the processor chip 33, an interface, a bus, and the like. An interface of the target storage chip 32 includes all pins after the target storage chip 32 is packaged, an interface of the processor chip 33 includes all pins after the processor chip 33 is packaged, and the bus is a trace that is on the circuit board 31 and that may be used to implement communication transmission between the target storage chip 32 and the processor chip 33 when the target storage chip 32 and the processor chip 33 are connected to the circuit board 31.

In the storage system of the electronic device, the power management chip 34 may perform powering-on, and may complete data exchange between the target storage chip 32 and the processor chip 33 under a constraint of a protocol. The bus, the interface, and the power management chip 34 provide a hardware environment necessary for the storage system of the electronic device. The protocol is used to standardize a hardware behavior, reduce data errors in a case of high-speed transmission, and maintain normal running of the storage system.

The processor chip 33 includes but is not limited to a central processing unit (central processing unit, CPU) chip, and the processor chip 33 may also be referred to as a host chip. Some processor chips 33 may support a plurality of different types of storage chips.

The power management chip 34 may be a power management integrated circuit (power management IC, PMIC) chip, and is mainly configured to convert, into a voltage required for working of the target storage chip 32, a voltage provided by the processor chip 33.

The target storage chip 32 may include any one of at least two types of storage chips, and protocols (protocol modes or protocol specifications) of all of the at least two types of storage chips are different. In addition, quantities of pins of all of the at least two types of storage chips are equal, and pin arrangements of all of the at least two types of storage chips are the same.

It should be noted that, that the pin arrangements of all of the at least two types of storage chips are the same specifically means that quantities of pins arranged in any direction on all of the at least two types of storage chips are the same, and there is an equal spacing between two adjacent pins arranged in any direction.

Currently, a storage chip used in the electronic device is rapidly developed in terms of a protocol and an interface. Currently, there are mainly two types of mobile embedded storage chips: a UFS storage chip and an EMMC storage chip. The UFS storage chip has many advantages over the EMMC storage chip, especially in performance. However, the EMMC storage chip has advantages in costs and supply. The two types of storage chips, namely, the UFS storage chip and the EMMC storage chip have independent protocols, but have consistent pin packages. To be specific, a quantity of pins of the UFS storage chip is equal to a quantity of pins of the EMMC storage chip, and a pin arrangement of the UFS storage chip is the same as a pin arrangement of the EMMC storage chip.

The UFS storage chip may include a first UFS storage chip and a second UFS storage chip, and an interface version of the first UFS storage chip is different from an interface version of the second UFS storage chip. In addition, a quantity of pins of the first UFS storage chip, a quantity of pins of the second UFS storage chip, and the quantity of pins of the EMMC storage chip are equal, and a pin arrangement of the first UFS storage chip, a pin arrangement of the second UFS storage chip, and the pin arrangement of the EMMC storage chip are the same.

The first UFS storage chip may be a UFS storage chip of UFS 3.0 and a protocol of a higher version, the second UFS storage chip may be a UFS storage chip of UFS 3.0 and a protocol of a lower version, and the first UFS storage chip is downward-compatible with the second UFS storage chip. For example, the first UFS storage chip may be a UFS 3.1 storage chip, and the second UFS storage chip may be a UFS 2.2 storage chip. The EMMC storage chip may be an EMMC 5.1 storage chip.

In some embodiments, the processor chip 33 not only supports the UFS storage chip, but also may support the EMMC storage chip. For example, the processor chip 33 supports the first UFS storage chip and the EMMC storage chip, or the processor chip 33 supports the second UFS storage chip and the EMMC storage chip.

In this case, each first pad on the circuit board 31 is disposed to be connected to two traces, to implement a design of compatibility of a connection relationship between the processor chip 33 and the UFS storage chip and a connection relationship between the processor chip 33 and the EMMC storage chip, so that when the UFS storage chip or the EMMC storage chip is mounted on the circuit board 31, a jumper element may be mounted in a first jumper area included in a corresponding trace in the two traces connected to the first pad, to implement gating. In this way, the two types of storage chips, namely, the UFS storage chip and the EMMC storage chip are compatible on a same circuit board 31. Therefore, in this embodiment of this application, access and control of the UFS storage chip or the EMMC storage chip may be implemented on a same circuit board 31.

In some other embodiments, the processor chip 33 may further support the first UFS storage chip and the second UFS storage chip. Correspondingly, the two types of storage chips, namely, the first UFS storage chip and the second UFS storage chip are also compatible on a same circuit board 31.

In still some other embodiments, the processor chip 33 may further support the first UFS storage chip, the second UFS storage chip, and the EMMC storage chip.

In this case, each first pad on the circuit board 31 is disposed to be connected to at least two traces, to implement a design of compatibility of a connection relationship between the processor chip 33 and the first UFS storage chip, a connection relationship between the processor chip 33 and the second UFS storage chip, and a connection relationship between the processor chip 33 and the EMMC storage chip, so that when any one of the first UFS storage chip, the second UFS storage chip, and the EMMC storage chip is mounted on the circuit board 31, a jumper element may be mounted in a first jumper area included in a corresponding trace in the at least two traces connected to the first pad, to implement gating. In this way, the three storage chips, namely, the first UFS storage chip, the second UFS storage chip, and the EMMC storage chip are compatible on a same circuit board 31.

In conclusion, the at least two types of storage chips include at least two of the first UFS storage chip, the second UFS storage chip, and the EMMC storage chip. In this case, a difference between interfaces and external circuit designs of storage chips of different protocols is analyzed in this embodiment of this application, so that when the processor chip 33 can simultaneously support storage chips of a plurality of different protocols, the storage chips of the different protocols are compatible on a same circuit board 31, and flexibility of the storage system is improved.

It may be understood that, some target storage chips 32 may include a storage medium and a control module. The storage medium includes a plurality of storage areas, and the plurality of storage areas in the storage medium are separately used to store service data. The control module is configured to control writing of data to the storage area or reading of data in the storage area.

The following describes a specific structure of the circuit board in this embodiment of this application by using an example in which the target storage chip includes a first storage chip or a second storage chip, the first storage chip includes the first UFS storage chip or the second UFS storage chip, and the second storage chip includes the EMMC storage chip.

For example, FIG. 4 is a schematic diagram of a layout of pins after a first storage chip or a second storage chip is packaged according to an embodiment of this application. As shown in FIG. 4, pins 321 of the first storage chip or the second storage chip are arranged in an array, all rows of pins are respectively marked from top to bottom as Row A, Row B, Row C, Row D, Row E, Row F, Row G, Row H, Row J, Row K, Row L, Row M, Row N, and Row P, and columns of pins are respectively marked from left to right as Column 1, Column 2, Column 3, Column 4, Column 5, Column 6, Column 7, Column 8, Column 9, Column 10, Column 11, Column 12, Column 13, and Column 14. In addition, the first storage chip and the second storage chip each include 153 pins.

Each row on the first storage chip or the second storage chip includes a plurality of pins 321, and quantities of pins in different rows may be equal or may be unequal. Each column on the first storage chip or the second storage chip includes a plurality of pins 321 and quantities of pins in different columns may be equal or may be unequal.

Based on functions of the pins of the first storage chip or the second storage chip, the pins of the first storage chip or the second storage chip may be classified into a signal pin, a power pin, a ground pin, and an unused (not used, NU) pin. In other words, the first storage chip includes a signal pin, a power pin, a ground pin, and an unused pin, and the second storage chip also includes a signal pin, a power pin, a ground pin, and an unused pin.

The first storage chip is used as an example. The signal pin of the first storage chip includes a pin for accessing and controlling the first storage chip, the power pin of the first storage chip provides a power supply for the first storage chip, the ground pin of the first storage chip means that the pin is directly or indirectly grounded, and the unused pin of the first storage chip is a pin that is of the first storage chip and that is usually in a floating state without being connected to the outside. The unused pin includes a not connected (not connect, NC) pin and a reserved for future use (reserved for furture use, RFU) pin. The unused pin indicates that no element is connected.

It should be noted that, the pin of the first storage chip or the second storage chip is named differently by different storage chip manufacturers. An actual function of the pin is used as a reference for description in this embodiment of this application.

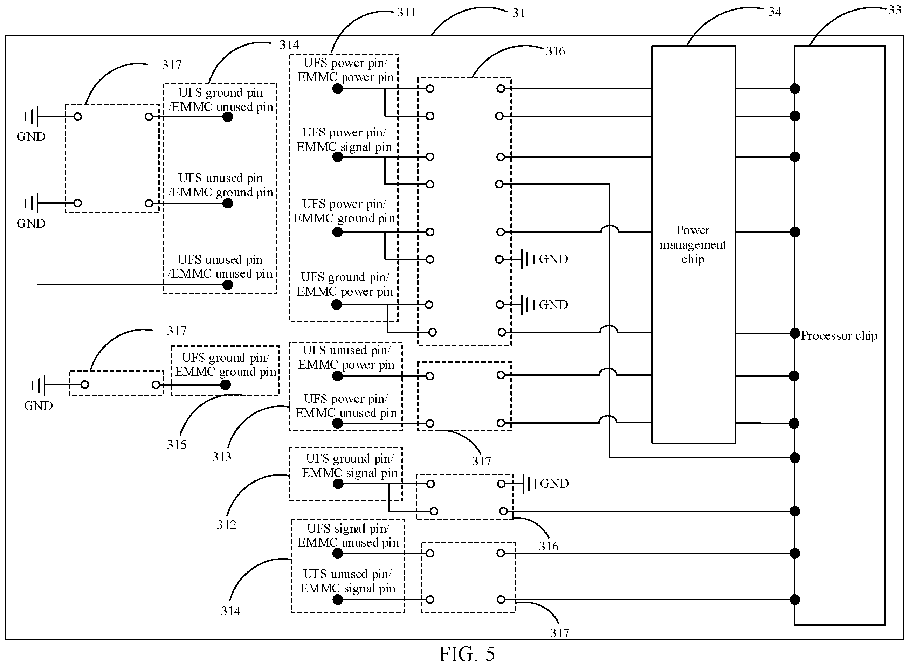

For example, FIG. 5 is a schematic diagram of an example structure of a circuit board according to an embodiment of this application. As shown in FIG. 5, a circuit board 31 is configured to carry a target storage chip 32 (not shown in FIG. 5), the target storage chip 32 includes a first storage chip or a second storage chip, a quantity of pins of the first storage chip is equal to a quantity of pins of the second storage chip, and a pin arrangement of the first storage chip is the same as a pin arrangement of the second storage chip.

It should be noted that, that the pin arrangement of the first storage chip is the same as the pin arrangement of the second storage chip specifically means that a quantity of pins of the first storage chip and a quantity of pins of the second storage chip that are arranged in any direction are the same, and there is an equal spacing between two adjacent pins arranged in any direction.

The circuit board 31 includes a first pad group, and the first pad group is configured to be connected to the first storage chip or the second storage chip. The first pad group includes a plurality of first pads, each first pad is connected to two traces, the two traces connected to each of at least some first pads each include a first jumper area 316, and a trace is broken off in the first jumper area 316.

It should be noted that the first jumper area 316 may include two pads with a specific spacing, so that a trace is disconnected in the first jumper area 316.

When the circuit board 31 is configured to carry the first storage chip, the first jumper area 316 included in a first trace connected to the at least some first pads is used to mount a jumper element, and the first trace is a trace corresponding to the first storage chip in the two traces connected to the first pad; and when the circuit board 31 is configured to carry the second storage chip, the first jumper area 316 included in a second trace connected to the at least some first pads is used to mount a jumper element, and the second trace is a trace corresponding to the second storage chip in the two traces connected to the first pad.

In this way, each first pad on the circuit board 31 is disposed to be connected to two traces. When the first storage chip is mounted on the circuit board 31, a jumper element may be mounted in the first jumper area 316 included in the first trace in the two traces connected to the first pad, to implement gating; and when the second storage chip is mounted on the circuit board 31, a jumper element may be mounted in the first jumper area 316 included in the second trace in the two traces connected to the first pad, to implement gating. In this way, the first storage chip and the second storage chip are compatible on a same circuit board 31.

In some embodiments, the pads included in the first pad group are arranged in an array. In addition, the pads included in the first pad group are in a one-to-one correspondence with the pins included on the first storage chip, the pads included in the first pad group are also in a one-to-one correspondence with the pins included on the second storage chip, and a pad and a pin that correspond to each other are configured to be electrically connected, to implement a signal transfer.

Specifically, an arrangement array of all the pads (including the first pad and a second pad) included in the first pad group is the same as an arrangement array of all the pins included on the first storage chip, and a quantity of pads included in the first pad group is equal to the quantity of pins included on the first storage chip. Correspondingly, the arrangement array of all the pads included in the first pad group is the same as an arrangement array of all the pins included on the second storage chip, and the quantity of pads included in the first pad group is equal to the quantity of pins included on the second storage chip.

In this embodiment of this application, the first storage chip and the second storage chip are compatible on a same circuit board 31. For a pad at a same location in the first pad group, a function of a pin when the pad is connected to the first storage chip may be different from a function of a pin when the pad is connected to the second storage chip.

Therefore, when the first storage chip and the second storage chip are compatible on the circuit board 31, there may be 16 cases of a specific connection relationship between all the pads in the first pad group on the circuit board 31.

In a first case, a pad at a same location on the circuit board 31 is connected to a power pin of the first storage chip when the first storage chip is mounted on the circuit board 31, and is connected to a power pin of the second storage chip when the second storage chip is mounted on the circuit board 31. Such a pad may be referred to as a first-type pin common pad. For example, the first-type pin common pad may be a pad at a UFS power pin/EMMC power pin shown in FIG. 5, and means that the pad is connected to a power pin of a UFS storage chip when the UFS storage chip is mounted on the circuit board 31, and is connected to a power pin of an EMMC storage chip when the EMMC storage chip is mounted on the circuit board 31.

In a second case, a pad at a same location on the circuit board 31 is connected to a power pin of the first storage chip when the first storage chip is mounted on the circuit board 31, and is connected to a signal pin of the second storage chip when the second storage chip is mounted on the circuit board 31. Such a pad may be referred to as a second-type pin common pad. For example, the second-type pin common pad may be a pad at a UFS power pin/EMMC signal pin shown in FIG. 5, and means that the pad is connected to a power pin of a UFS storage chip when the UFS storage chip is mounted on the circuit board 31, and is connected to a signal pin of an EMMC storage chip when the EMMC storage chip is mounted on the circuit board 31.

In a third case, a pad at a same location on the circuit board 31 is connected to a power pin of the first storage chip when the first storage chip is mounted on the circuit board 31, and is connected to a ground pin of the second storage chip when the second storage chip is mounted on the circuit board 31. Such a pad may be referred to as a third-type pin common pad. For example, the third-type pin common pad may be a pad at a UFS power pin/EMMC ground pin shown in FIG. 5, and means that the pad is connected to a power pin of a UFS storage chip when the UFS storage chip is mounted on the circuit board 31, and is connected to a ground pin of an EMMC storage chip when the EMMC storage chip is mounted on the circuit board 31.

In a fourth case, a pad at a same location on the circuit board 31 is connected to a signal pin of the first storage chip when the first storage chip is mounted on the circuit board 31, and is connected to a power pin of the second storage chip when the second storage chip is mounted on the circuit board 31. Such a pad may be referred to as a fourth-type pin common pad. For example, the first storage chip is a UFS storage chip, and the second storage chip is an EMMC storage chip. The fourth-type pin common pad may not exist on the circuit board 31. Therefore, the fourth-type pin common pad is not shown in FIG. 5. Certainly, it may be understood that when the first storage chip and/or the second storage chip are another type of storage chip, the fourth-type pin common pad may alternatively exist on the circuit board 31.

In a fifth case, a pad at a same location on the circuit board 31 is connected to a ground pin of the first storage chip when the first storage chip is mounted on the circuit board 31, and is connected to a power pin of the second storage chip when the second storage chip is mounted on the circuit board 31. Such a pad may be referred to as a fifth-type pin common pad. For example, the fifth-type pin common pad may be a pad at a UFS ground pin/EMMC power pin shown in FIG. 5, and means that the pad is connected to a ground pin of a UFS storage chip when the UFS storage chip is mounted on the circuit board 31, and is connected to a power pin of an EMMC storage chip when the EMMC storage chip is mounted on the circuit board 31.

In a sixth case, a pad at a same location on the circuit board 31 is connected to a signal pin of the first storage chip when the first storage chip is mounted on the circuit board 31, and is connected to a signal pin of the second storage chip when the second storage chip is mounted on the circuit board 31. Such a pad may be referred to as a sixth-type pin common pad. For example, the first storage chip is a UFS storage chip, and the second storage chip is an EMMC storage chip. The sixth-type pin common pad may not exist on the circuit board 31. Therefore, the sixth-type pin common pad is not shown in FIG. 5. Certainly, it may be understood that when the first storage chip and/or the second storage chip are another type of storage chip, the sixth-type pin common pad may alternatively exist on the circuit board 31.

In a seventh case, a pad at a same location on the circuit board 31 is connected to a ground pin of the first storage chip when the first storage chip is mounted on the circuit board 31, and is connected to a signal pin of the second storage chip when the second storage chip is mounted on the circuit board 31. Such a pad may be referred to as a seventh-type pin common pad. For example, the seventh-type pin common pad may be a pad at a UFS ground pin/EMMC signal pin shown in FIG. 5, and means that the pad is connected to a ground pin of a UFS storage chip when the UFS storage chip is mounted on the circuit board 31, and is connected to a signal pin of an EMMC storage chip when the EMMC storage chip is mounted on the circuit board 31.

In an eighth case, a pad at a same location on the circuit board 31 is connected to a signal pin of the first storage chip when the first storage chip is mounted on the circuit board 31, and is connected to a ground pin of the second storage chip when the second storage chip is mounted on the circuit board 31. Such a pad may be referred to as an eighth-type pin common pad. For example, the first storage chip is a UFS storage chip, and the second storage chip is an EMMC storage chip. The eighth-type pin common pad may not exist on the circuit board 31. Therefore, the eighth-type pin common pad is not shown in FIG. 5. Certainly, it may be understood that when the first storage chip and/or the second storage chip are another type of storage chip, the eighth-type pin common pad may alternatively exist on the circuit board 31.

In a ninth case, a pad at a same location on the circuit board 31 is connected to an unused pin of the first storage chip when the first storage chip is mounted on the circuit board 31, and is connected to a power pin of the second storage chip when the second storage chip is mounted on the circuit board 31. Such a pad may be referred to as a ninth-type pin common pad. For example, the ninth-type pin common pad may be a pad at a UFS unused pin//EMMC power pin shown in FIG. 5, and means that the pad is connected to an unused pin of a UFS storage chip when the UFS storage chip is mounted on the circuit board 31, and is connected to a power pin of an EMMC storage chip when the EMMC storage chip is mounted on the circuit board 31.

In a tenth case, a pad at a same location on the circuit board 31 is connected to a power pin of the first storage chip when the first storage chip is mounted on the circuit board 31, and is connected to an unused pin of the second storage chip when the second storage chip is mounted on the circuit board 31. Such a pad may be referred to as a tenth-type pin common pad. For example, the tenth-type pin common pad may be a pad at a UFS power pin/EMMC unused pin shown in FIG. 5, and means that the pad is connected to a power pin of a UFS storage chip when the UFS storage chip is mounted on the circuit board 31, and is connected to an unused pin of an EMMC storage chip when the EMMC storage chip is mounted on the circuit board 31.

In an eleventh case, a pad at a same location on the circuit board 31 is connected to a ground pin of the first storage chip when the first storage chip is mounted on the circuit board 31, and is connected to an unused pin of the second storage chip when the second storage chip is mounted on the circuit board 31. Such a pad may be referred to as an eleventh-type pin common pad. For example, the eleventh-type pin common pad may be a pad at a UFS ground pin/EMMC unused pin shown in FIG. 5, and means that the pad is connected to a ground pin of a UFS storage chip when the UFS storage chip is mounted on the circuit board 31, and is connected to an unused pin of an EMMC storage chip when the EMMC storage chip is mounted on the circuit board 31.

In a twelfth case, a pad at a same location on the circuit board 31 is connected to an unused pin of the first storage chip when the first storage chip is mounted on the circuit board 31, and is connected to a ground pin of the second storage chip when the second storage chip is mounted on the circuit board 31. Such a pad may be referred to as a twelfth-type pin common pad. For example, the twelfth-type pin common pad may be a pad at a UFS unused pin//EMMC ground pin shown in FIG. 5, and means that the pad is connected to an unused pin of a UFS storage chip when the UFS storage chip is mounted on the circuit board 31, and is connected to a ground pin of an EMMC storage chip when the EMMC storage chip is mounted on the circuit board 31.

In a thirteenth case, a pad at a same location on the circuit board 31 is connected to a signal pin of the first storage chip when the first storage chip is mounted on the circuit board 31, and is connected to an unused pin of the second storage chip when the second storage chip is mounted on the circuit board 31. Such a pad may be referred to as a thirteenth-type pin common pad. For example, the thirteenth-type pin common pad may be a pad at a UFS signal pin/EMMC unused pin shown in FIG. 5, and means that the pad is connected to a signal pin of a UFS storage chip when the UFS storage chip is mounted on the circuit board 31, and is connected to an unused pin of an EMMC storage chip when the EMMC storage chip is mounted on the circuit board 31.

In a fourteenth case, a pad at a same location on the circuit board 31 is connected to an unused pin of the first storage chip when the first storage chip is mounted on the circuit board 31, and is connected to a signal pin of the second storage chip when the second storage chip is mounted on the circuit board 31. Such a pad may be referred to as a fourteenth-type pin common pad. For example, the fourteenth-type pin common pad may be a pad at a UFS unused pin//EMMC signal pin shown in FIG. 5, and means that the pad is connected to an unused pin of a UFS storage chip when the UFS storage chip is mounted on the circuit board 31, and is connected to a signal pin of an EMMC storage chip when the EMMC storage chip is mounted on the circuit board 31.

In a fifteenth case, a pad at a same location on the circuit board 31 is connected to an unused pin of the first storage chip when the first storage chip is mounted on the circuit board 31, and is connected to an unused pin of the second storage chip when the second storage chip is mounted on the circuit board 31. Such a pad may be referred to as a fifteenth-type pin common pad. For example, the fifteenth-type pin common pad may be a pad at a UFS unused pin/EMMC unused pin shown in FIG. 5, and means that the pad is connected to an unused pin of a UFS storage chip when the UFS storage chip is mounted on the circuit board 31, and is connected to an unused pin of an EMMC storage chip when the EMMC storage chip is mounted on the circuit board 31.

In a sixteenth case, a pad at a same location on the circuit board 31 is connected to a ground pin of the first storage chip when the first storage chip is mounted on the circuit board 31, and is connected to a ground pin of the second storage chip when the second storage chip is mounted on the circuit board 31. Such a pad may be referred to as a sixteenth-type pin common pad. For example, the sixteenth-type pin common pad may be a pad at a UFS ground pin//EMMC ground pin shown in FIG. 5, and means that the pad is connected to a ground pin of a UFS storage chip when the UFS storage chip is mounted on the circuit board 31, and is connected to a ground pin of an EMMC storage chip when the EMMC storage chip is mounted on the circuit board 31.

For ease of distinguishing between the sixteen cases, a pad configured to be connected to two traces in the first pad group may be referred to as a first pad, and a pad configured to be connected to one trace in the first pad group may be referred to as a second pad. In addition, a first pad in the plurality of first pads that is configured to be connected to the power pin of the first storage chip and/or the power pin of the second storage chip is referred to as a first-type pad 311, and a first pad in the plurality of first pads that is not configured to be connected to the power pin of the first storage chip or the power pin of the second storage chip is referred to as a second-type pad 312. In addition, a second pad in a plurality of second pads that is configured to be connected to the power pin of the first storage chip or the power pin of the second storage chip is referred to as a third-type pad 313, a second pad in the plurality of second pads that is connected to the ground pin of the first storage chip and the ground pin of the second storage chip is referred to as a fifth-type pad 315, and a remaining second pad in the plurality of second pads is referred to as a fourth-type pad 314.

Therefore, the plurality of first pads are classified into the first-type pad 311 and the second-type pad 312; the first-type pad 311 may include the first-type pin common pad, the second-type pin common pad, the third-type pin common pad, the fourth-type pin common pad, and the fifth-type pin common pad; and the second-type pad 312 includes the sixth-type pin common pad, the seventh-type pin common pad, and the eighth-type pin common pad. The plurality of second pads are classified into the third-type pad 313, the fourth-type pad 314, and the fifth-type pad 315; the third-type pad 313 includes the ninth-type pin common pad and the tenth-type pin common pad; the fourth-type pad 314 includes the eleventh-type pin common pad, the twelfth-type pin common pad, the thirteenth-type pin common pad, the fourteenth-type pin common pad, and the fifteenth-type pin common pad; and the fifth-type pad 315 includes the sixteenth-type pin common pad.

For the plurality of first pads in the first pad group, a pin correspondingly connected to each first pad when the first pad is connected to the first storage chip and a pin correspondingly connected to the first pad when the first pad is connected to the second storage chip each correspond to a specific function. Therefore, a trace connected to each first pad may be designed by using a jumper.

In some embodiments, the plurality of first pads include the first-type pad 311, the first-type pad 311 is configured to be connected to the power pin of the first storage chip and/or the power pin of the second storage chip, the first-type pad is not configured to be connected to the unused pin of the first storage chip or the unused pin of the second storage chip.

Because the first storage chip and the second storage chip each include four types of pins, namely, the signal pin, the power pin, the ground pin, and the unused pin, the first-type pad 311 is configured to be connected to the power pin of the first storage chip and the power pin of the second storage chip, or is configured to be connected to the power pin of the first storage chip and the signal pin of the second storage chip, or is configured to be connected to the power pin of the first storage chip and the ground pin of the second storage chip, or is configured to be connected to the signal pin of the first storage chip and the power pin of the second storage chip, or is configured to be connected to the ground pin of the first storage chip and the power pin of the second storage chip.

In addition, the circuit board 31 is further configured to carry a first power module. When the first-type pad 311 is configured to be connected to the power pin of the first storage chip, the first power module is configured to be connected to the first-type pad 311 through the first trace; and/or when the first-type pad 311 is configured to be connected to the power pin of the second storage chip, the first power module is configured to be connected to the first-type pad 311 through the second trace.

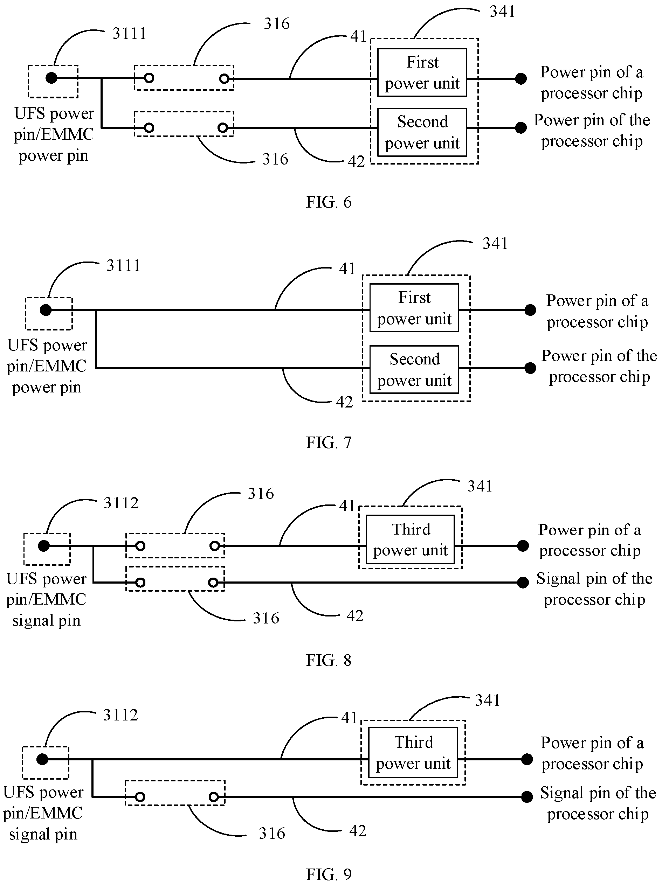

FIG. 6 is a schematic diagram of a connection relationship between a first-type pin common pad and each of a first trace and a second trace according to an embodiment of this application. FIG. 7 is a schematic diagram of another connection relationship between a first-type pin common pad and each of a first trace and a second trace according to an embodiment of this application. As shown in FIG. 6 and FIG. 7, a first-type pin common pad 3111 in a first-type pad 311 may be a pad at a UFS power pin/EMMC power pin. To be specific, the first-type pin common pad 3111 is configured to be connected to a power pin of a first storage chip and a power pin of a second storage chip. The first-type pin common pad 3111 is connected to two traces, and the two traces connected to the first-type pin common pad 3111 are respectively a first trace 41 corresponding to a UFS storage chip and a second trace 42 corresponding to an EMMC storage chip. A first power module 341 may include a first power unit and a second power unit, the first power unit is connected to the first-type pin common pad 3111 through the first trace 41, and the second power unit is connected to the first-type pin common pad 3111 through the second trace 42. In addition, the first power unit in the first power module 341 is connected to one power pin of the processor chip 33, and the second power unit in the first power module 341 is further connected to the other power pin of the processor chip 33.

In one manner, as shown in FIG. 6, the first trace 41 and the second trace 42 that are connected to the first-type pin common pad 3111 each include a first jumper area 316.

When the first storage chip is mounted on a circuit board 31, a jumper element is mounted in the first jumper area 316 included in the first trace 41 connected to the first-type pin common pad 3111, so that the first trace 41 connected to the first-type pin common pad 3111 is connected. In this way, a corresponding voltage is output to the first power module 341 by a power pin that is of the processor chip 33 and that corresponds to the first storage chip. After the first power unit in the first power module 341 converts the voltage into a voltage required for working of the first storage chip, the voltage obtained by the first power unit through conversion may be transmitted to the power pin of the first storage chip through the first trace 41 and the first-type pin common pad 3111. In addition, no jumper element is mounted in the first jumper area 316 included in the second trace 42 connected to the first-type pin common pad 3111, so that the second trace 42 connected to the first-type pin common pad 3111 is broken off.

For example, if the voltage output by the power pin that is of the processor chip 33 and that corresponds to the first storage chip may be 3.0 V, and the voltage required for working of the first storage chip may be 2.5 V, the first power unit in the first power module 341 may convert the voltage of 3.0 V into 2.5 V, to transmit 2.5 V to the power pin of the first storage chip through the first trace 41 and the first-type pin common pad 3111.

Correspondingly, when the second storage chip is mounted on the circuit board 31, a jumper element is mounted in the first jumper area 316 included in the second trace 42 connected to the first-type pin common pad 3111, so that the second trace 42 connected to the first-type pin common pad 3111 is connected. In this way, a corresponding voltage is output to the first power module 341 by a power pin that is of the processor chip 33 and that corresponds to the second storage chip. After the second power unit in the first power module 341 converts the voltage into a voltage required for working of the second storage chip, the voltage obtained by the second power unit through conversion may be transmitted to the power pin of the second storage chip through the second trace 42 and the first-type pin common pad 3111. In addition, no jumper element is mounted in the first jumper area 316 included in the first trace 41 connected to the first-type pin common pad 3111, so that the first trace 41 connected to the first-type pin common pad 3111 is broken off.

For example, the first storage chip is a first UFS storage chip, and the second storage chip is the EMMC storage chip. A pin that is of the first UFS storage chip and that is at a location F5 is a VCCQ pin (namely, a power pin), and a pin that is of the EMMC storage chip and that is at the location F5 is a VCC pin (namely, a power pin). Therefore, the first-type pin common pad 3111 includes first pads connected to the pins that are of the first UFS storage chip and the EMMC storage chip and that are at the location F5. In this case, when the first UFS storage chip is mounted on the circuit board 31, the first-type pin common pad 3111 is connected to the pin that is of the first UFS storage chip and that is at the location F5, and a jumper element such as a resistor, a diode, or a transistor is mounted in the first jumper area 316 included in the first trace 41 connected to the first-type pin common pad 3111; and when the EMMC storage chip is mounted on the circuit board 31, the first-type pin common pad 3111 is connected to the pin that is of the EMMC storage chip and that is at the location F5, and a jumper element such as a resistor, a diode, or a transistor is mounted in the first jumper area 316 included in the second trace 42 connected to the first-type pin common pad 3111.

It should be understood that the pin that is of the first UFS storage chip and that is at the location F5 indicates a pin that is of the first UFS storage chip and that is at a location in Row F and Column 5, and the pin that is of the EMMC storage chip and that is at the location F5 indicates a pin that is of the EMMC storage chip and that is at the location in Row F and Column 5. For the following description about a pin location, correspondingly refer to the location F5.

For example, the first storage chip is a second UFS storage chip, and the second storage chip is the EMMC storage chip. A pin that is of the second UFS storage chip and that is at a location C6 is a VCCQ2 pin (namely, a power pin), and a pin that is of the EMMC storage chip and that is at the location C6 is a VCCQ pin (namely, a power pin). Therefore, the first-type pin common pad 3111 includes first pads connected to the pins that are of the second UFS storage chip and the EMMC storage chip and that are at the location C6. In this case, when the second UFS storage chip is mounted on the circuit board 31, the first-type pin common pad 3111 is connected to the pin that is of the second UFS storage chip and that is at the location C6, and a jumper element such as a resistor, a diode, or a transistor is mounted in the first jumper area 316 included in the first trace 41 connected to the first-type pin common pad 3111; and when the EMMC storage chip is mounted on the circuit board 31, the first-type pin common pad 3111 is connected to the pin that is of the EMMC storage chip and that is at the location C6, and a jumper element such as a resistor, a diode, or a transistor is mounted in the first jumper area 316 included in the second trace 42 connected to the first-type pin common pad 3111.

In another manner, as shown in FIG. 7, neither of the first trace 41 and the second trace 42 that are connected to the first-type pin common pad 3111 include a first jumper area 316.

When the first storage chip is mounted on the circuit board 31, the first power unit in the first power module 341 powers on the first trace 41 connected to the first-type pin common pad 3111. To be specific, the first power unit converts, into a voltage required for working of the first storage chip, a voltage provided by the processor chip 33, and outputs the voltage to the first trace 41 connected to the first-type pin common pad 3111, so that the voltage obtained by the first power unit through conversion may be transmitted to the power pin of the first storage chip through the first trace 41 and the first-type pin common pad 3111. In addition, the second power unit in the first power module 341 does not power on the second trace 42 connected to the first-type pin common pad 3111. To be specific, the second power unit does not convert, into the voltage required for working of the second storage chip, the voltage provided by the processor chip 33, or output the voltage required for working of the second storage chip to the second trace 42 connected to the first-type pin common pad 3111.

Correspondingly, when the second storage chip is mounted on the circuit board 31, the second power unit in the first power module 341 powers on the second trace 42 connected to the first-type pin common pad 3111. To be specific, the second power unit converts, into a voltage required for working of the second storage chip, a voltage provided by the processor chip 33, and outputs the voltage to the second trace 42 connected to the first-type pin common pad 3111, so that the voltage obtained by the second power unit through conversion may be transmitted to the power pin of the second storage chip through the second trace 42 and the first-type pin common pad 3111. In addition, the first power unit in the first power module 341 does not power on the first trace 41 connected to the first-type pin common pad 3111. To be specific, the first power unit does not convert, into the voltage required for working of the first storage chip, the voltage provided by the processor chip 33, or output the voltage required for working of the first storage chip to the first trace 41 connected to the first-type pin common pad 3111.

Therefore, neither of the first trace 41 and the second trace 42 for connecting the first-type pin common pad 3111 in the first-type pad 311 shown in FIG. 7 and the first power module 341 include the first jumper area 316. When the circuit board 31 is configured to carry the first storage chip and the first-type pad 311 is configured to be connected to the power pin of the first storage chip, the first power module 341 is configured to power on the first trace 41 connected to the first-type pad 311, and the first power module 341 is configured to not power on the second trace 42 connected to the first-type pad 311; and when the circuit board 31 is configured to carry the second storage chip and the first-type pad 311 is configured to be connected to the power pin of the second storage chip, the first power module 341 is configured to power on the second trace 42 connected to the first-type pad 311, and the first power module 341 is configured to not power on the first trace 41 connected to the first-type pad 311.

FIG. 8 is a schematic diagram of a connection relationship between a second-type pin common pad and each of a first trace and a second trace according to an embodiment of this application. FIG. 9 is a schematic diagram of another connection relationship between a second-type pin common pad and each of a first trace and a second trace according to an embodiment of this application. As shown in FIG. 8 and FIG. 9, a second-type pin common pad 3112 in a first-type pad 311 may be a pad at a UFS power pin/EMMC signal pin. To be specific, the second-type pin common pad 3112 is configured to be connected to a power pin of a first storage chip and a signal pin of a second storage chip. The second-type pin common pad 3112 is connected to two traces, the two traces connected to the second-type pin common pad 3112 are respectively a first trace 41 corresponding to a UFS storage chip and a second trace 42 corresponding to an EMMC storage chip, a first power module 341 may further include a third power unit, and the third power unit is connected to the second-type pin common pad 3112 through the first trace 41. In addition, the third power unit in the first power module 341 is further connected to a power pin of a processor chip 33, and a signal pin of the processor chip 33 is further connected to the second-type pin common pad 3112 through the second trace 42.

In one manner, as shown in FIG. 8, the first trace 41 and the second trace 42 that are connected to the second-type pin common pad 3112 each include a first jumper area 316.

When the first storage chip is mounted on a circuit board 31, a jumper element is mounted in the first jumper area 316 included in the first trace 41 connected to the second-type pin common pad 3112, so that the first trace 41 connected to the second-type pin common pad 3112 is connected. In this way, a corresponding voltage is output to the first power module 341 by the power pin of the processor chip 33. After the third power unit in the first power module 341 converts the voltage into a voltage required for working of the first storage chip, the voltage obtained by the third power unit through conversion may be transmitted to the power pin of the first storage chip through the first trace 41 and the second-type pin common pad 3112. In addition, no jumper element is mounted in the first jumper area 316 included in the second trace 42 connected to the second-type pin common pad 3112, so that the second trace 42 connected to the second-type pin common pad 3112 is broken off.

Correspondingly, when the second storage chip is mounted on the circuit board 31, a jumper element is mounted in the first jumper area 316 included in the second trace 42 connected to the second-type pin common pad 3112, so that the second trace 42 connected to the second-type pin common pad 3112 is connected. In this way, a signal output by the signal pin of the processor chip 33 may be transmitted to the signal pin of the second storage chip through the second trace 42 and the second-type pin common pad 3112. In addition, no jumper element is mounted in the first jumper area 316 included in the first trace 41 connected to the second-type pin common pad 3112, so that the first trace 41 connected to the second-type pin common pad 3112 is broken off.

For example, the first storage chip is a first UFS storage chip, and the second storage chip is the EMMC storage chip. Pins of the first UFS storage chip that are at a location A4, a location A5, a location B4, and a location B5 are VCCQ pins (namely, power pins), a pin that is of the EMMC storage chip and that is at the location A4 is a DAT1 pin (namely, a signal pin), a pin that is of the EMMC storage chip and that is at the location A5 is a DAT2 pin (namely, a signal pin), a pin that is of the EMMC storage chip and that is at the location B4 is a DAT5 pin (namely, a signal pin), and a pin that is of the EMMC storage chip and that is at the location B5 is a DAT6 pin (namely, a signal pin). Therefore, the second-type pin common pad 3112 may include first pads connected to the pins that are of the first UFS storage chip and the EMMC storage chip and that are at the location A4, the location A5, the location B4, and the location B5.

In this case, when the first UFS storage chip is mounted on the circuit board 31, the second-type pin common pad 3112 includes a plurality of first pads, the first pads are respectively connected to the pins of the first UFS storage chip that are at the location A4, the location A5, the location B4, and the location B5, and a jumper element such as a resistor, a diode, or a transistor is mounted in the first jumper area 316 included in the first trace 41 connected to the second-type pin common pad 3112; and when the EMMC storage chip is mounted on the circuit board 31, the second-type pin common pad 3112 includes a plurality of first pads, the first pads are respectively connected to the pins of the EMMC storage chip that are at the location A4, the location A5, the location B4, and the location B5, and a jumper element such as a resistor, a diode, or a transistor is mounted in the first jumper area 316 included in the second trace 42 connected to the second-type pin common pad 3112.

For example, the first storage chip is a second UFS storage chip, and the second storage chip is the EMMC storage chip. A pin that is of the second UFS storage chip and that is at a location B6 is a VCCQ2 pin (namely, a power pin), and a pin that is of the EMMC storage chip and that is at the location B6 is a DAT7 pin (namely, a signal pin). Therefore, the second-type pin common pad 3112 includes first pads connected to the pins that are of the second UFS storage chip and the EMMC storage chip and that are at the location B6.

In this case, when the second UFS storage chip is mounted on the circuit board 31, the second-type pin common pad 3112 is connected to the pin that is of the second UFS storage chip and that is at the location B6, and a jumper element such as a resistor, a diode, or a transistor is mounted in the first jumper area 316 included in the first trace 41 connected to the second-type pin common pad 3112; and when the EMMC storage chip is mounted on the circuit board 31, the second-type pin common pad 3112 is connected to the pin that is of the EMMC storage chip and that is at the location B6, and a jumper element such as a resistor, a diode, or a transistor is mounted in the first jumper area 316 included in the second trace 42 connected to the second-type pin common pad 3112.

In another manner, as shown in FIG. 9, the first trace 41 connected to the second-type pin common pad 3112 does not include the first jumper area 316, and the second trace 42 connected to the second-type pin common pad 3112 includes the first jumper area 316.

When the first storage chip is mounted on the circuit board 31, the third power unit in the first power module 341 powers on the first trace 41 connected to the second-type pin common pad 3112. To be specific, the third power unit converts, into a voltage required for working of the first storage chip, a voltage provided by the processor chip 33, and outputs the voltage to the first trace 41 connected to the second-type pin common pad 3112, so that the voltage obtained by the third power unit through conversion may be transmitted to the power pin of the first storage chip through the first trace 41 and the second-type pin common pad 3112. In addition, no jumper element is mounted in the first jumper area 316 included in the second trace 42 connected to the second-type pin common pad 3112, so that the second trace 42 connected to the second-type pin common pad 3112 is broken off.

Correspondingly, when the second storage chip is mounted on the circuit board 31, a jumper element is mounted in the first jumper area 316 included in the second trace 42 connected to the second-type pin common pad 3112, so that the second trace 42 connected to the second-type pin common pad 3112 is connected. In this way, a signal output by the signal pin of the processor chip 33 may be transmitted to the signal pin of the second storage chip through the second trace 42 and the second-type pin common pad 3112. In addition, the third power unit in the first power module 341 does not power on the first trace 41 connected to the second-type pin common pad 3112. To be specific, the third power unit does not convert, into the voltage required for working of the first storage chip, the voltage provided by the processor chip 33, or output the voltage required for working of the first storage chip to the first trace 41 connected to the second-type pin common pad 3112.

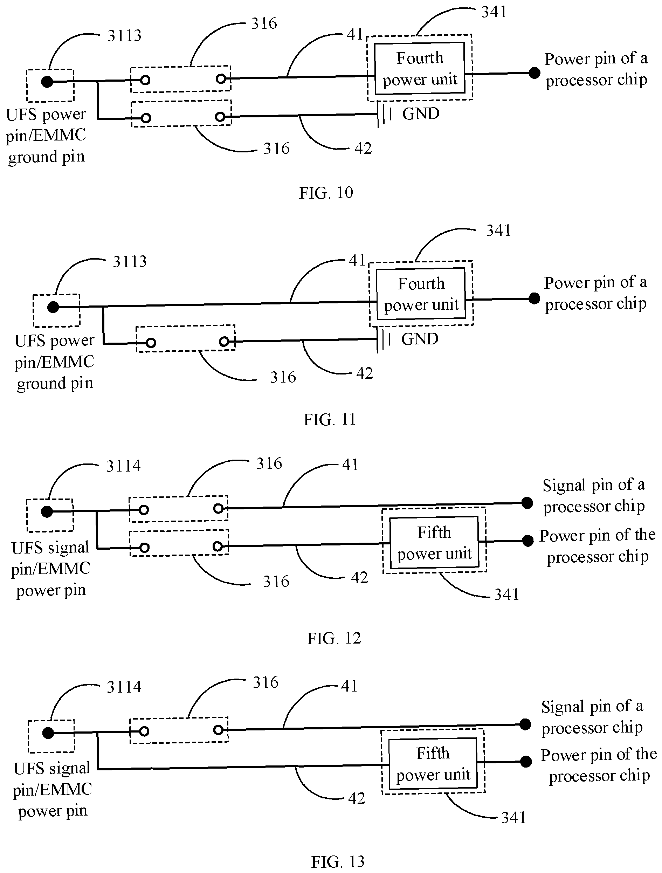

FIG. 10 is a schematic diagram of a connection relationship between a third-type pin common pad and each of a first trace and a second trace according to an embodiment of this application. FIG. 11 is a schematic diagram of another connection relationship between a third-type pin common pad and each of a first trace and a second trace according to an embodiment of this application. As shown in FIG. 10 and FIG. 11, a third-type pin common pad 3113 in a first-type pad 311 may be a pad at a UFS power pin/EMMC ground pin. To be specific, the third-type pin common pad 3113 is configured to be connected to a power pin of a first storage chip and a ground pin of a second storage chip. The third-type pin common pad 3113 is connected to two traces, the two traces connected to the third-type pin common pad 3113 are respectively a first trace 41 corresponding to a UFS storage chip and a second trace 42 corresponding to an EMMC storage chip, a first power module 341 may further include a fourth power unit, and the fourth power unit is connected to the third-type pin common pad 3113 through the first trace 41. In addition, the fourth power unit in the first power module 341 is further connected to a power pin of a processor chip 33, and the second trace 42 connected to the third-type pin common pad 3113 is further connected to a ground terminal GND of a circuit board 31.

In one manner, as shown in FIG. 10, the first trace 41 and the second trace 42 that are connected to the third-type pin common pad 3113 each include a first jumper area 316.

When the first storage chip is mounted on the circuit board 31, a jumper element is mounted in the first jumper area 316 included in the first trace 41 connected to the third-type pin common pad 3113, so that the first trace 41 connected to the third-type pin common pad 3113 is connected. In this way, a corresponding voltage is output to the first power module 341 by the power pin of the processor chip 33. After the fourth power unit in the first power module 341 converts the voltage into a voltage required for working of the first storage chip, the voltage obtained by the fourth power unit through conversion may be transmitted to the power pin of the first storage chip through the first trace 41 and the third-type pin common pad 3113. In addition, no jumper element is mounted in the first jumper area 316 included in the second trace 42 connected to the third-type pin common pad 3113, so that the second trace 42 connected to the third-type pin common pad 3113 is broken off.

Correspondingly, when the second storage chip is mounted on the circuit board 31, a jumper element is mounted in the first jumper area 316 included in the second trace 42 connected to the third-type pin common pad 3113, so that the second trace 42 connected to the third-type pin common pad 3113 is connected. In this way, the ground pin of the second storage chip may be connected to the ground terminal GND sequentially through the third-type pin common pad 3113 and the second trace 42. In addition, no jumper element is mounted in the first jumper area 316 included in the first trace 41 connected to the third-type pin common pad 3113, so that the first trace 41 connected to the third-type pin common pad 3113 is broken off.

For example, the first storage chip is a first UFS storage chip, and the second storage chip is the EMMC storage chip. A pin that is of the first UFS storage chip and that is at a location C4 is a VCCQ pin (namely, a power pin), a pin that is of the first UFS storage chip and that is at a location K8 is a VCC pin (namely, a power pin), and pins of the EMMC storage chip that are at the location C4 and the location K8 each are a VSS pin (namely, a ground pin). Therefore, the third-type pin common pad 3113 may include first pads connected to the pins that are of the first UFS storage chip and the EMMC storage chip and that are at the location C4 and the location K8.

In this case, when the first UFS storage chip is mounted on the circuit board 31, the third-type pin common pad 3113 includes a plurality of first pads, the first pads are respectively connected to the pins of the first UFS storage chip that are at the location C4 and the location K8, and a jumper element such as a resistor, a diode, or a transistor is mounted in the first jumper area 316 included in the first trace 41 connected to the third-type pin common pad 3113; and when the EMMC storage chip is mounted on the circuit board 31, the third-type pin common pad 3113 includes a plurality of first pads, the first pads are respectively connected to the pins of the EMMC storage chip that are at the location C4 and the location K8, and a jumper element such as a resistor, a diode, or a transistor is mounted in the first jumper area 316 included in the second trace 42 connected to the third-type pin common pad 3113.

For example, the first storage chip is a second UFS storage chip, and the second storage chip is the EMMC storage chip. A pin that is of the second UFS storage chip and that is at a location A6 is a VCCQ2 pin (namely, a power pin), a pin that is of the second UFS storage chip and that is at a location K8 is a VCC pin (namely, a power pin), and pins of the EMMC storage chip that are at the location A6 and the location K8 each are a VSS pin (namely, a ground pin). Therefore, the third-type pin common pad 3113 may include first pads connected to the pins that are of the second UFS storage chip and the EMMC storage chip and that are at the location A6 and the location K8.

In this case, when the second UFS storage chip is mounted on the circuit board 31, the third-type pin common pad 3113 includes a plurality of first pads, the first pads are respectively connected to the pins of the second UFS storage chip that are at the location A6 and the location K8, and a jumper element such as a resistor, a diode, or a transistor is mounted in the first jumper area 316 included in the first trace 41 connected to the third-type pin common pad 3113; and when the EMMC storage chip is mounted on the circuit board 31, the third-type pin common pad 3113 includes a plurality of first pads, the first pads are respectively connected to the pins of the EMMC storage chip that are at the location A6 and the location K8, and a jumper element such as a resistor, a diode, or a transistor is mounted in the first jumper area 316 included in the second trace 42 connected to the third-type pin common pad 3113.

In another manner, as shown in FIG. 11, the first trace 41 connected to the third-type pin common pad 3113 does not include the first jumper area 316, and the second trace 42 connected to the third-type pin common pad 3113 includes the first jumper area 316.

When the first storage chip is mounted on the circuit board 31, the fourth power unit in the first power module 341 powers on the first trace 41 connected to the third-type pin common pad 3113. To be specific, the fourth power unit converts, into a voltage required for working of the first storage chip, a voltage provided by the processor chip 33, and outputs the voltage to the first trace 41 connected to the third-type pin common pad 3113, so that the voltage obtained by the fourth power unit through conversion may be transmitted to the power pin of the first storage chip sequentially through the first trace 41 and the third-type pin common pad 3113. In addition, no jumper element is mounted in the first jumper area 316 included in the second trace 42 connected to the third-type pin common pad 3113, so that the second trace 42 connected to the third-type pin common pad 3113 is broken off.

Correspondingly, when the second storage chip is mounted on the circuit board 31, a jumper element is mounted in the first jumper area 316 included in the second trace 42 connected to the third-type pin common pad 3113, so that the second trace 42 connected to the third-type pin common pad 3113 is connected. In this way, the ground pin of the second storage chip may be connected to the ground terminal GND sequentially through the third-type pin common pad 3113 and the second trace 42. In addition, the fourth power unit in the first power module 341 does not power on the first trace 41 connected to the third-type pin common pad 3113. To be specific, the fourth power unit does not convert, into the voltage required for working of the first storage chip, the voltage provided by the processor chip 33, or output the voltage required for working of the first storage chip to the first trace 41 connected to the third-type pin common pad 3113.

Therefore, with reference to FIG. 9 and FIG. 11, it may be learned that the first trace 41 connected to the first power module 341 does not include the first jumper area 316, and the second trace 42 not connected to the first power module 341 includes the first jumper area 316. When the circuit board 31 is configured to carry the first storage chip and the first-type pad 311 is configured to be connected to the power pin of the first storage chip, the first power module 341 is configured to power on the first trace 41 connected to the first-type pad 311, and the first jumper area 316 included in the second trace 42 connected to the first-type pad 311 is not used to mount a jumper element; and when the circuit board 31 is configured to carry the second storage chip and the first-type pad 311 is configured to be connected to a signal pin or a ground pin of the second storage chip, the first jumper area 316 included in the second trace 42 connected to the first-type pad 311 is used to mount a jumper element, and the first power module 341 is configured to not power on the first trace 41 connected to the first-type pad 311.

FIG. 12 is a schematic diagram of a connection relationship between a fourth-type pin common pad and each of a first trace and a second trace according to an embodiment of this application. FIG. 13 is a schematic diagram of another connection relationship between a fourth-type pin common pad and each of a first trace and a second trace according to an embodiment of this application. As shown in FIG. 12 and FIG. 13, a fourth-type pin common pad 3114 in a first-type pad 311 may be a pad at a UFS signal pin/EMMC power pin. To be specific, the fourth-type pin common pad 3114 is configured to be connected to a signal pin of a first storage chip and a power pin of a second storage chip. The fourth-type pin common pad 3114 is connected to two traces, the two traces connected to the fourth-type pin common pad 3114 are respectively a first trace 41 corresponding to a UFS storage chip and a second trace 42 corresponding to an EMMC storage chip, a first power module 341 further includes a fifth power unit, and the fifth power unit is connected to the fourth-type pin common pad 3114 through the second trace 42. In addition, the fifth power unit in the first power module 341 is further connected to a power pin of a processor chip 33, and a signal pin of the processor chip 33 is further connected to the fourth-type pin common pad 3114 through the first trace 41.

In one manner, as shown in FIG. 12, the first trace 41 and the second trace 42 that are connected to the fourth-type pin common pad 3114 each include a first jumper area 316.

When the first storage chip is mounted on a circuit board 31, a jumper element such as a resistor, a diode, or a transistor is mounted in the first jumper area 316 included in the first trace 41 connected to the fourth-type pin common pad 3114, so that the first trace 41 connected to the fourth-type pin common pad 3114 is connected. In this way, a signal output by the signal pin of the processor chip 33 may be transmitted to a signal pin of the second storage chip through the first trace 41 and the fourth-type pin common pad 3114. In addition, no jumper element is mounted in the first jumper area 316 included in the second trace 42 connected to the fourth-type pin common pad 3114, so that the second trace 42 connected to the fourth-type pin common pad 3114 is broken off.

Correspondingly, when the second storage chip is mounted on the circuit board 31, a jumper element such as a resistor, a diode, or a transistor is mounted in the first jumper area 316 included in the second trace 42 connected to the first-type pin common pad 3114, so that the second trace 42 connected to the fourth-type pin common pad 3114 is connected. In this way, a corresponding voltage is output to the first power module 341 by the power pin of the processor chip 33. After the fifth power unit in the first power module 341 converts the voltage into a voltage required for working of the second storage chip, the voltage obtained by the fifth power unit through conversion may be transmitted to the power pin of the second storage chip through the second trace 42 and the fourth-type pin common pad 3114. In addition, no jumper element is mounted in the first jumper area 316 included in the first trace 41 connected to the fourth-type pin common pad 3114, so that the first trace 41 connected to the fourth-type pin common pad 3114 is broken off.

For example, the first storage chip is a first UFS storage chip, and the second storage chip is the EMMC storage chip. A case in which pins that are of the first UFS storage chip and the EMMC storage chip and that are at a same location are connected to the fourth-type pin common pad 3114 does not exist. In other words, the fourth-type pin common pad 3114 may not exist on the circuit board 31. Alternatively, for example, the first storage chip is a second UFS storage chip, and the second storage chip is the EMMC storage chip. A case in which pins that are of the second UFS storage chip and the EMMC storage chip and that are at a same location are connected to the fourth-type pin common pad 3114 does not exist either.

In another manner, as shown in FIG. 13, the first trace 41 connected to the fourth-type pin common pad 3114 includes the first jumper area 316, and the second trace 42 connected to the fourth-type pin common pad 3114 does not include the first jumper area 316.

When the first storage chip is mounted on a circuit board 31, a jumper element is mounted in the first jumper area 316 included in the first trace 41 connected to the fourth-type pin common pad 3114, so that the first trace 41 connected to the fourth-type pin common pad 3114 is connected. In this way, a signal output by the signal pin of the processor chip 33 may be transmitted to the signal pin of the first storage chip through the first trace 41 and the fourth-type pin common pad 3114. In addition, the fifth power unit in the first power module 341 does not power on the second trace 42 connected to the fourth-type pin common pad 3114. To be specific, the fifth power unit does not convert, into the voltage required for working of the second storage chip, the voltage provided by the processor chip 33, or output the voltage required for working of the second storage chip to the second trace 42 connected to the fourth-type pin common pad 3114.

Correspondingly, when the second storage chip is mounted on the circuit board 31, the fifth power unit in the first power module 341 powers on the second trace 42 connected to the fourth-type pin common pad 3114. To be specific, the fifth power unit converts, into a voltage required for working of the second storage chip, a voltage provided by the processor chip 33, and outputs the voltage to the second trace 42 connected to the fourth-type pin common pad 3114, so that the voltage obtained by the fifth power unit through conversion may be transmitted to the power pin of the second storage chip through the second trace 42 and the fourth-type pin common pad 3114. In addition, no jumper element is mounted in the first jumper area 316 included in the first trace 41 connected to the fourth-type pin common pad 3114, so that the first trace 41 connected to the fourth-type pin common pad 3114 is broken off.

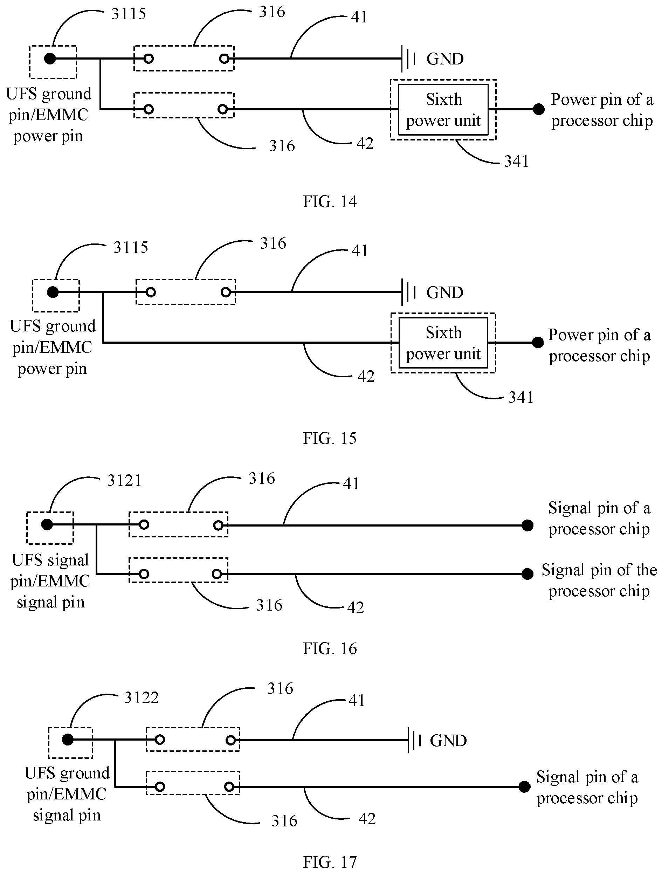

FIG. 14 is a schematic diagram of a connection relationship between a fifth-type pin common pad and each of a first trace and a second trace according to an embodiment of this application. FIG. 15 is a schematic diagram of another connection relationship between a fifth-type pin common pad and each of a first trace and a second trace according to an embodiment of this application. As shown in FIG. 14 and FIG. 15, a fifth-type pin common pad 3115 in a first-type pad 311 may be a pad at a UFS ground pin/EMMC power pin. To be specific, the fifth-type pin common pad 3115 is configured to be connected to a ground pin of a first storage chip and a power pin of a second storage chip. The fifth-type pin common pad 3115 is connected to two traces, the two traces connected to the fifth-type pin common pad 3115 are respectively a first trace 41 corresponding to a UFS storage chip and a second trace 42 corresponding to an EMMC storage chip, a first power module 341 may further include a sixth power unit, and the sixth power unit is connected to the fifth-type pin common pad 3115 through the second trace 42. In addition, the sixth power unit in the first power module 341 is further connected to a power pin of a processor chip 33, and the first trace 41 connected to the fifth-type pin common pad 3115 is further connected to a ground terminal GND of a circuit board 31.

In one manner, as shown in FIG. 14, the first trace 41 and the second trace 42 that are connected to the fifth-type pin common pad 3115 each include a first jumper area 316.

When the first storage chip is mounted on the circuit board 31, a jumper element is mounted in the first jumper area 316 included in the first trace 41 connected to the fifth-type pin common pad 3115, so that the first trace 41 connected to the fifth-type pin common pad 3115 is connected. In this way, the ground pin of the first storage chip may be connected to the ground terminal GND sequentially through the fifth-type pin common pad 3115 and the first trace 41. In addition, no jumper element is mounted in the first jumper area 316 included in the second trace 42 connected to the fifth-type pin common pad 3115, so that the second trace 42 connected to the fifth-type pin common pad 3115 is broken off.

Correspondingly, when the second storage chip is mounted on the circuit board 31, a jumper element is mounted in the first jumper area 316 included in the second trace 42 connected to the fifth-type pin common pad 3115, so that the second trace 42 connected to the fifth-type pin common pad 3115 is connected. In this way, a corresponding voltage is output to the first power module 341 by the power pin of the processor chip 33. After the sixth power unit in the first power module 341 converts the voltage into a voltage required for working of the second storage chip, the voltage obtained by the sixth power unit through conversion may be transmitted to the power pin of the second storage chip through the second trace 42 and the fifth-type pin common pad 3115. In addition, no jumper element is mounted in the first jumper area 316 included in the first trace 41 connected to the fifth-type pin common pad 3115, so that the first trace 41 connected to the fifth-type pin common pad 3115 is broken off.

For example, the first storage chip is a first UFS storage chip, and the second storage chip is the EMMC storage chip. Pins of the first UFS storage chip that are at a location M4, a location N4, and a location P5 each are a VSS pin (namely, a ground pin), and pins of the EMMC storage chip that are at the location M4, the location N4, and the location P5 each are a VCCQ pin (namely, a power pin). Therefore, the fifth-type pin common pad 3115 may include first pads connected to the pins that are of the first UFS storage chip and the EMMC storage chip and that are at the location M4, the location N4, and the location P5.

In this case, when the first UFS storage chip is mounted on the circuit board 31, the fifth-type pin common pad 3115 includes a plurality of first pads, the first pads are respectively connected to the pins of the first UFS storage chip that are at the location M4, the location N4, and the location P5, and a jumper element such as a resistor, a diode, or a transistor is mounted in the first jumper area 316 included in the first trace 41 connected to the fifth-type pin common pad 3115; and when the EMMC storage chip is mounted on the circuit board 31, the fifth-type pin common pad 3115 includes a plurality of first pads, the first pads are respectively connected to the pins of the EMMC storage chip that are at the location M4, the location N4, and the location P5, and a jumper element such as a resistor, a diode, or a transistor is mounted in the first jumper area 316 included in the second trace 42 connected to the fifth-type pin common pad 3115.

For example, the first storage chip is a second UFS storage chip, and the second storage chip is the EMMC storage chip. Pins of the second UFS storage chip that are at a location M4, a location N4, and a location P5 each are a VSS pin (namely, a ground pin), and pins of the EMMC storage chip that are at the location M4, the location N4, and the location P5 each are a VCCQ pin (namely, a power pin). Therefore, the fifth-type pin common pad 3115 may include first pads connected to the pins that are of the second UFS storage chip and the EMMC storage chip and that are at the location M4, the location N4, and the location P5.

In this case, when the second UFS storage chip is mounted on the circuit board 31, the fifth-type pin common pad 3115 includes a plurality of first pads, the first pads are respectively connected to the pins of the second UFS storage chip that are at the location M4, the location N4, and the location P5, and a jumper element such as a resistor, a diode, or a transistor is mounted in the first jumper area 316 included in the first trace 41 connected to the fifth-type pin common pad 3115; and when the EMMC storage chip is mounted on the circuit board 31, the fifth-type pin common pad 3115 includes a plurality of first pads, the first pads are respectively connected to the pins of the EMMC storage chip that are at the location M4, the location N4, and the location P5, and a jumper element such as a resistor, a diode, or a transistor is mounted in the first jumper area 316 included in the second trace 42 connected to the fifth-type pin common pad 3115.

In another manner, as shown in FIG. 15, the first trace 41 connected to the fifth-type pin common pad 3115 includes the first jumper area 316, and the second trace 42 connected to the fifth-type pin common pad 3115 does not include the first jumper area 316.

When the first storage chip is mounted on the circuit board 31, a jumper element is mounted in the first jumper area 316 included in the first trace 41 connected to the fifth-type pin common pad 3115, so that the first trace 41 connected to the fifth-type pin common pad 3115 is connected. In this way, the ground pin of the first storage chip may be connected to the ground terminal GND sequentially through the fifth-type pin common pad 3115 and the first trace 41. In addition, the sixth power unit in the first power module 341 does not power on the second trace 42 connected to the fifth-type pin common pad 3115. To be specific, the sixth power unit does not convert, into the voltage required for working of the second storage chip, the voltage provided by the processor chip 33, or output the voltage required for working of the second storage chip to the second trace 42 connected to the fifth-type pin common pad 3115.

Correspondingly, when the second storage chip is mounted on the circuit board 31, the sixth power unit in the first power module 341 powers on the second trace 42 connected to the fifth-type pin common pad 3115. To be specific, the sixth power unit converts, into a voltage required for working of the second storage chip, a voltage provided by the processor chip 33, and outputs the voltage to the second trace 42 connected to the fifth-type pin common pad 3115, so that the voltage obtained by the sixth power unit through conversion may be transmitted to the power pin of the second storage chip sequentially through the second trace 42 and the fifth-type pin common pad 3115. In addition, no jumper element is mounted in the first jumper area 316 included in the first trace 41 connected to the fifth-type pin common pad 3115, so that the first trace 41 connected to the fifth-type pin common pad 3115 is broken off.

Therefore, with reference to FIG. 13 and FIG. 15, it may be learned that the second trace 42 connected to the first power module 341 does not include the first jumper area 316, and the first trace 41 not connected to the first power module 341 includes the first jumper area 316. When the circuit board 31 is configured to carry the first storage chip and the first-type pad 311 is configured to be connected to a signal pin or a ground pin of the first storage chip, the first jumper area 316 included in the first trace 41 connected to the first-type pad 311 is used to mount a jumper element, and the first power module 341 is configured to not power on the second trace 42 connected to the first-type pad 311; and when the circuit board 31 is configured to carry the second storage chip and the first-type pad 311 is configured to be connected to the power pin of the second storage chip, the first power module 341 is configured to power on the second trace 42 connected to the first-type pad 311, and the first jumper area 316 included in the first trace 41 connected to the first-type pad 311 is not used to mount a jumper element.

In conclusion, with reference to FIG. 6, FIG. 8, FIG. 10, FIG. 12, and FIG. 14, the first trace 41 and the second trace 42 that are connected to the first-type pad 311 each include the first jumper area 316. When the circuit board 31 is configured to carry the first storage chip, the first jumper area 316 included in the first trace 41 connected to the first-type pad 311 is used to mount a jumper element, and the first jumper area 316 included in the second trace 42 connected to the first-type pad 311 is not used to mount a jumper element; and when the circuit board 31 is configured to carry the second storage chip, the first jumper area 316 included in the second trace 42 connected to the first-type pad 311 is used to mount a jumper element, and the first jumper area 316 included in the first trace 41 connected to the first-type pad 311 is not used to mount a jumper element.

In conclusion, as shown in FIG. 7, FIG. 9, FIG. 11, FIG. 13, and FIG. 15, the first trace 41 and/or the second trace 42 that are/is connected to the first power module 341 do/does not include the first jumper area 316, and the first trace 41 or the second trace 42 that is not connected to the first power module 341 include the first jumper area 316. When the circuit board 31 is configured to carry the first storage chip and the first-type pad 311 is configured to be connected to the power pin of the first storage chip, the first power module 341 is configured to power on the first trace 41 connected to the first-type pad 311; and/or when the circuit board 31 is configured to carry the second storage chip and the first-type pad 311 is configured to be connected to the power pin of the second storage chip, the first power module 341 is configured to power on the second trace 42 connected to the first-type pad 311.

It should be noted that the first power unit, the second power unit, the third power unit, the fourth power unit, the fifth power unit, and the sixth power unit may be a same functional unit used for voltage conversion in the first power module 341, or may be a plurality of different functional units used for voltage conversion in the first power module 341. In addition, the first power unit, the second power unit, the third power unit, the fourth power unit, the fifth power unit, and the sixth power unit may be integrated into a same component, for example, are all integrated into a power management chip 34; or the first power unit, the second power unit, the third power unit, the fourth power unit, the fifth power unit, and the sixth power unit may be disposed independently. This is not limited in this embodiment of this application.

In some embodiments, the plurality of first pads include a second-type pad 312, and the second-type pad 312 is configured to be connected to the signal pin of the first storage chip and the signal pin of the second storage chip, or is configured to be connected to the signal pin of the first storage chip and the ground pin of the second storage chip, or is configured to be connected to the ground pin of the first storage chip and the signal pin of the second storage chip. In addition, the first trace 41 and the second trace 42 that are connected to the second-type pad 312 each include the first jumper area 316; when the circuit board 31 is configured to carry the first storage chip, the first jumper area 316 included in the first trace 41 connected to at least some second-type pads 312 is used to mount a jumper element; and when the circuit board 31 is configured to carry the second storage chip, the first jumper area 316 included in the second trace 42 connected to the second-type pad 312 is used to mount a jumper element.

FIG. 16 is a schematic diagram of a connection relationship between a sixth-type pin common pad and each of a first trace and a second trace according to an embodiment of this application. As shown in FIG. 16, a sixth-type pin common pad 3121 in a second-type pad 312 may be a pad at a UFS signal pin/EMMC signal pin. To be specific, the sixth-type pin common pad 3121 is configured to be connected to a signal pin of a first storage chip and a signal pin of a second storage chip. The sixth-type pin common pad 3121 is connected to two traces, and the two traces connected to the sixth-type pin common pad 3121 are respectively a first trace 41 corresponding to a UFS storage chip and a second trace 42 corresponding to an EMMC storage chip. In addition, one signal pin of a processor chip 33 is connected to the sixth-type pin common pad 3121 through the first trace 41, and the other signal pin of the processor chip 33 is further connected to the sixth-type pin common pad 3121 through the second trace 42.

The first trace 41 and the second trace 42 that are connected to the sixth-type pin common pad 3121 each include a first jumper area 316.

When the first storage chip is mounted on a circuit board 31, a jumper element such as a resistor, a diode, or a transistor is mounted in the first jumper area 316 included in the first trace 41 connected to the sixth-type pin common pad 3121, so that the first trace 41 connected to the sixth-type pin common pad 3121 is connected. In this way, a signal output by a signal pin that is of the processor chip 33 and that corresponds to the first storage chip may be transmitted to the signal pin of the first storage chip sequentially through the first trace 41 and the sixth-type pin common pad 3121. In addition, no jumper element is mounted in the first jumper area 316 included in the second trace 42 connected to the sixth-type pin common pad 3121, so that the second trace 42 connected to the sixth-type pin common pad 3121 is broken off.

Correspondingly, when the second storage chip is mounted on the circuit board 31, a jumper element such as a resistor, a diode, or a transistor is mounted in the first jumper area 316 included in the second trace 42 connected to the sixth-type pin common pad 3121, so that the second trace 42 connected to the sixth-type pin common pad 3121 is connected. In this way, a signal output by a signal pin that is of the processor chip 33 and that corresponds to the second storage chip may be transmitted to the signal pin of the second storage chip sequentially through the second trace 42 and the sixth-type pin common pad 3121. In addition, no jumper element is mounted in the first jumper area 316 included in the first trace 41 connected to the sixth-type pin common pad 3121, so that the first trace 41 connected to the sixth-type pin common pad 3121 is broken off.

For example, the first storage chip is a first UFS storage chip, and the second storage chip is the EMMC storage chip. A case in which pins that are of the first UFS storage chip and the EMMC storage chip and that are at a same location are connected to the sixth-type pin common pad 3121 does not exist. In other words, the sixth-type pin common pad 3121 may not exist on the circuit board 31. Alternatively, for example, the first storage chip is a second UFS storage chip, and the second storage chip is the EMMC storage chip. A case in which pins that are of the second UFS storage chip and the EMMC storage chip and that are at a same location are connected to the sixth-type pin common pad 3121 does not exist either.

FIG. 17 is a schematic diagram of a connection relationship between a seventh-type pin common pad and each of a first trace and a second trace according to an embodiment of this application. As shown in FIG. 17, a seventh-type pin common pad 3122 in a second-type pad 312 may be a pad at a UFS ground pin/EMMC signal pin. To be specific, the seventh-type pin common pad 3122 is configured to be connected to a ground pin of a first storage chip and a signal pin of a second storage chip. The seventh-type pin common pad 3122 is connected to two traces, and the two traces connected to the seventh-type pin common pad 3122 are respectively a first trace 41 corresponding to a UFS storage chip and a second trace 42 corresponding to an EMMC storage chip. In addition, the first trace 41 connected to the seventh-type pin common pad 3122 is further connected to a ground terminal GND of a circuit board 31, and a signal pin of a processor chip 33 is connected to the seventh-type pin common pad 3122 through the second trace 42.

The first trace 41 and the second trace 42 that are connected to the seventh-type pin common pad 3122 each include a first jumper area 316.

When the first storage chip is mounted on the circuit board 31, a jumper element is mounted or no jumper element is mounted in the first jumper area 316 included in the first trace 41 connected to the seventh-type pin common pad 3122. In addition, no jumper element is mounted in the first jumper area 316 included in the second trace 42 connected to the seventh-type pin common pad 3122.

Correspondingly, when the second storage chip is mounted on the circuit board 31, a jumper element is mounted in the first jumper area 316 included in the second trace 42 connected to the seventh-type pin common pad 3122, so that the second trace 42 connected to the seventh-type pin common pad 3122 is connected. In this way, a signal output by the signal pin of the processor chip 33 may be transmitted to the signal pin of the second storage chip through the second trace 42 and the seventh-type pin common pad 3122. In addition, no jumper element is mounted in the first jumper area 316 included in the first trace 41 connected to the seventh-type pin common pad 3122, so that the first trace 41 connected to the seventh-type pin common pad 3122 is broken off.

For example, the first storage chip is a first UFS storage chip, and the second storage chip is the EMMC storage chip. A pin that is of the first UFS storage chip and that is at a location A3 is a VDDiQ pin (namely, a ground pin), and a pin that is of the EMMC storage chip and that is at the location A3 is a DAT0 pin (namely, a signal pin). Pins of the first UFS storage chip that are at a location B2, a location H5, a location K5, and a location M5 each are a VSS pin (namely, a ground pin), a pin that is of the EMMC storage chip and that is at the location B2 is a DAT3 pin (namely, a signal pin), a pin that is of the EMMC storage chip and that is at the location H5 is a DS pin (namely, a signal pin), a pin that is of the EMMC storage chip and that is at the location K5 is an RST_n pin (namely, a signal pin), and a pin that is of the EMMC storage chip and that is at the location M5 is a CMD pin (namely, a signal pin). Therefore, the seventh-type pin common pad 3122 may include first pads connected to the pins that are of the first UFS storage chip and the EMMC storage chip and that are at the location A3, the location B2, the location H5, the location K5, and the location M5.

Therefore, the seventh-type pin common pad 3122 includes first pads connected to the pins that are of the first UFS storage chip and the EMMC storage chip and that are at the location A3. When the first UFS storage chip is mounted on the circuit board 31, a capacitor is mounted in the first jumper area 316 included in the first trace 41 correspondingly connected to the pin that is of the first UFS storage chip and that is at the location A3, or no jumper element is mounted. If no jumper element is mounted in the first jumper area 316 included in the first trace 41 correspondingly connected to the pin that is of the first UFS storage chip and that is at the location A3, the first trace 41 correspondingly connected to the pin that is of the first UFS storage chip and that is at the location A3 may be in an open-circuit state. When the EMMC storage chip is mounted on the circuit board 31, a jumper element such as a resistor, a diode, or a transistor is mounted in the first jumper area 316 included in the second trace 42 correspondingly connected to the pin that is of the EMMC storage chip and that is at the location A3.

In addition, the seventh-type pin common pad 3122 includes first pads connected to the pins that are of the first UFS storage chip and the EMMC storage chip and that are at the location B2, the location H5, the location K5, and the location M5. When the first UFS storage chip is mounted on the circuit board 31, a jumper element such as a resistor, a diode, or a transistor is mounted in the first jumper area 316 included in the first trace 41 correspondingly connected to the pins of the first UFS storage chip that are at the location B2, the location H5, the location K5, and the location M5; and when the EMMC storage chip is mounted on the circuit board 31, a jumper element such as a resistor, a diode, or a transistor is mounted in the first jumper area 316 included in the second trace 42 correspondingly connected to the pins of the EMMC storage chip that are at the location B2, the location H5, the location K5, and the location M5.

It should be noted that, locations of a plurality of first pads included in the seventh-type pin common pad 3122, functions of connected pins, whether a jumper element is mounted in each first jumper area 316, and a type of a jumper element when the jumper element is mounted in the first jumper area 316 when the first storage chip is a second UFS storage chip are correspondingly the same as locations of a plurality of first pads included in the seventh-type pin common pad 3122, functions of connected pins, whether a jumper element is mounted in each first jumper area 316, and a type of a jumper element when the jumper element is mounted in the first jumper area 316 when the first storage chip is the first UFS storage chip. Details are not described herein again.

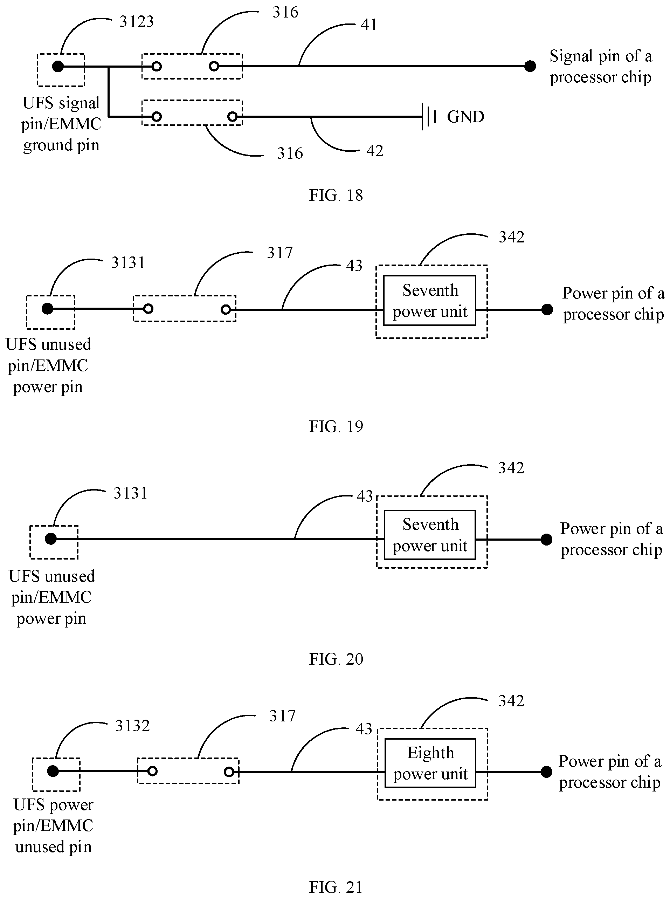

FIG. 18 is a schematic diagram of a connection relationship between an eighth-type pin common pad and each of a first trace and a second trace according to an embodiment of this application. As shown in FIG. 18, an eighth-type pin common pad 3123 in a second-type pad 312 may be a pad at a UFS signal pin/EMMC ground pin. To be specific, the eighth-type pin common pad 3123 is configured to be connected to a signal pin of a first storage chip and a ground pin of a second storage chip. The eighth-type pin common pad 3123 is connected to two traces, and the two traces connected to the eighth-type pin common pad 3123 are respectively a first trace 41 corresponding to a UFS storage chip and a second trace 42 corresponding to an EMMC storage chip. In addition, a signal pin of a processor chip 33 is connected to the eighth-type pin common pad 3123 through the first trace 41, and the second trace 42 connected to the eighth-type pin common pad 3123 is further connected to a ground terminal GND of a circuit board 31.

The first trace 41 and the second trace 42 that are connected to the eighth-type pin common pad 3123 each include a first jumper area 316.

When the first storage chip is mounted on the circuit board 31, a jumper element such as a resistor, a capacitor, a diode, or a transistor is mounted in the first jumper area 316 included in the first trace 41 connected to the eighth-type pin common pad 3123, so that the first trace 41 connected to the eighth-type pin common pad 3123 is connected. In this way, a signal output by the signal pin of the processor chip 33 may be transmitted to the signal pin of the first storage chip through the first trace 41 and the eighth-type pin common pad 3123. In addition, no jumper element is mounted in the first jumper area 316 included in the second trace 42 connected to the eighth-type pin common pad 3123, so that the second trace 42 connected to the eighth-type pin common pad 3123 is broken off.

Correspondingly, when the second storage chip is mounted on the circuit board 31, a jumper element such as a resistor, a capacitor, a diode, or a transistor is mounted in the first jumper area 316 included in the second trace 42 connected to the eighth-type pin common pad 3123, so that the second trace 42 connected to the eighth-type pin common pad 3123 is connected. In this way, the ground pin of the second storage chip may be connected to the ground terminal GND sequentially through the eighth-type pin common pad 3123 and the second trace 42. In addition, no jumper element is mounted in the first jumper area 316 included in the first trace 41 connected to the eighth-type pin common pad 3123, so that the first trace 41 connected to the eighth-type pin common pad 3123 is broken off.

For example, the first storage chip is a first UFS storage chip, and the second storage chip is the EMMC storage chip. A case in which pins that are of the first UFS storage chip and the EMMC storage chip and that are at a same location are connected to the eighth-type pin common pad 3123 does not exist. In other words, the eighth-type pin common pad 3123 may not exist on the circuit board 31. Alternatively, for example, the first storage chip is a second UFS storage chip, and the second storage chip is the EMMC storage chip. A case in which pins that are of the second UFS storage chip and the EMMC storage chip and that are at a same location are connected to the eighth-type pin common pad 3123 does not exist either.

In some embodiments, as shown in FIG. 5, the first pad group further includes a plurality of second pads, each second pad is connected to one trace, one trace connected to the second pad is a third trace, the third trace connected to some second pads includes a second jumper area 317, the third trace is broken off in the second jumper area 317, and the third trace connected to the other second pads does not include the second jumper area 317. When the circuit board 31 is configured to carry the first storage chip or the second storage chip, the second jumper area 317 included in the third trace connected to the at least some second pads is used to mount a jumper element.

It should be noted that the second jumper area 317 may include two pads with a specific spacing, so that a trace is disconnected in the second jumper area 317.

The plurality of second pads include a third-type pad 313, and the third-type pad 313 is configured to be connected to a power pin of the first storage chip and an unused pin of the second storage chip, or is configured to be connected to an unused pin of the first storage chip and a power pin of the second storage chip. In addition, the circuit board 31 is further configured to carry a second power module, and the second power module is configured to be connected to the third-type pad 313 through the third trace.

FIG. 19 is a schematic diagram of a connection relationship between a ninth-type pin common pad and a third trace according to an embodiment of this application. FIG. 20 is a schematic diagram of another connection relationship between a ninth-type pin common pad and a third trace according to an embodiment of this application. As shown in FIG. 19 and FIG. 20, a ninth-type pin common pad 3131 in a third-type pad 313 may be a pad at a UFS unused pin/EMMC power pin. To be specific, the ninth-type pin common pad 3131 is configured to be connected to an unused pin of a first storage chip and a power pin of a second storage chip. The ninth-type pin common pad 3131 is connected to one trace, and the trace connected to the ninth-type pin common pad 3131 is a third trace 43 corresponding to a UFS storage chip and an EMMC storage chip. A second power module 342 may include a seventh power unit, the seventh power unit is connected to the ninth-type pin common pad 3131 through the third trace 43, and the seventh power unit is further connected to a power pin of a processor chip 33.

In one manner, as shown in FIG. 19, the third trace 43 connected to the ninth-type pin common pad 3131 includes a second jumper area 317.

When the first storage chip is mounted on a circuit board 31, no jumper element is mounted in the second jumper area 317 included in the third trace 43 connected to the ninth-type pin common pad 3131, so that the third trace 43 connected to the ninth-type pin common pad 3131 is in an open-circuit state. When the second storage chip is mounted on the circuit board 31, a jumper element is mounted in the second jumper area 317 included in the third trace 43 connected to the ninth-type pin common pad 3131, so that the third trace 43 connected to the ninth-type pin common pad 3131 is connected. In this way, a corresponding voltage is output to the second power module 342 by the power pin of the processor chip 33. After the seventh power unit in the second power module 342 converts the voltage into a voltage required for working of the second storage chip, the voltage obtained by the seventh power unit through conversion may be transmitted to the power pin of the second storage chip through the third trace 43 and the ninth-type pin common pad 3131.

In another manner, as shown in FIG. 20, the third trace 43 connected to the ninth-type pin common pad 3131 does not include a second jumper area 317. In other words, the third trace 43 on the circuit board 31 is directly connected when being manufactured, and the second jumper area 317 does not exist.

When the first storage chip is mounted on the circuit board 31, the seventh power unit in the second power module 342 does not power on the third trace 43 connected to the ninth-type pin common pad 3131. When the second storage chip is mounted on the circuit board 31, the seventh power unit in the second power module 342 powers on the third trace 43 connected to the ninth-type pin common pad 3131. To be specific, the seventh power unit converts, into a voltage required for working of the second storage chip, a voltage provided by the processor chip 33, and outputs the voltage to the third trace 43 connected to the ninth-type pin common pad 3131, so that the voltage obtained by the seventh power unit through conversion may be transmitted to the power pin of the second storage chip sequentially through the third trace 43 and the ninth-type pin common pad 3131.

For example, the first storage chip is a first UFS storage chip, and the second storage chip is the EMMC storage chip. A pin that is of the first UFS storage chip and that is at a location C6 is an NU pin (namely, an unused pin), and a pin that is of the EMMC storage chip and that is at the location C6 is a VCCQ pin (namely, a power pin); a pin that is of the first UFS storage chip and that is at a location E6 is a VSF pin (a debug pin, which is also an unused pin), and a pin that is of the EMMC storage chip and that is at the location E6 is a VCC pin (namely, a power pin); a pin that is of the first UFS storage chip and that is at a location J10 is a VSF pin (namely, an unused pin), and a pin that is of the EMMC storage chip and that is at the location J10 is a VCC pin (namely, a power pin); a pin that is of the first UFS storage chip and that is at a location K9 is an NU pin (namely, an unused pin), and a pin that is of the EMMC storage chip and that is at the location K9 is a VCC pin (namely, a power pin); and a pin that is of the first UFS storage chip and that is at a location P3 is an NU pin (namely, an unused pin), and a pin that is of the EMMC storage chip and that is at the location P3 is a VCCQ pin (namely, a power pin). Therefore, the ninth-type pin common pad 3131 includes second pads connected to the pins that are of the first UFS storage chip and the EMMC storage chip and that are at the location C6, the location E6, the location J10, the location K9, and the location P3.

In this case, the third trace 43 connected to second pads respectively connected to the pins that are of the first UFS storage chip and the EMMC storage chip and that are at the location C6, the location K9, and the location P3 in the ninth-type pin common pad 3131 does not include the second jumper area 317, so that when the first UFS storage chip or the EMMC storage chip is mounted on the circuit board 31, the third trace 43 correspondingly connected to the pins at the location C6, the location K9, and the location P3 is in a short-circuit state.

Alternatively, the third trace 43 connected to a plurality of second pads respectively connected to pins that are of the first UFS storage chip and the EMMC storage chip and that are at the location C6, the location K9, and the location P3 in the ninth-type pin common pad 3131 includes the second jumper area 317. When the first UFS storage chip is mounted on the circuit board 31, no jumper element is mounted in the second jumper area 317 included in the third trace 43 correspondingly connected to the pins at the location C6, the location K9, and the location P3, so that the third trace 43 is in an open-circuit state; and when the EMMC storage chip is mounted on the circuit board 31, a jumper element such as a resistor, a diode, or a transistor is mounted in the second jumper area 317 included in the third trace 43 correspondingly connected to the pins at the location C6, the location K9, and the location P3.

In addition, the third trace 43 connected to second pads respectively connected to the pins that are of the first UFS storage chip and the EMMC storage chip and that are at the location E6 and the location J10 in the ninth-type pin common pad 3131 includes the second jumper area 317. When the first UFS storage chip is mounted on the circuit board 31, no jumper element is mounted in the second jumper area 317 included in the third trace 43 correspondingly connected to the pins at the location E6 and the location J10, so that the third trace 43 is in an open-circuit state; and when the EMMC storage chip is mounted on the circuit board 31, a jumper element such as a resistor, a diode, or a transistor is mounted in the second jumper area 317 included in the third trace 43 correspondingly connected to the pins at the location E6 and the location J10.

For example, the first storage chip is a second UFS storage chip, and the second storage chip is the EMMC storage chip. A pin that is of the second UFS storage chip and that is at a location E6 is a VSF pin (namely, an unused pin), and a pin that is of the EMMC storage chip and that is at the location E6 is a VCC pin (namely, a power pin); a pin that is of the second UFS storage chip and that is at a location F5 is an NU pin (namely, an unused pin), and a pin that is of the EMMC storage chip and that is at the location F5 is a VCC pin (namely, a power pin); a pin that is of the second UFS storage chip and that is at a location J10 is a VSF pin (namely, an unused pin), and a pin that is of the EMMC storage chip and that is at the location J10 is a VCC pin (namely, a power pin); a pin that is of the second UFS storage chip and that is at a location K9 is an NU pin (namely, an unused pin), and a pin that is of the EMMC storage chip and that is at the location K9 is a VCC pin (namely, a power pin); and a pin that is of the second UFS storage chip and that is at a location P3 is an NU pin (namely, an unused pin), and a pin that is of the EMMC storage chip and that is at the location P3 is a VCCQ pin (namely, a power pin). Therefore, the ninth-type pin common pad 3131 includes second pads connected to the pins that are of the second UFS storage chip and the EMMC storage chip and that are at the location E6, the location F5, the location J10, the location K9, and the location P3.

In this case, the third trace 43 connected to a plurality of second pads respectively connected to the pins that are of the second UFS storage chip and the EMMC storage chip and that are at the location F5, the location K9, and the location P3 in the ninth-type pin common pad 3131 does not include the second jumper area 317, so that when the second UFS storage chip or the EMMC storage chip is mounted on the circuit board 31, the third trace 43 correspondingly connected to the pins at the location F5, the location K9, and the location P3 is in a short-circuit state.

Alternatively, the third trace 43 connected to a plurality of second pads respectively connected to pins that are of the second UFS storage chip and the EMMC storage chip and that are at the location F5, the location K9, and the location P3 in the ninth-type pin common pad 3131 includes the second jumper area 317. When the second UFS storage chip is mounted on the circuit board 31, no jumper element is mounted in the second jumper area 317 included in the third trace 43 correspondingly connected to the pins at the location F5, the location K9, and the location P3, so that the third trace 43 is in an open-circuit state; and when the EMMC storage chip is mounted on the circuit board 31, a jumper element such as a resistor, a diode, or a transistor is mounted in the second jumper area 317 included in the third trace 43 correspondingly connected to the pins at the location F5, the location K9, and the location P3.

In addition, the third trace 43 connected to second pads respectively connected to the pins of the second UFS storage chip that are at the location E6 and the location J10 in the ninth-type pin common pad 3131 includes the second jumper area 317. When the second UFS storage chip is mounted on the circuit board 31, no jumper element is mounted in the second jumper area 317 included in the third trace 43 correspondingly connected to the pins at the location E6 and the location J10, so that the third trace 43 is in an open-circuit state; and when the EMMC storage chip is mounted on the circuit board 31, a jumper element such as a resistor, a diode, or a transistor is mounted in the second jumper area 317 included in the third trace 43 correspondingly connected to the pins at the location E6 and the location J10.

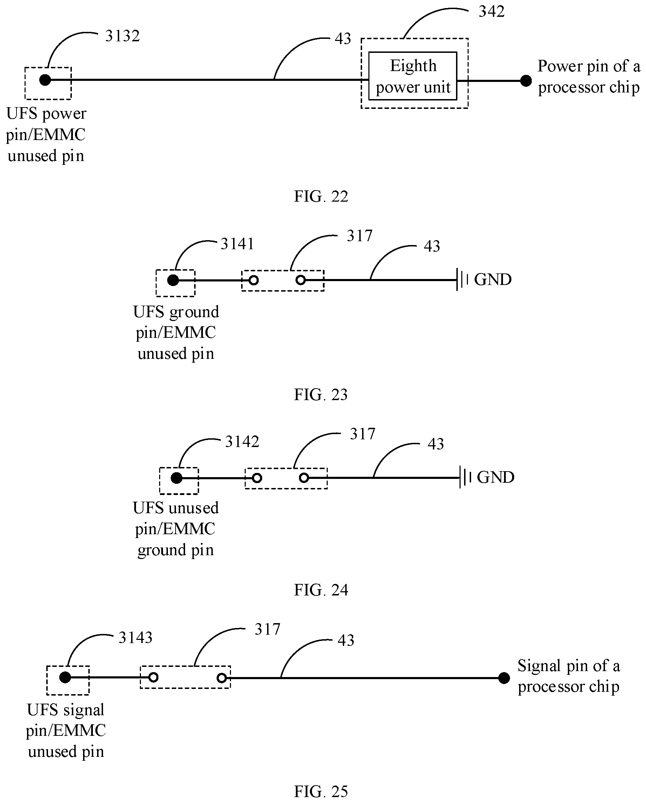

FIG. 21 is a schematic diagram of a connection relationship between a tenth-type pin common pad and a third trace according to an embodiment of this application. FIG. 22 is a schematic diagram of another connection relationship between a tenth-type pin common pad and a third trace according to an embodiment of this application. As shown in FIG. 21 and FIG. 22, a tenth-type pin common pad 3132 in a third-type pad 313 may be a pad at a UFS power pin/EMMC unused pin. To be specific, the tenth-type pin common pad 3132 is configured to be connected to a power pin of a first storage chip and an unused pin of a second storage chip. The tenth-type pin common pad 3132 is connected to one trace, and the trace connected to the tenth-type pin common pad 3132 is a third trace 43 corresponding to a UFS storage chip and an EMMC storage chip. A second power module 342 may include an eighth power unit, the eighth power unit is connected to the tenth-type pin common pad 3132 through the third trace 43, and the eighth power unit is further connected to a power pin of a processor chip 33.

In one manner, as shown in FIG. 21, the third trace 43 connected to the tenth-type pin common pad 3132 includes a second jumper area 317.

When the first storage chip is mounted on a circuit board 31, a jumper element is mounted in the second jumper area 317 included in the third trace 43 connected to the tenth-type pin common pad 3132, so that the third trace 43 connected to the tenth-type pin common pad 3132 is connected. In this way, a corresponding voltage is output to the second power module 342 by the power pin of the processor chip 33. After the eighth power unit in the second power module 342 converts the voltage into a voltage required for working of the first storage chip, the voltage obtained by the eighth power unit through conversion may be transmitted to the power pin of the first storage chip through the third trace 43 and the tenth-type pin common pad 3132. When the second storage chip is mounted on the circuit board 31, no jumper element is mounted in the second jumper area 317 included in the third trace 43 connected to the tenth-type pin common pad 3132, so that the third trace 43 connected to the tenth-type pin common pad 3132 is in an open-circuit state.

In another manner, as shown in FIG. 22, the third trace 43 connected to the tenth-type pin common pad 3132 does not include a second jumper area 317.

When the first storage chip is mounted on the circuit board 31, the eighth power unit in the second power module 342 powers on the third trace 43 connected to the tenth-type pin common pad 3132. To be specific, the eighth power unit converts, into a voltage required for working of the first storage chip, a voltage provided by the processor chip 33, and outputs the voltage to the third trace 43 connected to the tenth-type pin common pad 3132, so that the voltage obtained by the eighth power unit through conversion may be transmitted to the power pin of the first storage chip sequentially through the third trace 43 and the tenth-type pin common pad 3132. When the second storage chip is mounted on the circuit board 31, the eighth power unit in the second power module 342 does not power on the third trace 43 connected to the tenth-type pin common pad 3132.

For example, the first storage chip is a first UFS storage chip, and the second storage chip is the EMMC storage chip. Pins of the first UFS storage chip that are at a location A9, a location C5, and a location E5 each are a VCCQ pin (namely, a power pin), pins of the first UFS storage chip that are at a location B8, a location B9, a location C8, a location C9, a location E8, a location N8, a location N9, a location P8, and a location P9 each are a VCC pin (namely, a power pin), and pins of the EMMC storage chip that are at the location A9, the location B8, the location B9, the location C5, the location C8, the location C9, the location E5, the location E8, the location N8, the location N9, the location P8, and the location P9 each are an NU pin (namely, an unused pin). Therefore, the tenth-type pin common pad 3132 includes second pads connected to the pins that are of the first UFS storage chip and the EMMC storage chip and that are at the location A9, the location B8, the location B9, the location C5, the location C8, the location C9, the location E5, the location E8, the location N8, the location N9, the location P8, and the location P9.

In this case, the third trace 43 connected to the tenth-type pin common pad 3132 may not include the second jumper area 317, so that when the first UFS storage chip or the EMMC storage chip is mounted on the circuit board 31, the third trace 43 correspondingly connected to the pins at the location A9, the location B8, the location B9, the location C5, the location C8, the location C9, the location E5, the location E8, the location N8, the location N9, the location P8, and the location P9 is in a short-circuit state.

Alternatively, the third trace 43 connected to the tenth-type pin common pad 3132 may include the second jumper area 317. When the first UFS storage chip is mounted on the circuit board 31, a jumper element such as a resistor, a diode, or a transistor is mounted in the second jumper area 317 included in the third trace 43 correspondingly connected to the pins at the location A9, the location B8, the location B9, the location C5, the location C8, the location C9, the location E5, the location E8, the location N8, the location N9, the location P8, and the location P9; and when the EMMC storage chip is mounted on the circuit board 31, no jumper element is mounted in the second jumper area 317 included in the third trace 43 correspondingly connected to the pins at the location A9, the location B8, the location B9, the location C5, the location C8, the location C9, the location E5, the location E8, the location N8, the location N9, the location P8, and the location P9, so that the third trace 43 is in an open-circuit state.

For example, the first storage chip is a second UFS storage chip, and the second storage chip is the EMMC storage chip. Pins of the second UFS storage chip that are at a location A7, a location B7, a location C7, a location K6, and a location K7 each are a VCCQ2 pin (namely, a power pin), pins of the second UFS storage chip that are at a location B8, a location B9, a location C8, a location C9, a location E8, a location N8, a location N9, a location P8, and a location P9 each are a VCC pin (namely, a power pin), and pins of the EMMC storage chip that are at the location A7, the location B7, the location B8, the location B9, the location C7, the location C8, the location C9, the location E8, the location K6, the location K7, the location N8, the location N9, the location P8, and the location P9 each are an NU pin (namely, an unused pin). Therefore, the tenth-type pin common pad 3132 includes second pads connected to the pins that are of the second UFS storage chip and the EMMC storage chip and that are at the location A7, the location B7, the location B8, the location B9, the location C7, the location C8, the location C9, the location E8, the location K6, the location K7, the location N8, the location N9, the location P8, and the location P9.

In this case, the third trace 43 connected to the tenth-type pin common pad 3132 may not include the second jumper area 317, so that when the second UFS storage chip or the EMMC storage chip is mounted on the circuit board 31, the third trace 43 correspondingly connected to the pins at the location A7, the location B7, the location B8, the location B9, the location C7, the location C8, the location C9, the location E8, the location K6, the location K7, the location N8, the location N9, the location P8, and the location P9 is in a short-circuit state.

Alternatively, the third trace 43 connected to the tenth-type pin common pad 3132 may include the second jumper area 317. When the second UFS storage chip is mounted on the circuit board 31, a jumper element such as a resistor, a diode, or a transistor is mounted in the second jumper area 317 included in the third trace 43 correspondingly connected to the pins at the location A7, the location B7, the location B8, the location B9, the location C7, the location C8, the location C9, the location E8, the location K6, the location K7, the location N8, the location N9, the location P8, and the location P9; and when the EMMC storage chip is mounted on the circuit board 31, no jumper element is mounted in the second jumper area 317 included in the third trace 43 correspondingly connected to the pins at the location A7, the location B7, the location B8, the location B9, the location C7, the location C8, the location C9, the location E8, the location K6, the location K7, the location N8, the location N9, the location P8, and the location P9, so that the third trace 43 is in an open-circuit state.

Therefore, as shown in FIG. 19 and FIG. 21, the third trace 43 connected to the third-type pad 313 includes the second jumper area 317. As shown in FIG. 21, when the circuit board 31 is configured to carry the first storage chip and the third-type pad 313 is configured to be connected to the power pin of the first storage chip, the second jumper area 317 included in the third trace 43 connected to the third-type pad 313 is used to mount a jumper element; and when the circuit board 31 is configured to carry the second storage chip and the third-type pad 313 is configured to be connected to the unused pin of the second storage chip, the second jumper area 317 included in the third trace 43 connected to the third-type pad 313 is not used to mount a jumper element. As shown in FIG. 19, when the circuit board 31 is configured to carry the first storage chip and the third-type pad 313 is configured to be connected to the unused pin of the first storage chip, the second jumper area 317 included in the third trace 43 connected to the third-type pad 313 is not used to mount a jumper element; and when the circuit board 31 is configured to carry the second storage chip and the third-type pad 313 is configured to be connected to the power pin of the second storage chip, the second jumper area 317 included in the third trace 43 connected to the third-type pad 313 is used to mount a jumper element.

Therefore, as shown in FIG. 20 and FIG. 22, the third trace 43 connected to the third-type pad 313 does not include the second jumper area 317. As shown in FIG. 22, when the circuit board 31 is configured to carry the first storage chip and the third-type pad 313 is configured to be connected to the power pin of the first storage chip, the second power module 342 is configured to power on the third trace 43 connected to the third-type pad 313; and when the circuit board 31 is configured to carry the second storage chip and the third-type pad 313 is configured to be connected to the unused pin of the second storage chip, the second power module 342 is configured to not power on the third trace 43 connected to the third-type pad 313. As shown in FIG. 20, when the circuit board 31 is configured to carry the first storage chip and the third-type pad 313 is configured to be connected to the unused pin of the first storage chip, the second power module 342 is configured to not power on the third trace 43 connected to the third-type pad 313; and when the circuit board 31 is configured to carry the second storage chip and the third-type pad 313 is configured to be connected to the power pin of the second storage chip, the second power module 342 is configured to power on the third trace 43 connected to the third-type pad 313.

It should be noted that the seventh power unit and the eighth power unit may be two different functional units used for voltage conversion in the second power module 342. In addition, the seventh power unit and the eighth power unit may be integrated into a same component, for example, are both integrated into a power management chip 34; or the seventh power unit and the eighth power unit may be independently disposed. This is not limited in this embodiment of this application.

In some embodiments, a first power module 341 and a second power module 342 may be integrated into the power management chip 34. Certainly, the first power module 341 and the second power module 342 may alternatively be independently disposed.

In some embodiments, as shown in FIG. 5, a plurality of second pads include a fourth-type pad 314, the fourth-type pad 314 is configured to be connected to an unused pin of a first storage chip and/or an unused pin of a second storage chip, and the fourth-type pad 314 is not configured to be connected to a power pin of the first storage chip or a power pin of the second storage chip.

Because the first storage chip and the second storage chip each include four types of pins, namely, a signal pin, a power pin, a ground pin, and an unused pin, the fourth-type pad 314 is configured to be connected to the ground pin of the first storage chip and the unused pin of the second storage chip, is configured to be connected to the unused pin of the first storage chip and the ground pin of the second storage chip, is configured to be connected to the signal pin of the first storage chip and the unused pin of the second storage chip, is configured to be connected to the unused pin of the first storage chip and the signal pin of the second storage chip, and is configured to be connected to the unused pin of the first storage chip and the unused pin of the second storage chip.

FIG. 23 is a schematic diagram of a connection relationship between an eleventh-type pin common pad and a third trace according to an embodiment of this application. As shown in FIG. 23, an eleventh-type pin common pad 3141 in a fourth-type pad 314 may be a pad at a UFS ground pin/EMMC unused pin. To be specific, the eleventh-type pin common pad 3141 is configured to be connected to a ground pin of a first storage chip and an unused pin of a second storage chip. The eleventh-type pin common pad 3141 is connected to one trace, and the trace connected to the eleventh-type pin common pad 3141 is a third trace 43 corresponding to a UFS storage chip and an EMMC storage chip. In addition, the third trace 43 connected to the eleventh-type pin common pad 3141 is further connected to a ground terminal GND of a circuit board 31.

In one manner, as shown in FIG. 23, the third trace 43 connected to the eleventh-type pin common pad 3141 includes a second jumper area 317.

When the first storage chip is mounted on the circuit board 31, a jumper element is mounted or no jumper element is mounted in the second jumper area 317 included in the third trace 43 connected to the eleventh-type pin common pad 3141. When the second storage chip is mounted on the circuit board 31, no jumper element is mounted in the second jumper area 317 included in the third trace 43 connected to the eleventh-type pin common pad 3141, so that the third trace 43 connected to the eleventh-type pin common pad 3141 is in an open-circuit state.

In another manner, the third trace 43 connected to the eleventh-type pin common pad 3141 does not include a second jumper area 317. In this case, when the first storage chip or the second storage chip is mounted on the circuit board 31, the third trace 43 connected to the eleventh-type pin common pad 3141 is in a short-circuit state.

For example, the first storage chip is a first UFS storage chip, and the second storage chip is the EMMC storage chip. A pin that is of the first UFS storage chip and that is at a location A8 is a VDDiQ2 pin (namely, a ground pin), and a pin that is of the EMMC storage chip and that is at the location A8 is an NU pin (namely, an unused pin); pins of the first UFS storage chip that are at a location B11, a location B12, a location C1, a location C3, a location C11, a location C12, a location D3, a location D12, a location D13, a location D14, a location E1, a location E2, a location E3, a location F3, a location F12, a location F13, a location F14, a location G1, a location G2, a location G3, a location G10, a location G12, a location H3, a location H12, a location H13, a location H14, a location J1, a location J2, a location J3, a location J12, a location K3, a location K12, a location K13, a location K14, a location L1, a location L2, a location L3, a location L12, a location M3, a location M12, a location M13, a location M14, a location N3, a location N11, a location N12, a location P11, and a location P12 each are a VSS pin (namely, a ground pin); and pins of the EMMC storage chip that are at the location B11, the location B12, the location C1, the location C3, the location C11, the location C12, the location D3, the location D12, the location D13, the location D14, the location E1, the location E2, the location E3, the location F3, the location F12, the location F13, the location F14, the location G1, the location G2, the location G3, the location G10, the location G12, the location H3, the location H12, the location H13, the location H14, the location J1, the location J2, the location J3, the location J12, the location K3, the location K12, the location K13, the location K14, the location L1, the location L2, the location L3, the location L12, the location M3, the location M12, the location M13, the location M14, the location N3, the location N11, the location N12, the location P11, and the location P12 each are an NU pin (namely, an unused pin). Therefore, the eleventh-type pin common pad 3141 includes second pads connected to the pins that are of the first UFS storage chip and the EMMC storage chip and that are at the location A8, the location B11, the location B12, the location C1, the location C3, the location C11, the location C12, the location D3, the location D12, the location D13, the location D14, the location E1, the location E2, the location E3, the location F3, the location F12, the location F13, the location F14, the location G1, the location G2, the location G3, the location G10, the location G12, the location H3, the location H12, the location H13, the location H14, the location J1, the location J2, the location J3, the location J12, the location K3, the location K12, the location K13, the location K14, the location L1, the location L2, the location L3, the location L12, the location M3, the location M12, the location M13, the location M14, the location N3, the location N11, the location N12, the location P11, and the location P12.

Therefore, the third trace 43 connected to second pads respectively connected to the pins that are of the first UFS storage chip and the EMMC storage chip and that are at the location A8 in the eleventh-type pin common pad 3141 may include the second jumper area 317. When the first UFS storage chip is mounted on the circuit board 31, a jumper element such as a capacitor is mounted in the second jumper area 317 included in the third trace 43 correspondingly connected to the pin at the location A8, or no jumper element is mounted. If no jumper element is mounted in the second jumper area 317 included in the third trace 43 correspondingly connected to the pin at the location A8, the third trace 43 correspondingly connected to the pin at the location A8 may be in an open-circuit state. When the EMMC storage chip is mounted on the circuit board 31, no jumper element is mounted in the second jumper area 317 included in the third trace 43 correspondingly connected to the pin at the location A8, so that the third trace 43 correspondingly connected to the pin at the location A8 is in an open-circuit state, or a jumper element may be mounted in the second jumper area 317 included in the third trace 43 correspondingly connected to the pin at the location 8, so that the third trace 43 correspondingly connected to the pin at the location A8 is in a short-circuit state.

In addition, the third trace 43 connected to second pads other than the second pad connected to the pin at the location A8 in the eleventh-type pin common pad 3141 includes the second jumper area 317. When the first UFS storage chip is mounted on the circuit board 31, a jumper element such as a resistor, a diode, or a transistor is mounted in the second jumper area 317 included the third trace 43 correspondingly connected to the pins at the location B11, the location B12, the location C1, the location C3, the location C11, the location C12, the location D3, the location D12, the location D13, the location D14, the location E1, the location E2, the location E3, the location F3, the location F12, the location F13, the location F14, the location G1, the location G2, the location G3, the location G10, the location G12, the location H3, the location H12, the location H13, the location H14, the location J1, the location J2, the location J3, the location J12, the location K3, the location K12, the location K13, the location K14, the location L1, the location L2, the location L3, the location L12, the location M3, the location M12, the location M13, the location M14, the location N3, the location N11, the location N12, the location P11, and the location P12; and when the EMMC storage chip is mounted on the circuit board 31, no jumper element is mounted in the second jumper area 317 included the third trace 43 correspondingly connected to the pins at the location B11, the location B12, the location C1, the location C3, the location C11, the location C12, the location D3, the location D12, the location D13, the location D14, the location E1, the location E2, the location E3, the location F3, the location F12, the location F13, the location F14, the location G1, the location G2, the location G3, the location G10, the location G12, the location H3, the location H12, the location H13, the location H14, the location J1, the location J2, the location J3, the location J12, the location K3, the location K12, the location K13, the location K14, the location L1, the location L2, the location L3, the location L12, the location M3, the location M12, the location M13, the location M14, the location N3, the location N11, the location N12, the location P11, and the location P12, so that the third trace 43 is in an open-circuit state.

Alternatively, the third trace 43 connected to second pads other than the second pad connected to the pin at the location A8 in the eleventh-type pin common pad 3141 does not include the second jumper area 317. When the first UFS storage chip or the EMMC storage chip is mounted on the circuit board 31, the third trace 43 correspondingly connected to the pins at the location B11, the location B12, the location C1, the location C3, the location C11, the location C12, the location D3, the location D12, the location D13, the location D14, the location E1, the location E2, the location E3, the location F3, the location F12, the location F13, the location F14, the location G1, the location G2, the location G3, the location G10, the location G12, the location H3, the location H12, the location H13, the location H14, the location J1, the location J2, the location J3, the location J12, the location K3, the location K12, the location K13, the location K14, the location L1, the location L2, the location L3, the location L12, the location M3, the location M12, the location M13, the location M14, the location N3, the location N11, the location N12, the location P11, and the location P12 is in a short-circuit state.

For example, the first storage chip is a second UFS storage chip, and the second storage chip is the EMMC storage chip. The eleventh-type pin common pad 3141 includes second pads connected to pins that are of the second UFS storage chip and the EMMC storage chip and that are at a location A8, a location A9, a location B11, a location B12, a location C1, a location C3, a location C11, a location C12, a location D3, a location D12, a location D13, a location D14, a location E1, a location E2, a location E3, a location F3, a location F12, a location F13, a location F14, a location G1, a location G2, a location G3, a location G10, a location G12, a location H3, a location H12, a location H13, a location H14, a location J1, a location J2, a location J3, a location J12, a location K3, a location K12, a location K13, a location K14, a location L1, a location L2, a location L3, a location L12, a location M3, a location M12, a location M13, a location M14, a location N3, a location N11, a location N12, a location P11, and a location P12.

A pin that is of the second UFS storage chip and that is at the location A9 is a VDDi pin (namely, a ground pin), and a pin that is of the EMMC storage chip and that is at the location A9 is an NU pin (namely, an unused pin). Therefore, the third trace 43 connected to second pads respectively connected to the pins that are of the second UFS storage chip and the EMMC storage chip and that are at the location A9 in the eleventh-type pin common pad 3141 may include the second jumper area 317. When the second UFS storage chip is mounted on the circuit board 31, a jumper element such as a capacitor is mounted in the second jumper area 317 included in the third trace 43 correspondingly connected to the pin at the location A9, or no jumper element is mounted; and when the EMMC storage chip is mounted on the circuit board 31, no jumper element is mounted in the second jumper area 317 included in the third trace 43 correspondingly connected to the pin at the location A9, so that the third trace 43 correspondingly connected to the pin at the location A9 is in an open-circuit state, or a jumper element may be mounted in the second jumper area 317 included in the third trace 43 correspondingly connected to the pin at the location A9, so that the third trace 43 correspondingly connected to the pin at the location A9 is in a short-circuit state.

A location of pins other than the pin at the location A9 in locations of pins connected to the eleventh-type pin common pad 3141, a function of the connected pin, whether a jumper element is mounted in each second jumper area 317, and a type of a jumper element when the jumper element is mounted in the second jumper area 317 on the second UFS storage chip are correspondingly the same as a location of a pin connected to the eleventh-type pin common pad 3141, a function of the connected pin, whether a jumper element is mounted in each second jumper area 317, and a type of a jumper element when the jumper element is mounted in the second jumper area 317 on the first UFS storage chip. Details are not described herein again.

FIG. 24 is a schematic diagram of a connection relationship between a twelfth-type pin common pad and a third trace according to an embodiment of this application. As shown in FIG. 24, a twelfth-type pin common pad 3142 in a fourth-type pad 314 may be a pad at a UFS unused pin/EMMC ground pin. To be specific, the twelfth-type pin common pad 3142 is configured to be connected to an unused pin of a first storage chip and a ground pin of a second storage chip. The twelfth-type pin common pad 3142 is connected to one trace, and the trace connected to the twelfth-type pin common pad 3142 is a third trace 43 corresponding to a UFS storage chip and an EMMC storage chip. In addition, the third trace 43 connected to the twelfth-type pin common pad 3142 is further connected to a ground terminal GND of a circuit board 31.

In one manner, as shown in FIG. 24, the third trace 43 connected to the twelfth-type pin common pad 3142 includes a second jumper area 317.

When the first storage chip is mounted on the circuit board 31, no jumper element is mounted in the second jumper area 317 included in the third trace 43 connected to the twelfth-type pin common pad 3142, so that the third trace 43 connected to the twelfth-type pin common pad 3142 is in an open-circuit state. When the second storage chip is mounted on the circuit board 31, a jumper element is mounted in the second jumper area 317 included in the third trace 43 connected to the twelfth-type pin common pad 3142.

In another manner, the third trace 43 connected to the twelfth-type pin common pad 3142 does not include a second jumper area 317. In this case, when the first storage chip or the second storage chip is mounted on the circuit board 31, the third trace 43 connected to the twelfth-type pin common pad 3142 is in a short-circuit state.

For example, the first storage chip is a first UFS storage chip, and the second storage chip is the EMMC storage chip. Pins of the first UFS storage chip that are at a location G5 and a location E7 each are a VSF pin (namely, an unused pin), pins of the first UFS storage chip that are at a location A6 and a location P6 each are an NU pin (namely, an unused pin), and pins of the EMMC storage chip that are at the location G5, the location E7, the location A6, and the location P6 each are a VSS pin (namely, a ground pin). Therefore, the twelfth-type pin common pad 3142 includes second pads connected to the pins that are of the first UFS storage chip and the EMMC storage chip and that are at the location G5, the location E7, the location A6, and the location P6.

Therefore, the third trace 43 connected to second pads respectively connected to the pins that are of the first UFS storage chip and the EMMC storage chip and that are at the location G5 and the location E7 in the twelfth-type pin common pad 3142 may include the second jumper area 317. When the first UFS storage chip is mounted on the circuit board 31, no jumper element is mounted in the second jumper area 317 included in the third trace 43 correspondingly connected to the pins at the location G5 and the location E7, so that the third trace 43 correspondingly connected to the pins at the location G5 and the location E7 is in an open-circuit state; and when the EMMC storage chip is mounted on the circuit board 31, a jumper element such as a resistor, a diode, or a transistor is mounted in the second jumper area 317 included in the third trace 43 correspondingly connected to the pins at the location G5 and the location E7.

The third trace 43 connected to second pads respectively connected to the pins that are of the first UFS storage chip and the EMMC storage chip and that are at the location A6 and the location P6 in the twelfth-type pin common pad 3142 may include the second jumper area 317. When the first UFS storage chip is mounted on the circuit board 31, no jumper element is mounted in the second jumper area 317 included in the third trace 43 correspondingly connected to the pins at the location A6 and the location P6, so that the third trace 43 correspondingly connected to the pins at the location A6 and the location P6 is in an open-circuit state; and when the EMMC storage chip is mounted on the circuit board 31, a jumper element such as a resistor, a diode, or a transistor is mounted in the second jumper area 317 included in the third trace 43 correspondingly connected to the pins at the location A6 and the location P6.

Alternatively, the third trace 43 connected to second pads respectively connected to the pins that are of the first UFS storage chip and the EMMC storage chip and that are at the location A6 and the location P6 in the twelfth-type pin common pad 3142 may not include the second jumper area 317. When the first UFS storage chip or the EMMC storage chip is mounted on the circuit board 31, the third trace 43 correspondingly connected to the pins at the location A6 and the location P6 is in a short-circuit state.

For example, the first storage chip is a second UFS storage chip, and the second storage chip is the EMMC storage chip. Pins of the second UFS storage chip that are at a location E7 and a location G5 each are a VSF pin (namely, an unused pin), pins of the second UFS storage chip that are at a location C4 and a location P6 each are an NU pin (namely, an unused pin), and pins of the EMMC storage chip that are at the location E7, the location G5, the location C4, and the location P6 each are a VSS pin (namely, a ground pin). Therefore, the twelfth-type pin common pad 3142 includes second pads connected to the pins that are of the second UFS storage chip and the EMMC storage chip and that are at the location E7, the location G5, the location C4, and the location P6.

Therefore, the third trace 43 connected to second pads respectively connected to the pins that are of the second UFS storage chip and the EMMC storage chip and that are at the location G5 and the location E7 in the twelfth-type pin common pad 3142 may include the second jumper area 317. When the second UFS storage chip is mounted on the circuit board 31, no jumper element is mounted in the second jumper area 317 included in the third trace 43 correspondingly connected to the pins at the location G5 and the location E7, so that the third trace 43 correspondingly connected to the pins at the location G5 and the location E7 is in an open-circuit state; and when the EMMC storage chip is mounted on the circuit board 31, a jumper element such as a resistor, a diode, or a transistor is mounted in the second jumper area 317 included in the third trace 43 correspondingly connected to the pins at the location G5 and the location E7.

The third trace 43 connected to second pads respectively connected to the pins that are of the second UFS storage chip and the EMMC storage chip and that are at the location C4 and the location P6 in the twelfth-type pin common pad 3142 may include the second jumper area 317. When the second UFS storage chip is mounted on the circuit board 31, no jumper element is mounted in the second jumper area 317 included in the third trace 43 correspondingly connected to the pins at the location C4 and the location P6, so that the third trace 43 correspondingly connected to the pins at the location C4 and the location P6 is in an open-circuit state; and when the EMMC storage chip is mounted on the circuit board 31, a jumper element such as a resistor, a diode, or a transistor is mounted in the second jumper area 317 included in the third trace 43 correspondingly connected to the pins at the location C4 and the location P6.

Alternatively, the third trace 43 connected to second pads respectively connected to the pins that are of the second UFS storage chip and the EMMC storage chip and that are at the location C4 and the location P6 in the twelfth-type pin common pad 3142 may not include the second jumper area 317. When the second UFS storage chip or the EMMC storage chip is mounted on the circuit board 31, the third trace 43 correspondingly connected to the pins at the location C4 and the location P6 is in a short-circuit state.

FIG. 25 is a schematic diagram of a connection relationship between a thirteenth-type pin common pad and a third trace according to an embodiment of this application. As shown in FIG. 25, a thirteenth-type pin common pad 3143 in a fourth-type pad 314 may be a pad at a UFS signal pin/EMMC unused pin. To be specific, the thirteenth-type pin common pad 3143 is configured to be connected to a signal pin of a first storage chip and an unused pin of a second storage chip. The thirteenth-type pin common pad 3143 is connected to one trace, and the trace connected to the thirteenth-type pin common pad 3143 is a third trace 43 corresponding to a UFS storage chip and an EMMC storage chip. In addition, a signal pin of a processor chip 33 is further connected to the thirteenth-type pin common pad 3143 through the third trace 43.

In one manner, as shown in FIG. 25, the third trace 43 connected to the thirteenth-type pin common pad 3143 includes a second jumper area 317.

When the first storage chip is mounted on the circuit board 31, a jumper element is mounted in the second jumper area 317 included in the third trace 43 connected to the twelfth-type pin common pad 3143. When the second storage chip is mounted on the circuit board 31, no jumper element is mounted in the second jumper area 317 included in the third trace 43 connected to the thirteenth-type pin common pad 3143, so that the third trace 43 connected to the thirteenth-type pin common pad 3143 is in an open-circuit state.

In another manner, the third trace 43 connected to the thirteenth-type pin common pad 3143 does not include a second jumper area 317. In this case, when the first storage chip or the second storage chip is mounted on the circuit board 31, the third trace 43 connected to the thirteenth-type pin common pad 3143 is in a short-circuit state.

For example, the first storage chip is a first UFS storage chip, and the second storage chip is the EMMC storage chip. A pin that is of the first UFS storage chip and that is at a location D1 is a DIN1_T pin (namely, a signal pin), a pin that is of the first UFS storage chip and that is at a location D2 is a DIN1_C pin (namely, a signal pin), a pin that is of the first UFS storage chip and that is at a location F1 is a DIN0_T pin (namely, a signal pin), a pin that is of the first UFS storage chip and that is at a location F2 is a DIN0_C pin (namely, a signal pin), a pin that is of the first UFS storage chip and that is at a location H1 is an REF_CLK pin (namely, a signal pin), a pin that is of the first UFS storage chip and that is at a location H2 is an RST_N pin (namely, a signal pin), a pin that is of the first UFS storage chip and that is at a location K1 is a DOUT0_C pin (namely, a signal pin), a pin that is of the first UFS storage chip and that is at a location K2 is a DOUT0_T pin (namely, a signal pin), a pin that is of the first UFS storage chip and that is at a location M1 is a DOUT1_C pin (namely, a signal pin), a pin that is of the first UFS storage chip and that is at a location M2 is a DOUT1_T pin (namely, a signal pin), and pins of the EMMC storage chip that are at the location D1, the location D2, the location F1, the location F2, the location H1, the location H2, the location K1, the location K2, the location M1, and the location M2 each are an NU pin (namely, an unused pin). Therefore, the thirteenth-type pin common pad 3143 includes second pads connected to the pins that are of the first UFS storage chip and the EMMC storage chip and that are at the location D1, the location D2, the location F1, the location F2, the location H1, the location H2, the location K1, the location K2, the location M1, and the location M2.

In this case, the third trace 43 connected to the thirteenth-type pin common pad 3143 may include the second jumper area 317. When the first UFS storage chip is mounted on the circuit board 31, a jumper element such as a resistor, a diode, or a transistor is mounted in the second jumper area 317 included in the third trace 43 correspondingly connected to the pins at the location D1, the location D2, the location F1, the location F2, the location H1, the location H2, the location K1, the location K2, the location M1, and the location M2, and when the EMMC storage chip is mounted on the circuit board 31, no jumper element is mounted in the second jumper area 317 included in the third trace 43 correspondingly connected to the pins at the location D1, the location D2, the location F1, the location F2, the location H1, the location H2, the location K1, the location K2, the location M1, and the location M2, so that the third trace 43 is in an open-circuit state.

Alternatively, the third trace 43 connected to the thirteenth-type pin common pad 3143 may not include the second jumper area 317. When the first UFS storage chip or the EMMC storage chip is mounted on the circuit board 31, the third trace 43 correspondingly connected to the pins at the location D1, the location D2, the location F1, the location F2, the location H1, the location H2, the location K1, the location K2, the location M1, and the location M2 is in a short-circuit state.

Locations of a plurality of second pads included in the thirteenth-type pin common pad 3143, functions of connected pins, whether a jumper element is mounted in each second jumper area 317, and a type of a jumper element when the jumper element is mounted in the second jumper area 317 when the first storage chip is a second UFS storage chip are correspondingly the same as locations of a plurality of second pads included in the thirteenth-type pin common pad 3143, functions of connected pins, whether a jumper element is mounted in each second jumper area 317, and a type of a jumper element when the jumper element is mounted in the second jumper area 317 when the first storage chip is the first UFS storage chip. Details are not described herein again.

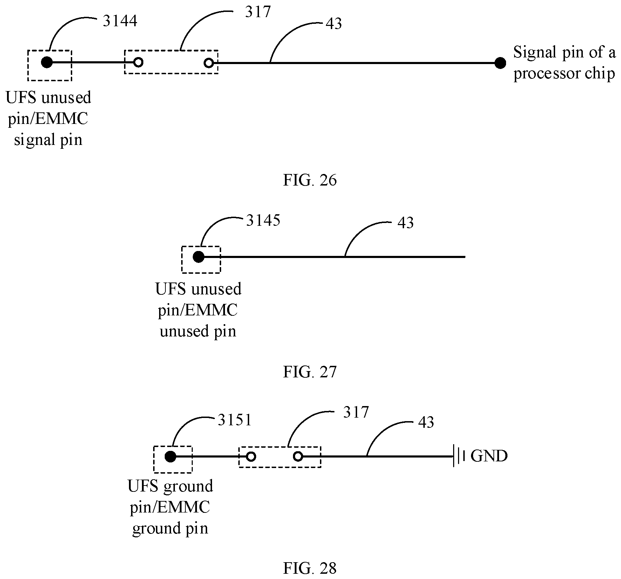

FIG. 26 is a schematic diagram of a connection relationship between a fourteenth-type pin common pad and a third trace according to an embodiment of this application. As shown in FIG. 26, a fourteenth-type pin common pad 3144 in a fourth-type pad 314 may be a pad at a UFS unused pin/EMMC signal pin. To be specific, the fourteenth-type pin common pad 3144 is configured to be connected to an unused pin of a first storage chip and a signal pin of a second storage chip. The fourteenth-type pin common pad 3144 is connected to one trace, and the trace connected to the fourteenth-type pin common pad 3144 is a third trace 43 corresponding to a UFS storage chip and an EMMC storage chip. In addition, a signal pin of a processor chip 33 is further connected to the fourteenth-type pin common pad 3144 through the third trace 43.

In one manner, as shown in FIG. 26, the third trace 43 connected to the fourteenth-type pin common pad 3144 includes a second jumper area 317.

When the first storage chip is mounted on the circuit board 31, no jumper element is mounted in the second jumper area 317 included in the third trace 43 connected to the fourteenth-type pin common pad 3144, so that the third trace 43 connected to the fourteenth-type pin common pad 3144 is in an open-circuit state. When the second storage chip is mounted on the circuit board 31, a jumper element is mounted in the second jumper area 317 included in the third trace 43 connected to the fourteenth-type pin common pad 3144.

In another manner, the third trace 43 connected to the fourteenth-type pin common pad 3144 does not include a second jumper area 317. In this case, when the first storage chip or the second storage chip is mounted on the circuit board 31, the third trace 43 connected to the fourteenth-type pin common pad 3144 is in a short-circuit state.

For example, the first storage chip is a first UFS storage chip, and the second storage chip is the EMMC storage chip. Pins of the first UFS storage chip that are at a location B3, a location B6, and a location M6 each are an NU pin (namely, an unused pin), a pin that is of the EMMC storage chip and that is at the location B3 is a DAT4 pin (namely, a signal pin), a pin that is of the EMMC storage chip and that is at the location B6 is a DAT7 pin (namely, a signal pin), a pin that is of the EMMC storage chip and that is at the location M6 is a CLK pin (namely, a signal pin). Therefore, the fourteenth-type pin common pad 3144 includes second pads connected to the pins that are of the first UFS storage chip and the EMMC storage chip and that are at the location B3, the location B6, and the location M6.

In this case, the third trace 43 connected to the fourteenth-type pin common pad 3144 may include the second jumper area 317. When the first UFS storage chip is mounted on the circuit board 31, no jumper element is mounted in the second jumper area 317 included in the third trace 43 connected to the pins at the location B3, the location B6, and the location M6, so that the third trace 43 connected to the pins at the location B3, the location B6, and the location M6 is in an open-circuit state; and when the EMMC storage chip is mounted on the circuit board 31, a jumper element such as a resistor, a diode, or a transistor is mounted in the second jumper area 317 included in the third trace 43 connected to the pins at the location B3, the location B6, and the location M6.

Alternatively, the third trace 43 connected to the fourteenth-type pin common pad 3144 may not include the second jumper area 317. When the first UFS storage chip or the EMMC storage chip is mounted on the circuit board 31, the third trace 43 connected to the pins at the location B3, the location B6, and the location M6 is in a short-circuit state.

For example, the first storage chip is a second UFS storage chip, and the second storage chip is the EMMC storage chip. Pins of the second UFS storage chip that are at a location A4, a location A5, a location B3, a location B4, a location B5, and a location M6 each are an NU pin (namely, an unused pin), a pin that is of the EMMC storage chip and that is at the location A4 is a DAT1 pin (namely, a signal pin), a pin that is of the EMMC storage chip and that is at the location A5 is a DAT2 pin (namely, a signal pin), a pin that is of the EMMC storage chip and that is at the location B3 is a DAT4 pin (namely, a signal pin), a pin that is of the EMMC storage chip and that is at the location B4 is a DAT5 pin (namely, a signal pin), a pin that is of the EMMC storage chip and that is at the location B5 is a DAT6 pin (namely, a signal pin), and a pin that is of the EMMC storage chip and that is at the location M6 is a CLK pin (namely, a signal pin). Therefore, the fourteenth-type pin common pad 3144 includes second pads connected to the pins that are of the second UFS storage chip and the EMMC storage chip and that are at the location A4, the location A5, the location B3, the location B4, the location B5, and the location M6.

In this case, the third trace 43 connected to the fourteenth-type pin common pad 3144 may include the second jumper area 317. When the second UFS storage chip is mounted on the circuit board 31, no jumper element is mounted in the second jumper area 317 included in the third trace 43 connected to the pins at the location A4, the location A5, the location B3, the location B4, the location B5, and the location M6, so that the third trace 43 connected to the pins at the location A4, the location A5, the location B3, the location B4, the location B5, and the location M6 is in an open-circuit state; and when the EMMC storage chip is mounted on the circuit board 31, a jumper element such as a resistor, a diode, or a transistor is mounted in the second jumper area 317 included in the third trace 43 connected to the pins at the location A4, the location A5, the location B3, the location B4, the location B5, and the location M6.

Alternatively, the third trace 43 connected to the fourteenth-type pin common pad 3144 may not include the second jumper area 317. When the second UFS storage chip or the EMMC storage chip is mounted on the circuit board 31, the third trace 43 connected to the pins at the location A4, the location A5, the location B3, the location B4, the location B5, and the location M6 is in a short-circuit state.

It should be noted that, for the foregoing scenario shown in FIG. 25, when the first storage chip is mounted on the circuit board 31, a resistor mounted in the second jumper area 317 included in the third trace 43 connected to the thirteenth-type pin common pad 3143 may match internal impedance of the first storage chip, to improve signal transmission quality of the first storage chip. Correspondingly, for the foregoing scenario shown in FIG. 26, when the second storage chip is mounted on the circuit board 31, a resistor mounted in the second jumper area 317 included in the third trace 43 connected to the fourteenth-type pin common pad 3144 may match internal impedance of the second storage chip, to improve signal transmission quality of the second storage chip.

Therefore, as shown in FIG. 23 to FIG. 26, the third trace 43 connected to the fourth-type pad 314 includes the second jumper area 317. As shown in FIG. 24 and FIG. 26, when the circuit board 31 is configured to carry the first storage chip and the fourth-type pad 314 is configured to be connected to the unused pin of the first storage chip, the second jumper area 317 included in the third trace 43 connected to the fourth-type pad 314 is not used to mount a jumper element; and when the circuit board 31 is configured to carry the second storage chip and the fourth-type pad 314 is configured to be connected to a ground pin or the signal pin of the second storage chip, the second jumper area 317 included in the third trace 43 connected to the fourth-type pad 314 is used to mount a jumper element. As shown in FIG. 23 and FIG. 25, when the circuit board 31 is configured to carry the first storage chip and the fourth-type pad 314 is configured to be connected to the ground pin or the signal pin of the first storage chip, the second jumper area 317 included in the third trace 43 connected to the fourth-type pad 314 is used to mount a jumper element or is not used to mount a jumper element; and when the circuit board 31 is configured to carry the second storage chip and the fourth-type pad 314 is configured to be connected to the unused pin of the second storage chip, the second jumper area 317 included in the third trace 43 connected to the fourth-type pad 314 is not used to mount a jumper element.

Alternatively, the third trace 43 connected to the fourth-type pad 314 including the eleventh-type pin common pad 3141, the twelfth-type pin common pad 3142, the thirteenth-type pin common pad 3143, and the fourteenth-type pin common pad 3144 does not include the second jumper area 317.

FIG. 27 is a schematic diagram of a connection relationship between a fifteenth-type pin common pad and a third trace according to an embodiment of this application. As shown in FIG. 27, a fifteenth-type pin common pad 3145 in a fourth-type pad 314 may be a pad at a UFS unused pin/EMMC unused pin. To be specific, the fifteenth-type pin common pad 3145 is configured to be connected to an unused pin of a first storage chip and an unused pin of a second storage chip. The fifteenth-type pin common pad 3145 is connected to one trace, and the trace connected to the fifteenth-type pin common pad 3145 is a third trace 43 corresponding to a UFS storage chip and an EMMC storage chip.

The third trace 43 connected to the fifteenth-type pin common pad 3145 does not include a second jumper area 317. In this case, when the first storage chip or the second storage chip is mounted on a circuit board 31, the third trace 43 connected to the fifteenth-type pin common pad 3145 is in a short-circuit state, so that the pins connected to the fifteenth-type pin common pad 3145 each are in a floating state.

For example, the first storage chip is a first UFS storage chip, and the second storage chip is the EMMC storage chip. Pins that are of the first UFS storage chip and the EMMC storage chip and that are at a location A1, a location A2, a location A7, a location A10, a location A11, a location A12, a location A13, a location A14, a location B1, a location B7, a location B10, a location B13, a location B14, a location C7, a location C10, a location C13, a location C14, a location D4, a location E9, a location E10, a location E12, a location E13, a location E14, a location F10, a location G13, a location G14, a location J13, a location J14, a location K6, a location K7, a location K10, a location L13, a location L14, a location M7, a location M8, a location M9, a location M10, a location M11, a location N1, a location N6, a location N7, a location N10, a location N13, a location N14, a location P1, a location P2, a location P7, a location P10, a location P13, and a location P14 each are an unused pin. Therefore, the fifteenth-type pin common pad 3145 includes second pads connected to the pins that are of the first UFS storage chip and the EMMC storage chip and that are at the foregoing locations. In this case, the third trace 43 connected to the fifteenth-type pin common pad 3145 does not include the second jumper area 317, so that when the first UFS storage chip or the EMMC storage chip is mounted on the circuit board 31, the third trace 43 correspondingly connected to the pins at the foregoing locations is in a short-circuit state.

For example, the first storage chip is a second UFS storage chip, and the second storage chip is the EMMC storage chip. Pins that are of the second UFS storage chip and the EMMC storage chip and that are at a location A1, a location A2, a location A10, a location A11, a location A12, a location A13, a location A14, a location B1, a location B10, a location B13, a location B14, a location C5, a location C10, a location C13, a location C14, a location D4, a location E5, a location E9, a location E10, a location E12, a location E13, a location E14, a location F10, a location G13, a location G14, a location J13, a location J14, a location K10, a location L13, a location L14, a location M7, a location M8, a location M9, a location M10, a location M11, a location N1, a location N6, a location N7, a location N10, a location N13, a location N14, a location P1, a location P2, a location P7, a location P10, a location P13, and a location P14 each are an unused pin. Therefore, the fifteenth-type pin common pad 3145 includes second pads connected to the pins that are of the second UFS storage chip and the EMMC storage chip and that are at the foregoing locations. In this case, the third trace 43 connected to the fifteenth-type pin common pad 3145 does not include the second jumper area 317, so that when the second UFS storage chip or the EMMC storage chip is mounted on the circuit board 31, the third trace 43 correspondingly connected to the pins at the foregoing locations is in a short-circuit state.

In some embodiments, as shown in FIG. 5, a plurality of second pads include a fifth-type pad 315, and the fifth-type pad 315 is configured to be connected to a ground pin of a first storage chip and a ground pin of a second storage chip. A third trace 43 connected to the fifth-type pad 315 includes a second jumper area 317; when the circuit board 31 is configured to carry the first storage chip, the second jumper area 317 included in the third trace 43 connected to the fifth-type pad 315 is used to mount a jumper element; and when the circuit board 31 is configured to carry the second storage chip, the second jumper area 317 included in the third trace 43 connected to the fifth-type pad 315 is used to mount a jumper element or is not used to mount a jumper element. Alternatively, the third trace 43 connected to the fifth-type pad 315 does not include a second jumper area 317.

FIG. 28 is a schematic diagram of a connection relationship between a sixteenth-type pin common pad and a third trace according to an embodiment of this application. As shown in FIG. 28, a sixteenth-type pin common pad 3151 in a fifth-type pad 315 may be a pad at a UFS ground pin/EMMC ground pin. To be specific, the sixteenth-type pin common pad 3151 is configured to be connected to a ground pin of a first storage chip and a ground pin of a second storage chip. The sixteenth-type pin common pad 3151 is connected to one trace, and the trace connected to the sixteenth-type pin common pad 3151 is a third trace 43 corresponding to a UFS storage chip and an EMMC storage chip. In addition, the third trace 43 connected to the sixteenth-type pin common pad 3151 is further connected to a ground terminal GND of a circuit board 31.

In one manner, as shown in FIG. 28, the third trace 43 connected to the sixteenth-type pin common pad 3151 includes a second jumper area 317.

When the first storage chip is mounted on the circuit board 31, a jumper element is mounted in the second jumper area 317 included in the third trace 43 connected to the sixteenth-type pin common pad 3151. When the second storage chip is mounted on the circuit board 31, a jumper element is mounted or no jumper element is mounted in the second jumper area 317 included in the third trace 43 connected to the sixteenth-type pin common pad 3151.

It may be understood that some pins connected to the pad at the UFS ground pin/EMMC ground pin may need to be grounded by using an element such as a capacitor. Therefore, in this case, some third traces 43 connected to the pad at the UFS ground pin/EMMC ground pin need to include a second jumper area 317.

In another manner, the third trace 43 connected to the sixteenth-type pin common pad 3151 does not include a second jumper area 317. In this case, when the first storage chip or the second storage chip is mounted on the circuit board 31, the third trace 43 connected to the sixteenth-type pin common pad 3151 is in a short-circuit state.

For example, the first storage chip is a first UFS storage chip, and the second storage chip is the EMMC storage chip. Pins of the first UFS storage chip that are at a location C2, a location H10, a location J5, a location N2, a location N5, and a location P4 each are a VSS pin (namely, a ground pin), a pin that is of the EMMC storage chip and that is at the location C2 is a VDDi pin (namely, a ground pin), and pins of the EMMC storage chip that are at the location H10, the location J5, the location N2, the location N5, and the location P4 each are a VSS pin (namely, a ground pin). Therefore, the sixteenth-type pin common pad 3151 includes second pads connected to the pins that are of the first UFS storage chip and the EMMC storage chip and that are at the location C2, the location H10, the location J5, the location N2, the location N5, and the location P4.

Therefore, the third trace 43 connected to second pads respectively connected to the pins that are of the first UFS storage chip and the EMMC storage chip and that are at the location C2 in the sixteenth-type pin common pad 3151 may include the second jumper area 317. When the first UFS storage chip is mounted on the circuit board 31, a jumper element such as a resistor, a diode, or a transistor is mounted in the second jumper area 317 included in the third trace 43 correspondingly connected to the pin at the location C2; and when the EMMC storage chip is mounted on the circuit board 31, a jumper element such as a capacitor is mounted in the second jumper area 317 included in the third trace 43 correspondingly connected to the pin at the location C2, or no jumper element is mounted.

In addition, the third trace 43 connected to second pads respectively connected to the pins that are of the first UFS storage chip and the EMMC storage chip and that are at the location H10, the location J5, the location N2, the location N5, and the location P4 in the sixteenth-type pin common pad 3151 may not include the second jumper area 317. When the first UFS storage chip or the EMMC storage chip is mounted on the circuit board 31, the third trace 43 correspondingly connected to the pins at the location H10, the location J5, the location N2, the location N5, and the location P4 is in a short-circuit state.

Locations of a plurality of second pads included in the sixteenth-type pin common pad 3151, functions of connected pins, whether a jumper element is mounted in each second jumper area 317, and a type of a jumper element when the jumper element is mounted in the second jumper area 317 when the first storage chip is a second UFS storage chip are correspondingly the same as locations of a plurality of second pads included in the sixteenth-type pin common pad 3151, functions of connected pins, whether a jumper element is mounted in each second jumper area 317, and a type of a jumper element when the jumper element is mounted in the second jumper area 317 when the first storage chip is the first UFS storage chip. Details are not described herein again.

It should be understood that, although a plurality of different jumper manners are listed for a jumper area (the first jumper area 316 or the second jumper area 317) included in a trace connected to a same pin, for example, the jumper manners may be an open-circuit manner, a short-circuit manner, a manner of mounting a jumper element such as a resistor, a capacitor, a diode, or a transistor, this does not indicate that all jumper manners of the pin are applied through traversal in an actual design. A jumper manner in the jumper area included in the trace connected to each pin may be selected based on a specific pin function, an external circuit, or the like, so that an overall design of the circuit board 31 is as simple as possible. The jumper manner in the jumper area included in the trace connected to each pin is not specifically limited in this embodiment of this application.

In this embodiment of this application, the jumper element includes any one of the resistor, the capacitor, the diode, and the transistor.

It should be noted that the circuit board 31 shown in FIG. 5 is merely used as an example for description. A trace connected to each pad in a first pad group and a jumper area disposed in the trace do not constitute a limitation on a location of each pad in the first pad group disposed on the circuit board 31, a quantity of pads in the first pad group, a distribution location of the trace, and the like. The location of each pad in the first pad group disposed on the circuit board 31, the quantity of pads in the first pad group, the distribution location of the trace, and the like may be set based on an actual situation. In addition, a power management chip 34, a processor chip 33, and the like may be further mounted on the circuit board 31 shown in FIG. 5, and the power management chip 34 may include the first power module 341 and the second power module 342.

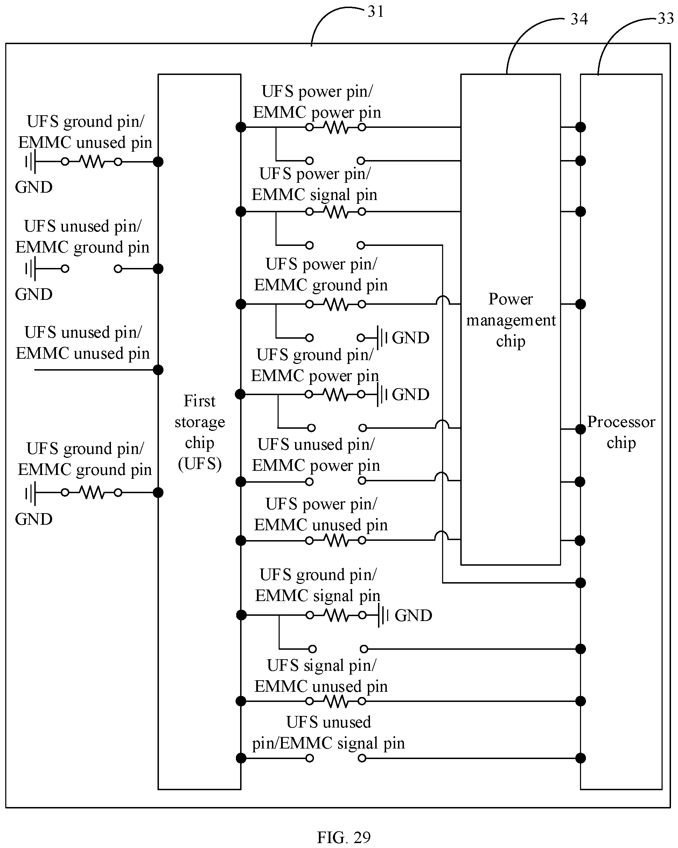

FIG. 29 is a schematic diagram of an example structure in which a first storage chip is mounted on a circuit board according to an embodiment of this application. When a first storage chip is mounted on the circuit board 31 shown in FIG. 5, for example, the first storage chip is a UFS storage chip, a circuit board assembly shown in FIG. 29 may be obtained.

A resistor is mounted in a first jumper area 316 included in a first trace 41 connected to a pad at a UFS power pin/EMMC power pin; a resistor is mounted in a first jumper area 316 included in a first trace 41 connected to a pad at a UFS power pin/EMMC signal pin; a resistor is mounted in a first jumper area 316 included in a first trace 41 connected to a pad at a UFS power pin/EMMC ground pin; a resistor is mounted in a first jumper area 316 included in a first trace 41 connected to a pad at a UFS ground pin/EMMC power pin; a resistor is mounted in a first jumper area 316 included in a first trace 41 connected to a pad at a UFS ground pin/EMMC signal pin; no jumper element is mounted in a second jumper area 317 included in a third trace 43 connected to a pad at a UFS unused pin/EMMC power pin; a resistor is mounted in a second jumper area 317 included in a third trace 43 connected to a pad at a UFS power pin/EMMC unused pin; a resistor is mounted in a second jumper area 317 included in a third trace 43 connected to a pad at a UFS ground pin/EMMC unused pin; no jumper element is mounted in a second jumper area 317 included in a third trace 43 connected to a pad at a UFS unused pin/EMMC ground pin; a resistor is mounted in a second jumper area 317 included in a third trace 43 connected to a pad at a UFS signal pin/EMMC unused pin; no jumper element is mounted in a second jumper area 317 included in a third trace 43 connected to a pad at a UFS unused pin/EMMC signal pin; a third trace 43 connected to a pad at a UFS unused pin/EMMC unused pin does not include a second jumper area 317; and a resistor is mounted in a second jumper area 317 included in a third trace 43 connected to a pad at a UFS ground pin/EMMC ground pin.

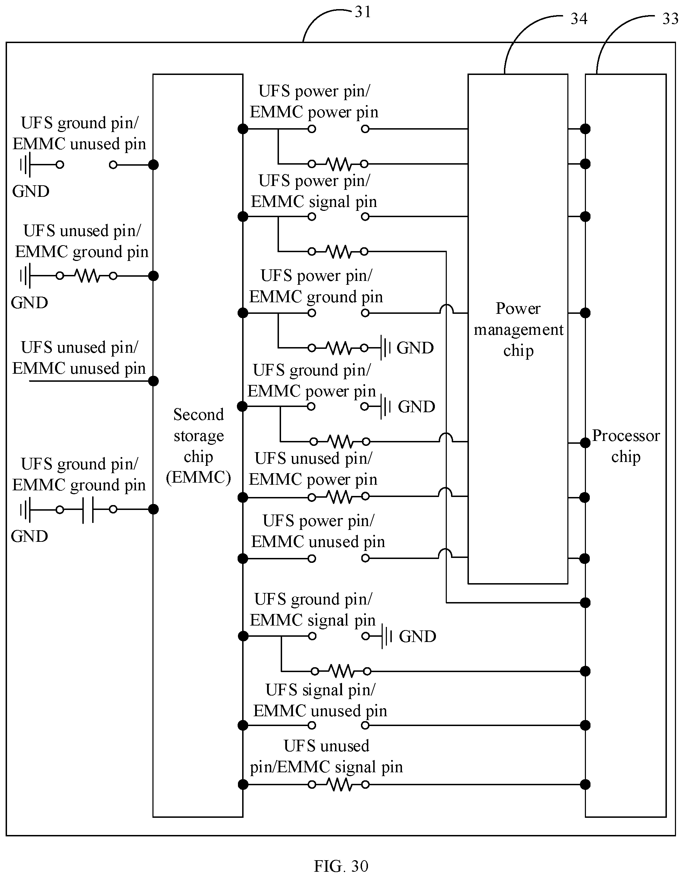

FIG. 30 is a schematic diagram of an example structure in which a second storage chip is mounted on a circuit board according to an embodiment of this application. When a second storage chip is mounted on the circuit board 31 shown in FIG. 5, for example, the second storage chip is an EMMC storage chip, the circuit board assembly shown in FIG. 30 may be obtained.

A resistor is mounted in a first jumper area 316 included in a second trace 42 connected to a pad at a UFS power pin/EMMC power pin; a resistor is mounted in a first jumper area 316 included in a second trace 42 connected to a pad at a UFS power pin/EMMC signal pin; a resistor is mounted in a first jumper area 316 included in a second trace 42 connected to a pad at a UFS power pin/EMMC ground pin; a resistor is mounted in a first jumper area 316 included in a second trace 42 connected to a pad at a UFS ground pin/EMMC power pin; a resistor is mounted in a first jumper area 316 included in a second trace 42 connected to a pad at a UFS ground pin/EMMC signal pin; a resistor is mounted in a second jumper area 317 included in a third trace 43 connected to a pad at a UFS unused pin/EMMC power pin; no jumper element is mounted in a second jumper area 317 included in a third trace 43 connected to a pad at a UFS power pin/EMMC unused pin; no jumper element is mounted in a second jumper area 317 included in a third trace 43 connected to a pad at a UFS ground pin/EMMC unused pin; a resistor is mounted in a second jumper area 317 included in a third trace 43 connected to a pad at a UFS unused pin/EMMC ground pin; no jumper element is mounted in a second jumper area 317 included in a third trace 43 connected to a pad at a UFS signal pin/EMMC unused pin; a resistor is mounted in a second jumper area 317 included in a third trace 43 connected to a pad at a UFS unused pin/EMMC signal pin; a third trace 43 connected to a pad at a UFS unused pin/EMMC unused pin does not include a second jumper area 317; and a capacitor is mounted in a second jumper area 317 included in a third trace 43 connected to a pad at a UFS ground pin/EMMC ground pin.

In conclusion, the first storage chip and the second storage chip are compatible on a same circuit board 31 provided in this embodiment of this application.

In some possible implementations, a first-type pin common pad 3111 in a first-type pad 311 may be connected to a power pin of a first storage chip and a power pin of a second storage chip. When the first storage chip or the second storage chip is mounted on the circuit board 31, if a power pin that is of a processor chip 33 and that is correspondingly connected to the first-type pin common pad 3111 is a same power pin, two traces may be combined into one trace.

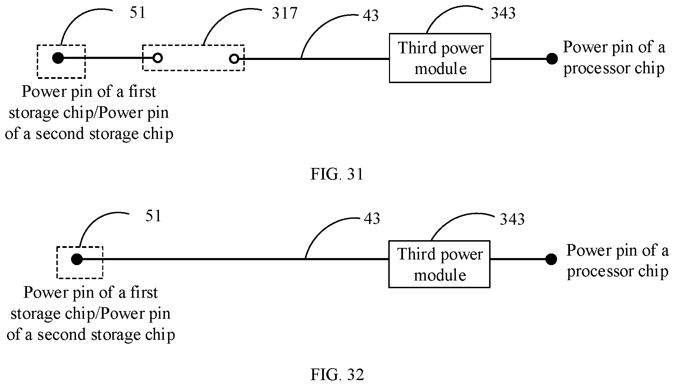

FIG. 31 is a schematic diagram of a connection relationship between a sixth-type pad and a third trace according to an embodiment of this application. FIG. 32 is a schematic diagram of another connection relationship between a sixth-type pad and a third trace according to an embodiment of this application. As shown in FIG. 31 and FIG. 32, the circuit board 31 further includes a second pad group, the second pad group is configured to be connected to a processor chip 33, and the circuit board 31 is further configured to carry a third power module 343. A plurality of second pads include a sixth-type pad 51; the sixth-type pad 51 is configured to be connected to a power pin of a first storage chip and a power pin of a second storage chip; when the circuit board 31 is configured to carry the first storage chip, the power pin of the first storage chip is connected to a first power pin of the processor chip 33 sequentially through the sixth-type pad 51, the third trace 43, and the third power module 343; when the circuit board 31 is configured to carry the second storage chip, the power pin of the second storage chip is connected to a second power pin of the processor chip 33 sequentially through the sixth-type pad 51, the third trace 43, and the third power module 343; and the first power pin and the second power pin are a same power pin.

In a manner, as shown in FIG. 31, the third trace 43 connected to the sixth-type pad 51 includes a second jumper area 317; and when the circuit board 31 is configured to carry the first storage chip or the second storage chip, the second jumper area 317 included in the third trace 43 connected to the sixth-type pad 51 is used to mount a jumper element.

In another manner, as shown in FIG. 32, the third trace 43 connected to the sixth-type pad 51 does not include a second jumper area 317; and when the circuit board 31 is configured to carry the first storage chip or the second storage chip, the third power module 343 is configured to power on the third trace 43 connected to the sixth-type pad 51. In addition, a voltage output when the third power module 343 performs powering-on when the first storage chip is mounted on the circuit board 31 may be different from a voltage output when the third power module 343 performs powering-on when the second storage chip is mounted on the circuit board 31.

In some embodiments, a size of the first storage chip is the same as a size of the second storage chip.

In some embodiments, a target storage chip 32 and the processor chip 33 may be located on a first surface of the circuit board 31. When the first storage chip or the second storage chip is mounted on the circuit board 31, a jumper element mounted in a first jumper area 316 may be located on a second surface of the circuit board 31, and the second surface and the first surface may be two relatively disposed surfaces of the circuit board.

In this case, for two traces connected to a same pad, a jumper element mounted in the first jumper area 316 and both a target storage chip 32 and the processor chip 33 may be distributed on two side of the circuit board 31, to reduce a signal matching problem caused by the two traces.

In some other embodiments, a target storage chip 32, the processor chip 33, and a jumper element mounted in the first jumper area 316 may alternatively be located on a same surface of the circuit board 31, and a distance between the first jumper area 316 and the target storage chip 32 is less than a distance between the first jumper area 316 and the processor chip 33.

In this case, for two traces connected to a same pad, first jumper areas 316 included in the two traces may be as close to a location of the target storage chip 32 as possible, so that after a jumper element such as a resistor is mounted in the first jumper areas 316, a signal matching problem caused by the two traces can be reduced.

In some embodiments, for a signal line compatibility scenario, in a scenario shown in FIG. 16, a difference between a trace width before a fork of two traces and a trace width after the fork is less than a preset value, and the preset value may be 0 or a value that approaches 0, so that the trace width before the fork of two traces is basically consistent with the trace width after the fork. In this way, impedance of a signal transmitted through the two traces can be adjusted.

The foregoing mainly describes an implementation in which the first storage chip and the second storage chip are compatible on a same circuit board 31. Certainly, three or more types of storage chips are further compatible on the circuit board 31 in this embodiment of this application.

Specifically, the circuit board 31 is configured to carry a target storage chip 32, the target storage chip 32 includes any one of at least two types of storage chips, quantities of pins of all of the at least two types of storage chips are equal, and pin arrangements of all of the at least two types of storage chips are the same. The circuit board 31 includes a first pad group, the first pad group is configured to be connected to the target storage chip 32, the first pad group includes a plurality of first pads, each first pad is connected to at least two traces, each trace connected to at least some first pads includes a first jumper area 316, and the trace is broken off in the first jumper area 316. When the circuit board 31 is configured to carry the target storage chip 32, the first jumper area 316 included in a target trace connected to the at least some first pads is used to mount a jumper element, and the target trace is a trace corresponding to the target storage chip 32 in the at least two traces connected to the first pad.

In some embodiments, all pads included in the first pad group are in a one-to-one correspondence with all pins included on the target storage chip 32. Specifically, an arrangement array of all the pads included in the first pad group is the same as an arrangement array of all the pins included on the target storage chip 32, and the quantity of pads included in the first pad group is equal to the quantity of pins included on the target storage chip 32.

In some embodiments, sizes of all of the at least two types of storage chips are the same.

Therefore, at least two types of storage chips are compatible on a same circuit board 31 in this embodiment of this application. In addition, at least two types of storage chips that are compatible on a same circuit board 31 include but are not limited to at least two of a first UFS storage chip, a second UFS storage chip, and an EMMC storage chip.

In the foregoing specific implementations, the objectives, technical solutions, and beneficial effects of this application are further described in detail. It should be understood that the foregoing descriptions are merely specific implementations of this application, but are not intended to limit the protection scope of this application. Any modification, equivalent replacement, improvement, or the like made based on the technical solutions of this application shall fall within the protection scope of this application.

## Claims

1. A circuit board, wherein the circuit board is configured to carry a target storage chip, the target storage chip comprises any one of at least two types of storage chips, quantities of pins of all of the at least two types of storage chips are equal, and pin arrangements of all of the at least two types of storage chips are the same;
the circuit board comprises a first pad group, the first pad group is configured to be connected to the target storage chip, the first pad group comprises a plurality of first pads, each first pad is connected to at least two traces, each trace connected to at least some first pads comprises a first jumper area, and the trace is broken off in the first jumper area; and
when the circuit board is configured to carry the target storage chip, the first jumper area comprised in a target trace connected to the at least some first pads is used to mount a jumper element, and the target trace is a trace corresponding to the target storage chip in the at least two traces connected to the first pad.

2. The circuit board according to claim 1, wherein the target storage chip comprises a first storage chip or a second storage chip;
each first pad is connected to two traces, and the two traces connected to each of the at least some first pads each comprise the first jumper area;
when the circuit board is configured to carry the first storage chip, the first jumper area comprised in a first trace connected to the at least some first pads is used to mount a jumper element, and the first trace is a trace corresponding to the first storage chip in the two traces connected to the first pad; and
when the circuit board is configured to carry the second storage chip, the first jumper area comprised in a second trace connected to the at least some first pads is used to mount a jumper element, and the second trace is a trace corresponding to the second storage chip in the two traces connected to the first pad.

3. The circuit board according to claim 2, wherein the plurality of first pads comprise a first-type pad, the first-type pad is configured to be connected to a power pin of the first storage chip and/or a power pin of the second storage chip, the first-type pad is not configured to be connected to an unused pin of the first storage chip or an unused pin of the second storage chip, and the circuit board is further configured to carry a first power module; and
when the first-type pad is configured to be connected to the power pin of the first storage chip, the first power module is configured to be connected to the first-type pad through the first trace; and/or when the first-type pad is configured to be connected to the power pin of the second storage chip, the first power module is configured to be connected to the first-type pad through the second trace.

4. The circuit board according to claim 3, wherein the first trace and the second trace that are connected to the first-type pad each comprise the first jumper area;
when the circuit board is configured to carry the first storage chip, the first jumper area comprised in the first trace connected to the first-type pad is used to mount a jumper element, and the first jumper area comprised in the second trace connected to the first-type pad is not used to mount a jumper element; and
when the circuit board is configured to carry the second storage chip, the first jumper area comprised in the second trace connected to the first-type pad is used to mount a jumper element, and the first jumper area comprised in the first trace connected to the first-type pad is not used to mount a jumper element.

5. The circuit board according to claim 3, wherein the first trace and/or the second trace that are/is connected to the first power module do/does not comprise the first jumper area, and the first trace or the second trace that is not connected to the first power module comprises the first jumper area; and
when the circuit board is configured to carry the first storage chip and the first-type pad is configured to be connected to the power pin of the first storage chip, the first power module is configured to power on the first trace connected to the first-type pad; and/or
when the circuit board is configured to carry the second storage chip and the first-type pad is configured to be connected to the power pin of the second storage chip, the first power module is configured to power on the second trace connected to the first-type pad.

6. The circuit board according to claim 5, wherein neither of the first trace and the second trace that are connected to the first power module comprise the first jumper area;
when the circuit board is configured to carry the first storage chip and the first-type pad is configured to be connected to the power pin of the first storage chip, the first power module is configured to power on the first trace connected to the first-type pad, and the first power module is configured to not power on the second trace connected to the first-type pad; and
when the circuit board is configured to carry the second storage chip and the first-type pad is configured to be connected to the power pin of the second storage chip, the first power module is configured to power on the second trace connected to the first-type pad, and the first power module is configured to not power on the first trace connected to the first-type pad.

7. The circuit board according to claim 5, wherein the first trace connected to the first power module does not comprise the first jumper area, and the second trace not connected to the first power module comprises the first jumper area;
when the circuit board is configured to carry the first storage chip and the first-type pad is configured to be connected to the power pin of the first storage chip, the first power module is configured to power on the first trace connected to the first-type pad, and the first jumper area comprised in the second trace connected to the first-type pad is not used to mount a jumper element; and
when the circuit board is configured to carry the second storage chip and the first-type pad is configured to be connected to a signal pin or a ground pin of the second storage chip, the first jumper area comprised in the second trace connected to the first-type pad is used to mount a jumper element, and the first power module is configured to not power on the first trace connected to the first-type pad.

8. The circuit board according to claim 5, wherein the second trace connected to the first power module does not comprise the first jumper area, and the first trace not connected to the first power module comprises the first jumper area;
when the circuit board is configured to carry the first storage chip and the first-type pad is configured to be connected to a signal pin or a ground pin of the first storage chip, the first jumper area comprised in the first trace connected to the first-type pad is used to mount a jumper element, and the first power module is configured to not power on the second trace connected to the first-type pad; and
when the circuit board is configured to carry the second storage chip and the first-type pad is configured to be connected to the power pin of the second storage chip, the first power module is configured to power on the second trace connected to the first-type pad, and the first jumper area comprised in the first trace connected to the first-type pad is not used to mount a jumper element.

9. The circuit board according to claim 2, wherein the plurality of first pads comprise a second-type pad, and the second-type pad is configured to be connected to a signal pin of the first storage chip and a signal pin of the second storage chip, or is configured to be connected to a signal pin of the first storage chip and a ground pin of the second storage chip, or is configured to be connected to a ground pin of the first storage chip and a signal pin of the second storage chip; and
the first trace and the second trace that are connected to the second-type pad each comprise the first jumper area; when the circuit board is configured to carry the first storage chip, the first jumper area comprised in the first trace connected to at least some second-type pads is used to mount a jumper element; and when the circuit board is configured to carry the second storage chip, the first jumper area comprised in the second trace connected to the second-type pad is used to mount a jumper element.

10. The circuit board according to claim 2, wherein the first pad group further comprises a plurality of second pads, each second pad is connected to one trace, one trace connected to the second pad is a third trace, the third trace connected to some second pads comprises a second jumper area, the third trace is broken off in the second jumper area, and the third trace connected to the other second pads does not comprise the second jumper area; and
when the circuit board is configured to carry the first storage chip or the second storage chip, the second jumper area comprised in the third trace connected to the at least some second pads is used to mount a jumper element.

11. The circuit board according to claim 10, wherein the plurality of second pads comprise a third-type pad, and the third-type pad is configured to be connected to a power pin of the first storage chip and an unused pin of the second storage chip, or is configured to be connected to an unused pin of the first storage chip and a power pin of the second storage chip; and
the circuit board is further configured to carry a second power module, and the second power module is configured to be connected to the third-type pad through the third trace.

12. The circuit board according to claim 11, wherein the third trace connected to the third-type pad comprises the second jumper area;
when the circuit board is configured to carry the first storage chip and the third-type pad is configured to be connected to the power pin of the first storage chip, the second jumper area comprised in the third trace connected to the third-type pad is used to mount a jumper element; and when the circuit board is configured to carry the second storage chip and the third-type pad is configured to be connected to the unused pin of the second storage chip, the second jumper area comprised in the third trace connected to the third-type pad is not used to mount a jumper element; and
when the circuit board is configured to carry the first storage chip and the third-type pad is configured to be connected to the unused pin of the first storage chip, the second jumper area comprised in the third trace connected to the third-type pad is not used to mount a jumper element; and when the circuit board is configured to carry the second storage chip and the third-type pad is configured to be connected to the power pin of the second storage chip, the second jumper area comprised in the third trace connected to the third-type pad is used to mount a jumper element.

13. The circuit board according to claim 11, wherein the third trace connected to the third-type pad does not comprise the second jumper area;
when the circuit board is configured to carry the first storage chip and the third-type pad is configured to be connected to the power pin of the first storage chip, the second power module is configured to power on the third trace connected to the third-type pad; and when the circuit board is configured to carry the second storage chip and the third-type pad is configured to be connected to the unused pin of the second storage chip, the second power module is configured to not power on the third trace connected to the third-type pad; and
when the circuit board is configured to carry the first storage chip and the third-type pad is configured to be connected to the unused pin of the first storage chip, the second power module is configured to not power on the third trace connected to the third-type pad; and when the circuit board is configured to carry the second storage chip and the third-type pad is configured to be connected to the power pin of the second storage chip, the second power module is configured to power on the third trace connected to the third-type pad.

14. The circuit board according to claim 10, wherein the plurality of second pads comprise a fourth-type pad, the fourth-type pad is configured to be connected to an unused pin of the first storage chip and/or an unused pin of the second storage chip, and the fourth-type pad is not configured to be connected to a power pin of the first storage chip or a power pin of the second storage chip.

15. The circuit board according to claim 14, wherein the third trace connected to the fourth-type pad comprises the second jumper area;
when the circuit board is configured to carry the first storage chip and the fourth-type pad is configured to be connected to the unused pin of the first storage chip, the second jumper area comprised in the third trace connected to the fourth-type pad is not used to mount a jumper element; and when the circuit board is configured to carry the second storage chip and the fourth-type pad is configured to be connected to a ground pin or a signal pin of the second storage chip, the second jumper area comprised in the third trace connected to the fourth-type pad is used to mount a jumper element; and
when the circuit board is configured to carry the first storage chip and the fourth-type pad is configured to be connected to a ground pin or a signal pin of the first storage chip, the second jumper area comprised in the third trace connected to the fourth-type pad is used to mount a jumper element or is not used to mount a jumper element; and when the circuit board is configured to carry the second storage chip and the fourth-type pad is configured to be connected to the unused pin of the second storage chip, the second jumper area comprised in the third trace connected to the fourth-type pad is not used to mount a jumper element.

16. The circuit board according to claim 14, wherein the third trace connected to the fourth-type pad does not comprise the second jumper area.

17. The circuit board according to claim 10, wherein the plurality of second pads comprises a fifth-type pad, and the fifth-type pad is configured to be connected to a ground pin of the first storage chip and a ground pin of the second storage chip; and
the third trace connected to the fifth-type pad comprises the second jumper area; when the circuit board is configured to carry the first storage chip, the second jumper area comprised in the third trace connected to the fifth-type pad is used to mount a jumper element; and when the circuit board is configured to carry the second storage chip, the second jumper area comprised in the third trace connected to the fifth-type pad is used to mount a jumper element or is not used to mount a jumper element; or
the third trace connected to the fifth-type pad does not comprise the second jumper area.

18. The circuit board according to claim 10, wherein the circuit board further comprises a second pad group, the second pad group is configured to be connected to a processor chip, and the circuit board is further configured to carry a third power module;
the plurality of second pads comprise a sixth-type pad; the sixth-type pad is configured to be connected to a power pin of the first storage chip and a power pin of the second storage chip; when the circuit board is configured to carry the first storage chip, the power pin of the first storage chip is connected to a first power pin of the processor chip sequentially through the sixth-type pad, the third trace, and the third power module; when the circuit board is configured to carry the second storage chip, the power pin of the second storage chip is connected to a second power pin of the processor chip sequentially through the sixth-type pad, the third trace, and the third power module; and the first power pin and the second power pin are a same power pin; and
the third trace connected to the sixth-type pad comprises the second jumper area; and when the circuit board is configured to carry the first storage chip or the second storage chip, the second jumper area comprised in the third trace connected to the sixth-type pad is used to mount a jumper element; or
the third trace connected to the sixth-type pad does not comprise the second jumper area; and when the circuit board is configured to carry the first storage chip or the second storage chip, the third power module is configured to power on the third trace connected to the sixth-type pad.

19. The circuit board according to any one of claims 1 to 18, wherein the jumper element comprises any one of a resistor, a capacitor, a diode, and a transistor.

20. The circuit board according to any one of claims 1 to 18, wherein sizes of all of the at least two types of storage chips are the same.

21. The circuit board according to any one of claims 1 to 18, wherein the at least two types of storage chips comprise at least two of a first UFS storage chip, a second UFS storage chip, and an EMMC storage chip, and an interface version of the first UFS storage chip is different from an interface version of the second UFS storage chip.

22. A circuit board assembly, comprising a target storage chip and the circuit board according to any one of claims 1 to 21, wherein the target storage chip is connected to the circuit board.

23. An electronic device, comprising a housing and the circuit board assembly according to claim 22, wherein the circuit board assembly is disposed inside the housing.

24. A circuit board, wherein the circuit board is configured to carry a target storage chip, the target storage chip comprises any one of at least two types of storage chips, quantities of pins of all of the at least two types of storage chips are equal, and pin arrangements of all of the at least two types of storage chips are the same;
the circuit board comprises a first pad group, the first pad group is configured to be connected to the target storage chip, the first pad group comprises a plurality of first pads, each first pad is connected to at least two traces, each trace connected to at least some first pads comprises a first jumper area, and the trace is broken off in the first jumper area;
when the circuit board is configured to carry the target storage chip, the first jumper area comprised in a target trace connected to the at least some first pads is used to mount a jumper element, and the target trace is a trace corresponding to the target storage chip in the at least two traces connected to the first pad; and
a quantity of pads comprised in the first pad group is equal to a quantity of pins of the target storage chip, the first jumper area is a disconnected area in the trace, and the jumper element is a to-be-mounted electronic element.

25. The circuit board according to claim 24, wherein the target storage chip comprises a first storage chip or a second storage chip;
each first pad is connected to two traces, and the two traces connected to each of the at least some first pads each comprise the first jumper area;
when the circuit board is configured to carry the first storage chip, the first jumper area comprised in a first trace connected to the at least some first pads is used to mount a jumper element, and the first trace is a trace corresponding to the first storage chip in the two traces connected to the first pad; and
when the circuit board is configured to carry the second storage chip, the first jumper area comprised in a second trace connected to the at least some first pads is used to mount a jumper element, and the second trace is a trace corresponding to the second storage chip in the two traces connected to the first pad.

26. The circuit board according to claim 25, wherein the plurality of first pads comprise a first-type pad, the first-type pad is configured to be connected to a power pin of the first storage chip and/or a power pin of the second storage chip, the first-type pad is not configured to be connected to an unused pin of the first storage chip or an unused pin of the second storage chip, and the circuit board is further configured to carry a first power module; and
when the first-type pad is configured to be connected to the power pin of the first storage chip, the first power module is configured to be connected to the first-type pad through the first trace; and/or when the first-type pad is configured to be connected to the power pin of the second storage chip, the first power module is configured to be connected to the first-type pad through the second trace.

27. The circuit board according to claim 26, wherein the first trace and the second trace that are connected to the first-type pad each comprise the first jumper area;
when the circuit board is configured to carry the first storage chip, the first jumper area comprised in the first trace connected to the first-type pad is used to mount a jumper element, and the first jumper area comprised in the second trace connected to the first-type pad is not used to mount a jumper element; and
when the circuit board is configured to carry the second storage chip, the first jumper area comprised in the second trace connected to the first-type pad is used to mount a jumper element, and the first jumper area comprised in the first trace connected to the first-type pad is not used to mount a jumper element.

28. The circuit board according to claim 26, wherein the first trace and/or the second trace that are/is connected to the first power module do/does not comprise the first jumper area, and the first trace or the second trace that is not connected to the first power module comprises the first jumper area; and
when the circuit board is configured to carry the first storage chip and the first-type pad is configured to be connected to the power pin of the first storage chip, the first power module is configured to power on the first trace connected to the first-type pad; and/or
when the circuit board is configured to carry the second storage chip and the first-type pad is configured to be connected to the power pin of the second storage chip, the first power module is configured to power on the second trace connected to the first-type pad.

29. The circuit board according to claim 28, wherein neither of the first trace and the second trace that are connected to the first power module comprise the first jumper area;
when the circuit board is configured to carry the first storage chip and the first-type pad is configured to be connected to the power pin of the first storage chip, the first power module is configured to power on the first trace connected to the first-type pad, and the first power module is configured to not power on the second trace connected to the first-type pad; and
when the circuit board is configured to carry the second storage chip and the first-type pad is configured to be connected to the power pin of the second storage chip, the first power module is configured to power on the second trace connected to the first-type pad, and the first power module is configured to not power on the first trace connected to the first-type pad.

30. The circuit board according to claim 28, wherein the first trace connected to the first power module does not comprise the first jumper area, and the second trace not connected to the first power module comprises the first jumper area;
when the circuit board is configured to carry the first storage chip and the first-type pad is configured to be connected to the power pin of the first storage chip, the first power module is configured to power on the first trace connected to the first-type pad, and the first jumper area comprised in the second trace connected to the first-type pad is not used to mount a jumper element; and
when the circuit board is configured to carry the second storage chip and the first-type pad is configured to be connected to a signal pin or a ground pin of the second storage chip, the first jumper area comprised in the second trace connected to the first-type pad is used to mount a jumper element, and the first power module is configured to not power on the first trace connected to the first-type pad.

31. The circuit board according to claim 28, wherein the second trace connected to the first power module does not comprise the first jumper area, and the first trace not connected to the first power module comprises the first jumper area;
when the circuit board is configured to carry the first storage chip and the first-type pad is configured to be connected to a signal pin or a ground pin of the first storage chip, the first jumper area comprised in the first trace connected to the first-type pad is used to mount a jumper element, and the first power module is configured to not power on the second trace connected to the first-type pad; and
when the circuit board is configured to carry the second storage chip and the first-type pad is configured to be connected to the power pin of the second storage chip, the first power module is configured to power on the second trace connected to the first-type pad, and the first jumper area comprised in the first trace connected to the first-type pad is not used to mount a jumper element.

32. The circuit board according to claim 25, wherein the plurality of first pads comprise a second-type pad, and the second-type pad is configured to be connected to a signal pin of the first storage chip and a signal pin of the second storage chip, or is configured to be connected to a signal pin of the first storage chip and a ground pin of the second storage chip, or is configured to be connected to a ground pin of the first storage chip and a signal pin of the second storage chip; and
the first trace and the second trace that are connected to the second-type pad each comprise the first jumper area; when the circuit board is configured to carry the first storage chip, the first jumper area comprised in the first trace connected to at least some second-type pads is used to mount a jumper element; and when the circuit board is configured to carry the second storage chip, the first jumper area comprised in the second trace connected to the second-type pad is used to mount a jumper element.

33. The circuit board according to claim 25, wherein the first pad group further comprises a plurality of second pads, each second pad is connected to one trace, one trace connected to the second pad is a third trace, the third trace connected to some second pads comprises a second jumper area, the third trace is broken off in the second jumper area, and the third trace connected to the other second pads does not comprise the second jumper area; and
when the circuit board is configured to carry the first storage chip or the second storage chip, the second jumper area comprised in the third trace connected to the at least some second pads is used to mount a jumper element, and the second jumper area is a disconnected area in the third trace.

34. The circuit board according to claim 33, wherein the plurality of second pads comprise a third-type pad, and the third-type pad is configured to be connected to a power pin of the first storage chip and an unused pin of the second storage chip, or is configured to be connected to an unused pin of the first storage chip and a power pin of the second storage chip; and
the circuit board is further configured to carry a second power module, and the second power module is configured to be connected to the third-type pad through the third trace.

35. The circuit board according to claim 34, wherein the third trace connected to the third-type pad comprises the second jumper area;
when the circuit board is configured to carry the first storage chip and the third-type pad is configured to be connected to the power pin of the first storage chip, the second jumper area comprised in the third trace connected to the third-type pad is used to mount a jumper element; and when the circuit board is configured to carry the second storage chip and the third-type pad is configured to be connected to the unused pin of the second storage chip, the second jumper area comprised in the third trace connected to the third-type pad is not used to mount a jumper element; and
when the circuit board is configured to carry the first storage chip and the third-type pad is configured to be connected to the unused pin of the first storage chip, the second jumper area comprised in the third trace connected to the third-type pad is not used to mount a jumper element; and when the circuit board is configured to carry the second storage chip and the third-type pad is configured to be connected to the power pin of the second storage chip, the second jumper area comprised in the third trace connected to the third-type pad is used to mount a jumper element.

36. The circuit board according to claim 34, wherein the third trace connected to the third-type pad does not comprise the second jumper area;
when the circuit board is configured to carry the first storage chip and the third-type pad is configured to be connected to the power pin of the first storage chip, the second power module is configured to power on the third trace connected to the third-type pad; and when the circuit board is configured to carry the second storage chip and the third-type pad is configured to be connected to the unused pin of the second storage chip, the second power module is configured to not power on the third trace connected to the third-type pad; and
when the circuit board is configured to carry the first storage chip and the third-type pad is configured to be connected to the unused pin of the first storage chip, the second power module is configured to not power on the third trace connected to the third-type pad; and when the circuit board is configured to carry the second storage chip and the third-type pad is configured to be connected to the power pin of the second storage chip, the second power module is configured to power on the third trace connected to the third-type pad.

37. The circuit board according to claim 33, wherein the plurality of second pads comprise a fourth-type pad, the fourth-type pad is configured to be connected to an unused pin of the first storage chip and/or an unused pin of the second storage chip, and the fourth-type pad is not configured to be connected to a power pin of the first storage chip or a power pin of the second storage chip.

38. The circuit board according to claim 37, wherein the third trace connected to the fourth-type pad comprises the second jumper area;
when the circuit board is configured to carry the first storage chip and the fourth-type pad is configured to be connected to the unused pin of the first storage chip, the second jumper area comprised in the third trace connected to the fourth-type pad is not used to mount a jumper element; and when the circuit board is configured to carry the second storage chip and the fourth-type pad is configured to be connected to a ground pin or a signal pin of the second storage chip, the second jumper area comprised in the third trace connected to the fourth-type pad is used to mount a jumper element; and
when the circuit board is configured to carry the first storage chip and the fourth-type pad is configured to be connected to a ground pin or a signal pin of the first storage chip, the second jumper area comprised in the third trace connected to the fourth-type pad is used to mount a jumper element or is not used to mount a jumper element; and when the circuit board is configured to carry the second storage chip and the fourth-type pad is configured to be connected to the unused pin of the second storage chip, the second jumper area comprised in the third trace connected to the fourth-type pad is not used to mount a jumper element.

39. The circuit board according to claim 37, wherein the third trace connected to the fourth-type pad does not comprise the second jumper area.

40. The circuit board according to claim 33, wherein the plurality of second pads comprises a fifth-type pad, and the fifth-type pad is configured to be connected to a ground pin of the first storage chip and a ground pin of the second storage chip; and
the third trace connected to the fifth-type pad comprises the second jumper area; when the circuit board is configured to carry the first storage chip, the second jumper area comprised in the third trace connected to the fifth-type pad is used to mount a jumper element; and when the circuit board is configured to carry the second storage chip, the second jumper area comprised in the third trace connected to the fifth-type pad is used to mount a jumper element or is not used to mount a jumper element; or
the third trace connected to the fifth-type pad does not comprise the second jumper area.

41. The circuit board according to claim 33, wherein the circuit board further comprises a second pad group, the second pad group is configured to be connected to a processor chip, and the circuit board is further configured to carry a third power module;
the plurality of second pads comprise a sixth-type pad; the sixth-type pad is configured to be connected to a power pin of the first storage chip and a power pin of the second storage chip; when the circuit board is configured to carry the first storage chip, the power pin of the first storage chip is connected to a first power pin of the processor chip sequentially through the sixth-type pad, the third trace, and the third power module; when the circuit board is configured to carry the second storage chip, the power pin of the second storage chip is connected to a second power pin of the processor chip sequentially through the sixth-type pad, the third trace, and the third power module; and the first power pin and the second power pin are a same power pin; and
the third trace connected to the sixth-type pad comprises the second jumper area; and when the circuit board is configured to carry the first storage chip or the second storage chip, the second jumper area comprised in the third trace connected to the sixth-type pad is used to mount a jumper element; or
the third trace connected to the sixth-type pad does not comprise the second jumper area; and when the circuit board is configured to carry the first storage chip or the second storage chip, the third power module is configured to power on the third trace connected to the sixth-type pad.

42. The circuit board according to any one of claims 24 to 41, wherein the jumper element comprises any one of a resistor, a capacitor, a diode, and a transistor

43. The circuit board according to any one of claims 24 to 41, wherein sizes of all of the at least two types of storage chips are the same.

44. The circuit board according to any one of claims 24 to 41, wherein the at least two types of storage chips comprise at least two of a first UFS storage chip, a second UFS storage chip, and an EMMC storage chip, and an interface version of the first UFS storage chip is different from an interface version of the second UFS storage chip.
